# EUROPEAN PATENT APPLICATION

(11) **EP 1 715 504 A2**
(43) Date of publication of application: **25.10.2006**
(21) Application number: 06008021.5
(22) Date of filing: 18.04.2006
(51) Int. Cl.: H01J 37/31, H01J 37/301

(54) **Glow discharge drilling apparatus and glow discharge drilling method**

(30) Priority: 19.04.2005 JP 2005121473; 22.06.2005 JP 2005182014; 06.09.2005 JP 2005258495
(71) Applicant: HORIBA, LTD., Minami-ku Kyoto 601-8510 (JP); Keio University, Tokyo 108-8345 (JP)
(72) Inventor: Hirano, Akihiro, Minami-ku, Kyoto 601-8510 (JP); Matsumoto, Koichi, Minami-ku, Kyoto 601-8510 (JP); Uchida, Yoshinobu, Minami-ku, Kyoto 601-8510 (JP); Mitani, Tomoaki, Yokohama-shi, Kanagawa 223-8522 (JP); Shimizu, Kenichi, Yokohama-shi, Kanagawa 223-8522 (JP)
(74) Representative: Müller - Hoffmann & Partner

(57) **Abstract**

A glow discharge drilling apparatus (1) enables switching of a continuous mode for continuously supplying electric power and an intermittent mode for intermittently supplying electric power. Electric power is supplied in the intermittent mode with respect to a sample (S) easily melted by a heat due to a glow discharge and a sample (S) easily broken by a force of sputtering due to a glow discharge or the like, whereby the sample (S) is drilled so that an observation face capable of carrying out good observation can be obtained. When the sample (S) is not easily melted and easily broken, the sample (S) is drilled so that a good observation face can be efficiently obtained by supplying electric power in the continuous mode.

## Description

### BACKGROUND OF THE INVENTION

### 1. Field of the Invention

The present invention relates to a glow discharge drilling apparatus and a glow discharge drilling method capable of properly drilling a sample surface in the case where the sample surface is drilled by means of sputtering due to a glow discharge in accordance with characteristics of a sample targeted for drilling.

In addition, the present invention relates to a glow discharge drilling apparatus and a glow discharge drilling method capable of carrying out a drilling process of a sample precisely up to a desired depth in the case where a sample surface is drilled by means of sputtering due to a glow discharge.

In addition, the present invention relates to a glow discharge drilling apparatus and a glow discharge drilling method capable of forming a good observation face even in a sample which is likely to be affected by a heat in the case where a sample surface is drilled by means of sputtering due to a glow discharge, thereby forming an observation face suitable to observation.

### 2. Description of the Related Art

Conventionally, when visually observing a structure and a texture or the like of a sample, a variety of microscopes such as a transmission electron microscope (TEM) and a scanning electron microscope (SEM) have been used. In order to observe a sample by such a microscope, it is necessary to prepare an observation face of a sample as a preparatory process. For example, in the case of observing a sample cross section, the sample is broken, and the cross section serving as the observation face is exposed, whereby polishing must be carried out until the exposed cross section becomes clean and is obtained as a degree of smoothness equal to or greater than a predetermined level.

While it is general to use a polishing agent for polishing a sample, there is an apprehension that a work environment is impaired under the influence of polishing powder or the like generated due to the polishing agent and a polishing work. In addition, because the polishing work is cumbersome, a long period of time is required at the stage of a preparatory process for carrying out sample observation by a variety of microscopes. Further, depending on a structure of a sample targeted for observation, a face of the sample suitable to observation cannot be obtained even if the sample is polished. For example, in the case where the sample is composed of a combination of a hard material such as glass and a soft material such as gold, the soft material is deformed due to polishing and the material flows out to the hard material side, thus making it very difficult to form a good observation face.

In order to avoid a failure relating to the sample polishing described above and obtain a clean observation face of a sample, an apparatus and method for drilling a surface targeted for observation of a sample by means of a sputtering force due to a glow discharge instead of polishing so as to finish a sample surface at a desired degree of smoothness are disclosed in Japanese Patent Application Laid-open No. 54-131539 (1979), Japanese Patent Application Laid-open No. 2002-310959, and Japanese Patent Application Laid-open No. 2004-61163.

### BRIEF SUMMARY OF THE INVENTION

In the above described apparatus according to Japanese Patent Application Laid-open No. 54-131539 (1979), inert gas (for example, argon gas) for glow discharge is introduced into a vacuum vessel that is sufficiently great with respect to a sample, thus making it difficult to smoothly guide the introduced argon gas to the sample. Therefore, there is a problem that, in the case where an insufficient amount of argon gas is supplied to a drilled site of the sample, sputtering is hardly generated such that a sample surface can be efficiently drilled.

Further, in the apparatus according to Japanese Patent Application Laid-open No. 2002-310959, an end face of a cylinder shaped discharging electrode is disposed so as to be opposed to a sample. However, a predetermined gap is provided between the end face of the discharging electrode and the sample. Therefore, there is a problem that the argon gas supplied into the discharging electrode flows out from that gap, and thus, the sputtering force due to a glow discharge cannot be concentrated to the sample surface, and efficient sample drilling cannot be achieved. The method according to Japanese Patent Application Laid-open No. 2004-61163 merely discloses measuring element concentration by using a secondary ion mass spectrometry for a face drilled by using a glow discharge.

In addition, in the case where a sample targeted for drilling is formed of materials having a low melting point such as various types of rubbers, a synthetic resin and an organic substance such as an organic polymer, there is a problem that a sample is melted due to the heat generation caused by a glow discharge, and a good observation face cannot be formed. Further, it is very difficult to prevent a sample from being broken by the sputtering force caused by a glow discharge with respect to a sample formed of a fragile material, if it is subjected to an external force equal to or greater than a predetermined force, such as glass and ceramics. Furthermore, in the case where a sample is formed of a plurality of materials, for example, a hard material and a soft material, there is a problem that it is generally difficult to optimally drill a sample face by a glow discharge in accordance with a variety of material characteristics. In addition, although texture observation of a metal material or the like made of a crystalline structure is generally carried out by means of a wet system, there is a problem that a difference in level caused by crystallization cannot be clearly recognized in a conventional method for forming an observation surface.

Further, in the case where observation is carried out at a predetermined depth from a sample surface, it is important to precisely drill a sample up to a depth for observation. However, in the above described apparatus according to Japanese Patent Application Laid-open No. 54-131539 (1979), because a sample surface is merely drilled by using a glow discharge, processing precision varies depending on an engineer's skillfulness, and it is necessary to temporarily stop processing many times in order to check a drilling quantity. Therefore, there is a problem that efficient processing cannot be carried out.

In addition, in the apparatuses according to Japanese Patent Application Laid-open No. 2002-310959 and Japanese Patent Application Laid-open No. 2004-61163, a depth for drilling is indirectly determined based on a discharge time (sputtering time) relevant to a glow discharge. Therefore, there is a problem that drilling processing with high precision cannot be achieved. Further, even if automated drilling processing is promoted in such a situation, desired processing precision is not obtained. Therefore, there is a problem that manual additional processing for approaching to desired dimensional precision after automatic processing is required.

Further, there exist various types of samples targeted for observation, for example, a thermally weak sample targeted for an observation such as a sample easily melted if it is subjected to a heat such as a rubber and a synthetic resin or a thermally hardened sample. In the case where a sample face of such a sample is drilled due to a sputtering force, thereby forming an observation face, if it is excessively subjected to a heat due to sputtering (if a temperature for a sample surface to be thermally durable is exceeded), the sample surface is melted or hardened, and the sample deteriorates. Therefore, there is a problem that a good observation face is hardly obtained.

It is considered to measure a discharge time (sputtering time) relevant to a glow discharge with respect to a thermal influence on a sample at the time of drilling processing due to a glow discharge, and to stop drilling if a predetermined time has elapsed in order to avoid a thermal influence. However, time measurement is merely provided as a "milestone" for indirectly determining whether or not a thermally weak sample actually deteriorates, thus making it impossible to obtain reliability that a good observation face can be formed while a thermal damage is avoided.

The present invention has been made in view of the foregoing problems. It is an object to provide a glow discharge drilling apparatus and a glow discharge drilling method capable of forming a small space by surrounding a space at which a sample is opposed to a electrode and supplying inert gas to that space, thereby sufficiently allocating a supply quantity of the inert gas and effectively drilling a sample surface.

In addition, it is another object of the present invention to provide a glow discharge drilling apparatus and a glow discharge drilling method capable of intermittently carrying out electric power supply for generating a glow discharge, thereby reducing a sample load with respect to the glow discharge and forming a good observation face with respect to a sample formed of materials having a low melting point or a sample formed of a fragile material, and a sample formed of a metal material having a crystalline structure or the like.

In addition, it is another object of the present invention to provide a glow discharge drilling apparatus and a glow discharge drilling method capable of changing an intermittent electric power supply state, thereby achieving drilling according to a variety of sample characteristics.

In addition, it is another object of the present invention to provide a glow discharge drilling apparatus and a glow discharge drilling method capable of directly measuring a site for drilling, thereby measuring a drilled depth with high precision, and making control to terminate drilling processing due to a glow discharge according to the measured depth, thereby achieving automatic processing with high precision.

In addition, it is another object of the present invention to provide a glow discharge drilling apparatus and a glow discharge drilling method capable of measuring a temperature of a drilled site of a sample using an infrared-ray radiation temperature measuring system so that a thermal influence of sputtering due to a glow discharge can be reliably avoided from occurring on a sample surface.

In order to solve the above described problems, a glow discharge drilling apparatus according to a first aspect is a glow discharge drilling apparatus for, in an atmosphere in which inert gas is supplied, drilling a sample disposed to be opposed to an electrode by means of a glow discharge generated by supplying electric power to the electrode and sample, characterized by comprising: a sealing member for surrounding and sealing a space at which the electrode and sample are opposed to each other; and a gas supply section for supplying inert gas to the space sealed by the sealing member; and intermittent electric power supply means for intermittently supplying electric power.

A glow discharge drilling apparatus according to a second aspect is characterized by comprising: continuous electric power supply means for continuously supplying electric power; and switching means for switching the continuous electric power supply carried out by the continuous electric power supply means and the intermittent electric power supply carried out by the intermittent electric power supply means.

A glow discharge drilling apparatus according to a third aspect is a glow discharge drilling apparatus comprising a first electrode and a second electrode on which a sample is disposed, in a drilling processing chamber to which inert gas is supplied, the apparatus drilling the sample by means of a glow discharge generated by supplying electric power to the first electrode and the second electrode, characterized by comprising: intermittent electric power supply means for intermittently supplying electric power; continuous electric power supply means for continuously supplying electric power; and switching means for switching continuous electric power supply carried out by the continuous electric power supply means and intermittent electric power supply carried out by the intermittent electric power supply means.

A glow discharge drilling apparatus according to a fourth aspect is characterized by comprising electric power supply state change means for changing a state relevant to intermittent electric power supply carried out by the intermittent electric power supply means.

A glow discharge drilling apparatus according to a fifth aspect is a glow discharge drilling apparatus comprising a first electrode and a second electrode on which a sample is disposed, in a drilling processing chamber to which inert gas is supplied, the apparatus drilling the sample by means of a glow discharge generated by supplying electric power to the first electrode and the second electrode, characterized by comprising intermittent electric power supply means for intermittently supplying electric power and electric power supply state change means for changing a state relevant to intermittent electric power supply carried out by the intermittent electric power supply means.

A glow discharge drilling apparatus according to a sixth aspect is characterized in that the electric power supply state change means is provided so as to change the number of the times per unit time electric power is supplied.

A glow discharge drilling apparatus according to a seventh aspect is characterized in that the electric power supply state change means is provided so as to change a duty ratio relevant to intermittent electric power supply.

A glow discharge drilling apparatus according to an eighth aspect is characterized in that the electric power supply state change means is provided so as to change an electric power value relevant to intermittent electric power supply.

A glow discharge drilling method according to a ninth aspect is a glow discharge drilling method for to a disposing a sample to be opposed to an electrode, supplying inert gas, supplying electric power to the electrode and sample to generate a glow discharge, and drilling the sample by means of the generated glow discharge, characterized by surrounding and sealing a space at which the electrode and sample are opposed to each other, and intermittently supplying electric power in an atmosphere in which the inert gas is supplied to the space formed by sealing.

A glow discharge drilling method according to a tenth aspect is a glow discharge drilling method for supplying inert gas to a drilling processing chamber having a first electrode and a second electrode on which a sample is disposed, supplying electric power to the first electrode and the second electrode to generate a glow discharge, and drilling the sample by means of the generated glow discharge, characterized by intermittently supplying electric power and make changeable a state relevant to the intermittent electric power supply.

A glow discharge drilling apparatus according to an eleventh aspect is a glow discharge drilling apparatus for drilling a sample by means of a glow discharge generated by applying a voltage between an electrode and the sample disposed to be opposed to the electrode, characterized by comprising measuring means for measuring a drilled depth by carrying out light irradiation to a drilled site and light receiving of reflection light reflected at the drilled site.

A glow discharge drilling apparatus according to a twelfth aspect is characterized in that a penetrating portion is provided on the electrode at a portion opposed to a sample, and wherein the measuring means is provided so as to carry out light irradiation to a drilling portion and light receiving of reflection light reflected on the drilled site through the penetrating portion.

A glow discharge drilling apparatus according to a thirteenth aspect is characterized by comprising a holding member for holding the electrode, and having a cavity that communicates with the penetrating portion of the electrode; and a light transmitting member opposed to the penetrating portion via the cavity, and wherein the measuring means is provided so as to carry out light irradiation to a drilled site and light receiving of reflection light reflected on the drilled site through the light transmitting member, the cavity and the penetrating portion.

A glow discharge drilling apparatus according to a fourteenth aspect is characterized in that the measuring means comprises an irradiation and light receiving section for carrying out light irradiation and light receiving of reflection light, and the irradiation and light receiving section is arranged in parallel to the holding member so as to be opposed to the light transmitting member, and comprises a light shielding member for shielding light by covering the irradiation and light receiving section and light transmitting member.

A glow discharge drilling apparatus according to a fifteenth aspect is characterized by comprising stopping means for, when the measuring means carries out light receiving of reflection light, stopping applying a voltage.

A glow discharge drilling apparatus according to a sixteenth aspect is characterized by comprising means for intermittently applying a voltage, wherein the measuring means is provided so as to carry out light receiving of reflection light when voltage application is intermitted while a voltage is intermittently applied.

A glow discharge drilling apparatus according to a seventeenth aspect is characterized by comprising: accepting means for accepting a drilled depth; means for carrying out comparative determination of a drilled depth accepted by the accepting means and a drilled depth measured by the measuring means; and means for, in the case where it is determined that the drilled depth measured by the measuring means is reached as the drilled depth accepted by the accepting means, stopping voltage application and terminating drilling.

A glow discharge drilling apparatus according to an eighteenth aspect is characterized in that the measuring means comprises means for irradiating a plurality of light beams and receiving a plurality of reflection light beams, and average value calculating means for calculating an average value of a plurality of drilled depths based on a plurality of the received reflection light beams.

A glow discharge drilling method according to a nineteenth aspect is a glow discharge drilling method for drilling a sample by a glow discharge generated by applying a voltage between an electrode and the sample disposed to be opposed to the electrode, characterized by measuring a drilled depth by light irradiation to a drilled site and light receiving of reflection light reflected at the drilled site, stopping applying a voltage according to the measured drilled depth, and terminating drilling.

A glow discharge drilling apparatus according to a twentieth aspect is a glow discharge drilling apparatus for drilling a sample by means of a glow discharge generated by applying a voltage between a hollow electrode and the sample disposed opposed to the hollow electrode, characterized by comprising: an infrared ray sensor irradiated from a drilled site of the sample so as to receive an infrared ray having passed through a hollow portion of the hollow electrode; and temperature measuring means for measuring a temperature of the drilled site of the sample based on the infrared ray received by the infrared ray sensor.

A glow discharge drilling apparatus according to a twenty first aspect is characterized by comprising moving means for moving the infrared ray sensor so as to close to or distant from a drilled site of a sample.

A glow discharge drilling apparatus according to a twenty second aspect is characterized by comprising a holding member for holding the hollow electrode, and having a cavity that communicates with a hollow portion of the hollow electrode and a light transmitting member opposed to the hollow portion via the cavity, wherein the infrared ray sensor is provided so as to receive an infrared ray having passed through the hollow portion, the cavity, and the light transmitting member.

A glow discharge drilling apparatus according to a twenty third aspect is characterized by comprising a light shielding member for shielding light by covering the infrared ray sensor and the light transmitting member.

A glow discharge drilling apparatus according to a twenty fourth aspect is characterized by comprising stopping means for, when the temperature measuring means measures a temperature, stopping applying a voltage.

A glow discharge drilling apparatus according to a twenty fifth aspect is characterized by comprising means for intermittently applying a voltage, wherein the temperature measuring means is provided so as to measure a temperature based on an infrared-ray received by the infrared ray sensor when voltage application is intermitted while a voltage is intermittently applied.

A glow discharge drilling apparatus according to a twenty sixth aspect is characterized by comprising: accepting means for accepting a reference temperature; means for carrying out comparative determination between the reference temperature accepted by the accepting means and a temperature measured by the temperature measuring means; and lowering means for, in the case where it is determined that the temperature measured by the temperature measuring means is equal to or greater than the reference temperature accepted by the accepting means, lowering a value associated with an applied voltage.

A glow discharge drilling apparatus according to a twenty seventh aspect is characterized by comprising: means for intermittently applying a voltage; accepting means for accepting a reference temperature; means for carrying out comparative determination between the reference temperature accepted by the accepting means and a temperature measured by the temperature measuring means; and lowering means for, in the case where it is determined that the temperature measured by the temperature measuring means is equal to or greater than the reference temperature accepted by the accepting means, lowering a duty ratio relevant to application while a voltage is intermittently applied and/or an electric power value relevant to an applied voltage, wherein the temperature measuring means is provided so as to measure a temperature based on an infrared ray received by the infrared ray sensor when voltage application is intermitted while a voltage is intermittently applied.

A glow discharge drilling method according to a twenty eighth aspect is a glow discharge drilling method for drilling a sample by means of a glow discharge generated by applying a voltage between a hollow electrode and the sample disposed to be opposed to the hollow electrode, characterized by receiving an infrared ray radiated from a drilled site of the sample, the infrared ray having passed through a hollow portion of the hollow electrode; measuring a temperature of the drilled site of the sample based on the received infrared ray; comparing the measured temperature and a reference temperature accepted in advance; and, in the case where the measured temperature is equal to or greater than the reference temperature as a result of the comparison, lowering a value associated with an applied voltage.

In the first aspect and the ninth aspect, a small space is formed by sealing a space at which an electrode and a sample are opposed to each other and inert gas is supplied to that space, so that the inert gas can be reliably supplied to the sample. As a result, sputtering caused by a glow discharge occurs to so as to concentrated with respect to the sample in the sealed space, so that the sample can be effectively drilled by means of sputtering and precision relevant to drilling can be improved.

Further, in the first aspect and the ninth aspect, electric power is intermittently supplied, and thus, sputtering due to a glow discharge occurs intermittently. Thus, a load of a sample subjected to a sputtering force is reduced. Therefore, even in the case where the sample is formed of an easily melted material or in the case where the sample is made of a material easily broken by an external force equal to or greater than a predetermined force, the sample load is reduced, and the sample is well drilled, so that a surface suitable to observation can be formed. Intermittent electric power supply can also be applied to a case in which either of a direct current and a high frequency (alternating current) voltage is applied.

In the second aspect, it is possible to switch continuous electric power supply and intermittent electric power supply. Thus, an electric power supply mode is switched in accordance with sample characteristics, and drilling is carried out without breaking the sample, whereby a good observation face can be formed. These two electric power supply modes can be switched even during drilling. For example, continuous electric power supply is carried out at a first half of the whole drilling time, and intermittent electric power supply is carried out at a latter half of the whole drilling time, whereby effective drilling can be achieved for a sample having a hard material in the vicinity of a surface and having a soft material at a distant site in a depth direction from the surface.

In the third aspect, continuous electric power supply and intermittent electric power supply are switched with respect to an apparatus for drilling a sample surface by means of a glow discharge in a drilling processing chamber, whereby a drilling process according to the sample characteristics can be achieved, and a good observation face can be formed.

In the fourth aspect, a state relevant to intermittent electric power supply is changed. Thus, a drilling process according to sample characteristics can be carried out in more detail, and an observation face suitable to a structural observation or the like by using a scanning electron microscope can be easily formed.

In the fifth aspect and tenth aspect, a state relevant to intermittent electric power supply can be changed with respect to an apparatus for drilling a sample surface by means of a glow discharge in a drilling processing chamber, whereby an adjustment relevant to the glow discharge can be carried out finely in consideration of a sample characteristics and the drilling process can be carried out.

In the sixth aspect, the number of the times per unit time electric power is supplied, i.e., a frequency relevant to intermittent electric power supply can be changed. Thus, a sample surface can be drilled while sample melting and breakage or the like is reliably avoided, and good drilling can be carried out with respect to a sample including a plurality of materials. It is preferable that a frequency relevant to electric power supply can be changed even during drilling. In particular, with respect to a sample having a complicated structure, it is preferable to properly change a frequency in accordance with a degree of drilling and to carry out a drilling process adapted to material characteristics targeted for drilling.

In the seventh aspect, a duty ratio relevant to intermittent electric power supply is changed. Thus, an optimal glow discharge can be generated in accordance with a variety of sample characteristics. In addition, a drilling process can be carried out while adjusting a duty ratio so that a sample is neither melted nor broken. It is preferable that a change of the duty ratio can be made even during drilling.

In the eighth aspect, an electric power value relevant to intermittent electric power supply is changed. Thus, drilling can be carried out while a glow discharge is generated while an electric power value is adjusted to an electric power value according to a sample. In particular, in the case where the sample is composed of a plurality of materials having different characteristics, it is preferable in carrying out good drilling to change an electric power value during drilling.

In the eleventh aspect, there is provided measuring means for directly measuring a depth drilled by carrying out light irradiation to a drilled site and light receiving of reflection light. Thus, a numeric value of the drilled depth with high precision can be checked with respect to a drilling process using a glow discharge. With respect to light used for measuring, it is preferable to use light beams having different wavelengths relevant to light beams according to sample specific elements emitting light with a glow discharge in that measurement can be carried out whatever a drilling situation may be. Specifically, a laser light beam having a wavelength of several tens of nanometers to several tens of thousands of nanometers is preferred.

In the twelfth aspect, a penetrating portion is disposed on an electrode, and light irradiation and light receiving of reflection light are carried out through the penetrating portion. Thus, even if the electrode and a sample are disposed to be opposed to each other, light can be reliably irradiated to a drilled site of the sample, and the drilled depth can be stably measured.

In the thirteenth aspect, a cavity is provided to hold an electrode having a penetrating portion on a holding member that comprises a light transmitting member capable of capturing light from the outside and light irradiation and light receiving of reflection light are carried out through the light transmitting member, the cavity and penetrating portion. Thus, even in the case where sample drilling is carried out by using means for generating a glow discharge such as a glow discharge tube, light is reliably irradiated to a drilled site, whereby measurement of the drilled depth can be carried out. The light transmitting member may have a lens function for changing an optical diameter of light to be irradiated.

In the fourteenth aspect, an irradiation and light receiving section for carrying out light irradiation and light receiving of reflection light is opposed to the light transmitting member, thus making it possible to smoothly irradiate light to a sample. In addition, the irradiation and light receiving section and the light transmitting member are shielded from light by means of a light shielding member so that the irradiation and light receiving section can be avoided from being affected by ambient bright light, and the drilled depth can be stably measured.

In the fifteenth aspect, when light receiving of reflection light is carried out, voltage application is stopped. Thus, while voltage application is stopped, light emission of a sample specific element due to a glow discharge does not occur. As a result, measuring means can receive only reflection light reliably, and precision relevant to measurement can be highly maintained while eliminating light other than the reflection light which may cause a measurement error.

In the sixteenth aspect, a voltage is intermittently applied, and thus, an occurrence of sputtering due to a glow discharge also becomes intermittent. Thus, a load of a sample subjected to a sputtering force is reduced. Therefore, with respect to a sample formed of an easily melted material and a sample formed of a fragile material easily broken by an external force equal to or greater than a predetermined force, a good observation face can be formed while the sample load is reduced. Further, light receiving of reflection light is carried out in synchronism with a time of stopping the above described intermittent application. Therefore, measuring means can receive only reflection light reliably and carry out depth measurement with high precision without being affected by light emission of a sample specific element due to a glow discharge. In addition, a time at the time of stopping application relevant to intermittent voltage application can be efficiently utilized.

In the seventeenth aspect, in the case where a drilled depth is accepted, and a measured drilled depth has reached the accepted drilled depth, drilling is terminated. Thus, an automated drilling process using a glow discharge can be achieved with high processing precision, and a sample observation face formed at a desired depth can be easily obtained. As a result, a stable drilling process can be carried out during a predetermined processing time without dependency on a processing person, and thus, inconvenience and time required for a preparatory stage of observation can be remarkably reduced as compared with a conventional case.

In the eighteenth aspect, a plurality of drilled depths are obtained by irradiation of a plurality of light beams and an average value of a plurality of the obtained drilled depths is calculated. Thus, an effect of irregularities on a drilled face at a microscopic level can be eliminated by software-based processing. In addition, the impairment of measurement precision due to irregularities of the drilled face can be provided, and measurement with high precision can be stably carried out.

In the nineteenth aspect, measurement of a drilled depth is carried out by light irradiation and light receiving of reflection light, and drilling is terminated in accordance with a result of the measurement. Thus, a time of the end of drilling can be determined based on a measurement value, and an automated drilling process can be achieved with good processing precision.

In the twentieth aspect, an infrared ray radiated from a sample is passed through a hollow portion of a hollow electrode, and the passed infrared ray is received by an infrared ray sensor. Thus, the infrared ray radiated from a drilled site of a deep position opposite to the hollow electrode can be smoothly received. In addition, temperature measuring means measures a temperature of a drilled site based on the infrared ray received by the infrared ray sensor so that the temperature of the drilled site itself can be measured based on the infrared ray radiated from the drilled site of a sample. Therefore, by checking the measured temperature, a drilling process can be carried out while a degree of applying a voltage is adjusted so as not to reach a temperature at which a thermal influence is generated, and a good observation face can be formed with respect to a sample that is easily affected by a heat. A thermal influence is generated in accordance with samples at a variety of temperatures. Thus, in order to form a good observation face, it is important to check in advance a temperature at which a thermal influence of a sample targeted for a drilling process is generated so that a measured temperature does not reach the thus checked temperature.

In the twenty first aspect, by moving means, a position of a light receiving face of an infrared ray sensor can be adjusted with respect to a drilled site of a sample. Thus, an area in which an infrared ray is radiated (viewing field of measurement) can be optimally adjusted, and precision relevant to temperature measurement can be improved while the infrared ray radiated from the drilled site of the sample is reliably received.

In the twenty second aspect, a cavity and a light transmitting member capable of passing an infrared ray radiated from a sample are provided at a holding member for holding a hollow electrode. Thus, an infrared ray sensor can be disposed outwardly of the holding member so as to receive the infrared ray over the light transmitting member. As a result, the infrared ray sensor is not directly affected by sputtering, stable light receiving can be carried out, and position adjustment and maintenance or the like of the infrared ray sensor can be easily carried out.

In the twenty third aspect, a light shielding member for covering an infrared ray sensor and a light transmitting member is provided. Thus, the entry of bright light is shielded during light receiving of the infrared ray sensor, and a circumstance can be eliminated such that measurement precision is lowered by ambient bright light, and precision relevant to temperature measurement can be maintained.

In the twenty fourth aspect, when temperature measurement is carried out, voltage application is stopped. Thus, light emission due to sputtering does not occur, a state can be produced such that only the infrared-ray radiated from a sample can be received by an infrared ray sensor, and thus, a temperature of a drilled site of the sample can be properly measured without being affected by sputtering. As a mode relevant to stoppage of voltage application, it is possible to presume a cycle at which, after a voltage has been applied at a predetermined period of time, such voltage application is stopped for the purpose of temperature measurement, and if the measured temperature does not exceed an allowable temperature of the sample, a voltage is applied again.

In the twenty fifth aspect, a voltage is intermittently applied, and thus, an occurrence of sputtering becomes intermittent. A degree of thermal influence (thermal damage) subjected to a sample is mitigated as compared with a case where a voltage is continuously applied. Thus, at the time of drilling a sample easily affected by a heat and a fragile material or the like easily broken by an external force equal to or greater than a predetermined force, processing can be carried out while restricting a sputtering force. Further, in the case where a voltage is intermittently applied, a temperature is measured based on an infrared ray received at the time of stopping application while a voltage is intermittently applied. Therefore, only the infrared ray radiated from a sample is received without receiving light emission due to sputtering, and temperature measurement with high precision can be carried out when voltage application is stopped. In addition, a time of stopping voltage application is utilized for a time of temperature measurement so that a drilling process including temperature measurement can be efficiently promoted.

In the twenty sixth aspect and twenty eighth aspect, in the case where a measured temperature has reached a reference temperature or more as a result of comparing the reference temperature and the measured temperature, a value associated with an applied voltage is lowered. Thus, when there is a danger that deterioration occurs with a sample, a heat rate applied to the sample can be restricted. As a result, during a drilling process, a temperature rise of the sample is automatically restricted, and a sample subjected to a drilling process can be reliably prevented from deteriorating so as not to be suitable to observation. In order to prevent a thermal damage to the sample, it is important to set an allowable temperature to an extent such that a thermal influence does not occur with a sample targeted for a drilling process or to set a temperature slightly lower than the allowable temperature, to the reference temperature.

In the twenty seventh aspect, in the case where a measured temperature is equal to or greater than a reference temperature, either or both of a duty ratio and an electric power value relevant to application during intermittent voltage application is lowered. Thus, in the case where a sample is drilled by intermittently applying a voltage, even when a temperature has risen to an extent such that a thermal damage occurs with the sample, a heat rate applied to the sample can be reliably reduced. Therefore, a temperature rise at a drilled site of the sample can be restricted, and a stable automatic drilling process can be achieved even for a sample easily affected by a heat.

The above and further objects and features of the invention will more fully be apparent from the following detailed description with accompanying drawings.

### BRIEF DESCRIPTION OF THE SEVERAL VIEWS OF THE DRAWINGS

FIG. 1 is a schematic view depicting a whole configuration of a glow discharge drilling apparatus according to a first embodiment of the present invention;
FIG. 2 is a sectional view of a glow discharge tube;
FIG. 3 is a block diagram depicting an internal configuration of a generator;
FIG. 4 is a graph depicting an aspect of a high frequency voltage to be applied;
FIG. 5A is a graph depicting an aspect of electric power supply in a continuous mode;
FIG. 5B is a graph depicting an aspect of electric power supply in an intermittent mode;
FIG. 6 is a block diagram depicting an internal configuration of a matching box;
FIG. 7 is a schematic view depicting the contents of a setting menu according to mode selection and frequency setting or the like;
FIG. 8 is a flow chart showing operating procedures in a glow discharge drilling method using a glow discharge drilling apparatus;
FIG. 9 is a schematic view depicting a sample drilling state;
FIG. 10 is a graph depicting an electric power supply aspect in which a duty ratio is differentiated from another one on a time period by time period basis.
FIG. 11 is a graph depicting an electric power supply aspect in which an electric power supply frequency is differentiated from another one on a time period by time period basis;
FIG. 12 is a graph depicting an electric power supply aspect in which an electric power value is differentiated from another one on a time period by time period basis;
FIG. 13 is a schematic view depicting a state in which drilling is carried out with respect to a sample held by using a sample holding device;
FIG. 14A is a schematic view depicting a silicon wafer;
FIG. 14B is a schematic view depicting a plurality of short strips;
FIG. 14C is a schematic view depicting a sample formed by bonding short strips to each other;
FIG. 15 is a sectional view showing a glow discharge tube according to a modified example;
FIG. 16 is a schematic view depicting a configuration of a glow discharge drilling apparatus according to a modified example;
FIG. 17A is an image of a whole microgram of a silicon substrate before drilled;
FIG. 17B is an image of a microgram showing an enlarged view of a surface of the silicon substrate before drilled;
FIG. 17C is an image of a microgram showing a further enlarged view of a surface of the silicon substrate before drilled;
FIG. 18A is an image of a whole microgram of a silicon substrate after drilled;
FIG. 18B is an image of a microgram showing a further enlarged view of a surface of the silicon substrate after drilled;
FIG. 18C is an image of a microgram showing a further enlarged view of the silicon substrate after drilled;
FIGS. 19A and 19B are images of a microgram of a plastic material surface before drilled;
FIG. 19C is a graph depicting a difference in level at two sites on the surface of the plastic material;
FIGS. 20A and 20B are images of a microgram on a plastic material surface after drilled in accordance with an intermittent mode;
FIG. 20C is a graph depicting a difference in level at two sites on the surface of the plastic material;
FIG. 21A is an image of a whole microgram of a plastic material after drilled in accordance with a continuous mode;
FIG. 21B is an image of a microgram showing an enlarged view of a plastic material surface after drilled in accordance with a continuous mode;
FIG. 21C is an image of a microgram showing a further enlarged view of a plastic material surface after drilled in accordance with a continuous mode;
FIGS. 22A and 22B are images of a microgram before drilling a semiconductor cross section;
FIGS. 22C and 22D are images of a microgram when drilling is carried out in a continuous mode;
FIGS. 22E and 22F are images of a microgram when an electric power supply condition is changed and drilling is carried out in a continuous mode;
FIGS. 23A to 23C are photographic images of a surface when some parts of one silicon wafer cut out and laminated in plurality are drilled in a continuous mode;
FIGS. 24A and 24B are images of a microgram of a metal material surface before drilled;
FIG. 24C is a graph depicting a difference in level at two sites on the surface of he metal material;
FIGS. 25A and 25B are images of a microgram of a metal material surface after drilled in a continuous mode;
FIG. 25C is a graph depicting a difference in level at two sites on the surface of the metal material;
FIG. 26 is a schematic view depicting a whole configuration of a glow discharge drilling apparatus according to a second embodiment of the present invention;
FIG. 27 is a partially sectional schematic view showing a glow discharge tube and a sensor head;
FIG. 28A is a graph depicting an electric power supply aspect in a continuous mode;
FIG. 28B is a graph depicting an electric power supply aspect of an intermittent mode and a period of time for measuring a drilled depth;
FIG. 29 is a schematic view depicting a setting menu for setting mode selection and a drilled depth or the like;
FIG. 30 is a graph depicting a period of time for carrying out a drilling process and measurement of a drilled depth;
FIG. 31 is a first flow chart showing operating procedures in a glow discharge drilling method using a glow discharge drilling apparatus;
FIG. 32A is a schematic view depicting a sample drilling state;
FIG. 32B is a view illustrating a drilled depth to be measured;
FIG. 33 is a second flow chart showing operating procedures relevant to measurement of a drilled depth in a glow discharge drilling method;
FIG. 34 is a graph depicting an operating aspect for carrying out measurement of a drilled depth after a drilling process has been carried out for a predetermined time;
FIG. 35 is a sectional view of essential portions showing a glow discharge tube according to a modified example;
FIG. 36A is a schematic view depicting part of a glow discharge tube and a length measuring device according to another modified example;
FIG. 36B is a schematic view depicting a laser light beam irradiation and reflection situation at a drilled site of a sample;
FIG. 37 is a schematic view showing a configuration of a glow discharge drilling apparatus according to a modified example;
FIG. 38 is a schematic view depicting a whole configuration of a glow discharge drilling apparatus according to a third embodiment of the present invention;
FIG. 39 is a partially sectional schematic view showing a glow discharge tube and an infrared ray sensor;
FIG. 40A is a graph depicting an electric power supply aspect of a continuous mode;
FIG. 40B is a graph depicting an electric power supply aspect of an intermittent mode and a temperature measurement period of time;
FIG. 41 is a schematic view showing the contents of a setting menu accepting a mode selection and a reference temperature or the like;
FIG. 42 is a first flow chart showing operating procedures in a glow discharge drilling method using a glow discharge drilling apparatus;
FIG. 43 is a schematic view depicting a sample drilling state;
FIG. 44 is a second flow chart showing procedures for drilling processing operation in an intermittent mode in the glow discharge drilling method;
FIG. 45 is a graph depicting a relationship between a drilling time and a temperature measurement time in a continuous mode;
FIG. 46 is a schematic view depicting a modified example relating to mounting of an infrared ray sensor; and
FIG. 47 is a schematic view depicting an aspect of mounting the infrared ray sensor according to the modified example.

### DETAILED DESCRIPTION OF THE INVENTION

### First embodiment

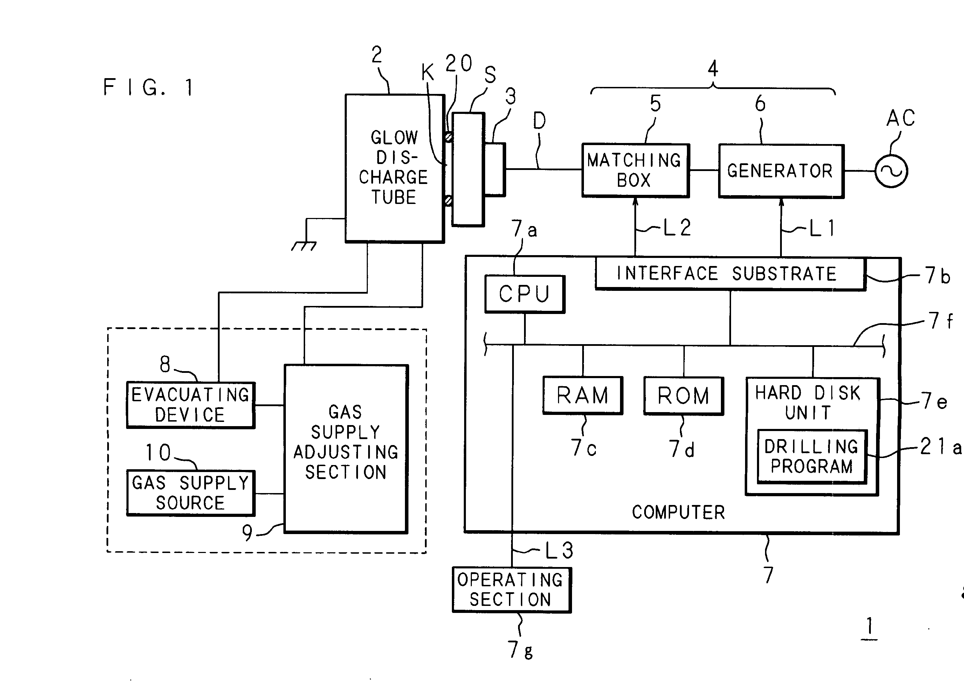

FIG. 1 shows a whole configuration of a glow discharge drilling apparatus 1 according to a first embodiment of the present invention. The glow discharge drilling apparatus 1 comprises: a glow discharge tube 2 for generating a glow discharge with respect to a sample S targeted for drilling; an electric power supply section 4 for supplying electric power with a high frequency; and a computer 7 for making whole control of the apparatus.

The electric power supply section 4 comprises a generator 6 and a matching box 5 connected to an alternating current electric power supply AC (220 V in the present embodiment) to generate electric power with a high frequency. In addition, in FIG. 1, the portions enclosed by the dashed line designate peripheral devices or the like that do not belong to an essential configuration of the glow discharge drilling apparatus 1. The peripheral devices or the like include: an evacuating device 8 for evacuating the inside of the glow discharge tube 2; a gas supply adjusting section 9 for supplying inert gas (argon gas) to the inside of the glow discharge tube 2 after the evacuation; and a gas supply source 10 (gas supply section). The gas supply adjusting section 9 comprises a valve or the like for adjusting a flow rate, and the gas supply source 10 corresponds to a cylinder filled with inert gas such as argon gas or mixture gas of inert gas or the like.

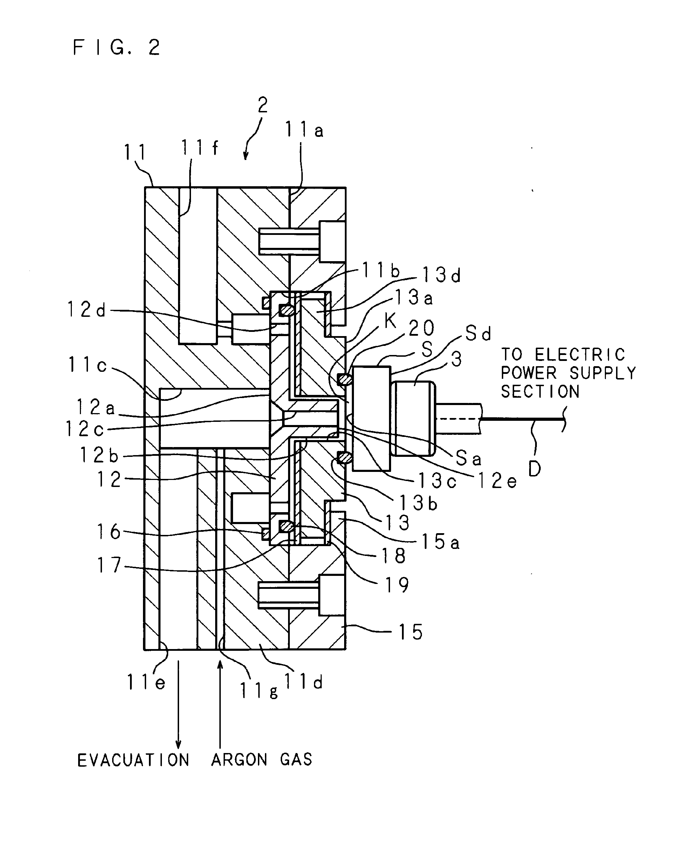

FIG. 2 is a sectional view depicting a configuration of a glow discharge tube 2. The glow discharge tube 2 is composed of: a short cylinder shaped lamp body 11; an electrode (anode) 12; a ceramics member 13; and a pressurizing block 15 in combination.

The lamp body 11 recesses a cavity portion 11b for mounting the electrode 12 at a center site of an end face 11a with which the pressurizing block 15 is combined, and punches a cavity 11c at a center part of the cavity portion 11b. In addition, the lamp body 11 provides a plurality of suction holes 11e, 11f used for evacuation in a radiation manner from a peripheral wall portion 11d to the center; some suction holes 11e are caused to communicate with a cavity 11c; and other suction holes 11f are caused to communicate with the cavity portion 11b. Further, the lamp body 11 comprises a gas supply hole 11g for supply of inert gas from the peripheral wall portion 11d to the center so as to communicate with the cavity 11c.

The electrode 12 housed in the cavity section 11b of the lamp body 11 is formed in a shape such that a cylinder portion 12b is protruded from the center of a disk portion 12a, and a through hole 12c for penetrating the disk portion 12a from the inside of the cylinder portion 12b is punched. In addition, a hole 12d is formed at the disk portion 12a. When the electrode 12 is mounted on the cavity portion 11b of the lamp body 11, an earth electric potential is obtained via the lamp body 11. In order to maintain sealing property of the cavity 11c of the lamp body 11 and the through hole 12c of the electrode 12 in a state in which the electrode 12 is housed, a first O-ring (sealing member) 16 is mounted between the lamp body 11 and the electrode 12.

The ceramics member 13 is provided as a thick disk-shaped member. This ceramics member is designed to be disposed at the lamp body 11 while the electrode 12 is covered from the cylinder portion 12b. This ceramics body has a flange portion 13b protruded to cover the disk portion 12a of the electrode 12. In addition, an insert hole 13c for inserting the cylinder portion 12b of the electrode 12 is formed at a center site. In addition, the ceramics member 13 recesses a ring groove 13b for mounting an O-ring on an end face 13a that is exposed. The ceramics member 13 is disposed with respect to the disk portion 12a of the electrode 12 via a heat resistance first insulating element 17. In the disposed state, a predetermined gap is formed between the through hole 13c of the ceramics member 13 and the cylinder portion 12b of the electrode 12. An end 12e of the cylinder portion 12b is positioned at a slightly deep site so as not to be more protrusive than an end face 13a of the ceramics member 13. A second O-ring 18 is mounted between the first insulating element 17 and the disk portion 12a of the electrode 12 for the purpose of maintaining sealing property.

The pressurizing block 15 for fixing the electrode 12 and the ceramics member 13 to the lamp body 11 is provided as a ring-shaped member so that a flange portion 13d of the ceramics member 13 is pressurized against the lamp body 11 at a protrusion portion 15a at the inner periphery rim. The pressurizing block 15 itself is mounted on the end face 11a of the lamp body 11 with a bolt. In addition, a heat resistance second insulating body 19 is intervened between a protrusion portion 15a of the pressurizing block 15 and the flange portion 13d of the ceramics member 13.

On the other hand, a sample S targeted for drilling, the sample being mounted on the glow discharge tube 2, is disposed so that a sample surface Sa abuts against a third O-ring 20 (corresponding to a sealing member) mounted on the end face 13a of the ceramics member 13. Further, in this state, an oscillator 3 is pressed against a back face Sd of the sample S, and the sample S is pressurized against the glow discharge tube 2. The thus disposed sample S is opposed to the through hole 12c of the electrode 12. In addition, a space K sealed to be surrounded by the third O-ring 20 is formed at a space at which the drilled face Sa of the sample S and the end 12e of the cylinder portion 12b of the electrode 12 are opposed to each other. The oscillator 3 is connected to an electric power supply section 4 by means of an electric power supply line D, as shown in FIG. 1. In addition, the sample S is pressurized against the glow discharge tube 2 with an optimal pressurizing force by predetermined locking means, although not shown.

In the glow discharge tube 2 configured as described above, the suction holes 11e, 11f of the lamp body 11 are connected to the evacuating device 8 shown in FIG. 1, and the gas supply hole 11g is connected to the gas supply adjusting section 9. Thus, when the evacuating device 8 carries out evaluation, the space K is evacuated through the suction holes 11e, 11f, the cavity 11c, and the through hole 12c of the electrode 12. In addition, in a state in which the space K is vacuumed, when the gas supply adjusting section 9 starts gas supply, inert gas is supplied to the space K through the gas supply hole 11g, the cavity 11c, and the through hole 12c of the electrode 12. At this time, the space K is sealed by means of the third O-ring 20, and is reduced in volume, and thus, a sufficient inert gas is supplied to the space K. In the glow discharge tube 2, the gas supply hole 11g, the cavity 11c, and the through hole 12c of the electrode 12 function as gas supply passages to the space K.

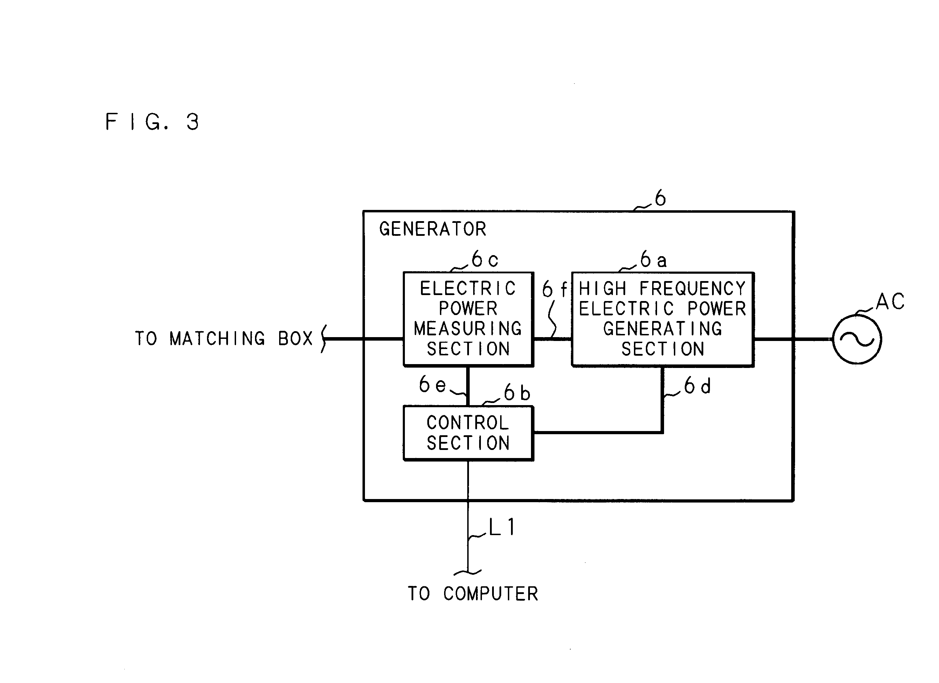

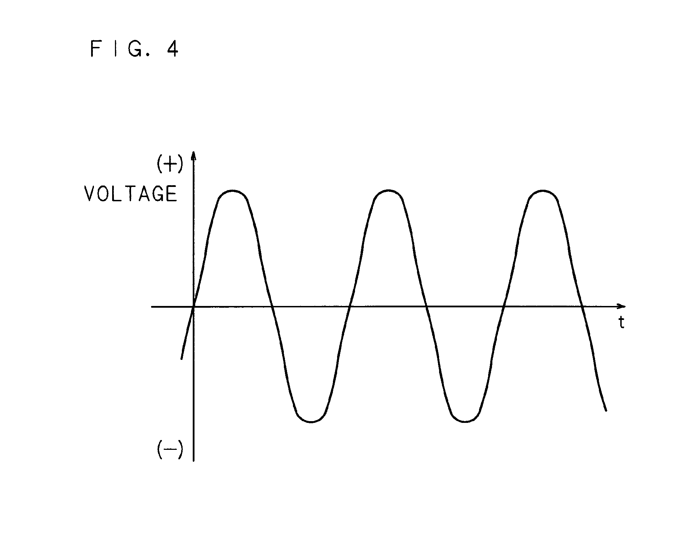

FIG. 3 shows an internal configuration of the generator 6 that configures the electric power supply section 4. The generator 6 comprises a high frequency electric power generating section 6a, a control section 6b (a controller), and an electric power measuring section 6c. The high frequency electric power generating section 6a is connected to an alternating current electric power supply AC. This generating section generates high frequency electric power so that an alternating current (high frequency) voltage to be changed to a positive (+) direction and a negative (-) direction shown in FIG. 4 can be applied to the sample S and the electrode 12. In addition, the high frequency electric power generating section 6a is connected to the control section 6b via a first internal connection line 6d. This generating section adjusts an output mode and an electric power value or the like relevant to high frequency electric power under the control of the control section 6b. The high frequency electric power generating section 6a according to the present embodiment generates electric power that consists of a high frequency voltage of 13.56 MHz.

The control section 6b is composed of an IC (integrated circuit), and is connected to the computer 7 through a first connection cable L1. This control section determines an electric power supply aspect (voltage application aspect) relevant to the glow discharge tube 2 and the sample S such as whether continuous or intermittent electric power supply is carried out based on a variety of signals outputted from the computer 7, and controls an output mode of the high frequency electric power generating section 6a based on a result of the determination.

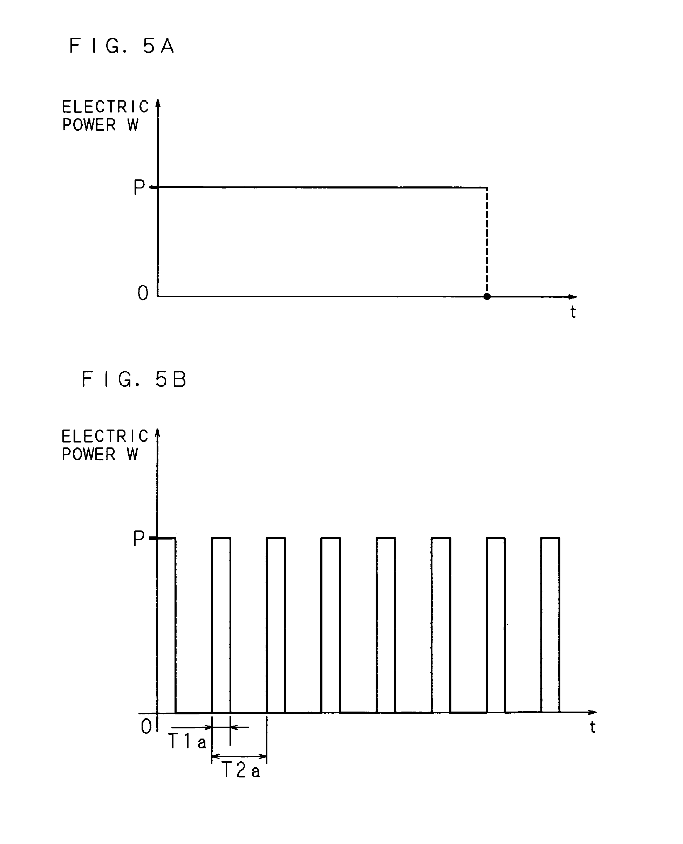

FIG. 5A is a graph depicting a first output mode using a control section 6b. In this mode, within a predetermined period of time, high frequency electric power (electric power value P) is continuously outputted, and a high frequency voltage is continuously applied to the sample S and the electrode 12 (hereinafter, referred to a continuous mode). In addition, FIG. 5B is a graph depicting a second output mode using the control section 6b. In this mode, within a predetermined period of time, high frequency electric power (electric power value P) is outputted in a pulse-based manner (in an ON/OFF switching manner), and high frequency electric power (electric power value P) is outputted, and a high frequency voltage is intermittently applied to the sample S and the electrode 12 (hereinafter, referred to as an intermittent mode).

The control section 6b alternately carries out electric power supply and electric power supply intermission by carrying out a pulse-based processing operation by an internal IC serving as intermittent electric power supply means (means for intermittently applying a voltage) in an intermittent mode. By such a processing operation, high frequency electric power is outputted at an electric power supply time interval T1a that corresponds to a portion protruded in a rod shape shown in FIG. 5B. Then, output of high frequency electric power is intermitted at a time at which the electric power supply time interval T1a is subtracted from a unit time T2a including one cycle of electric power supply and electric power supply intermission, respectively. In addition, the control section 6b continuously carries out electric power supply as continuous electric power supply means.

In addition, the control section 6b serves as switching means for switching the above described continuous mode and intermittent mode based on a signal outputted from the computer 7. Further, the control section 6b functions as electric power supply state change means for changing a state relevant to intermittent electric power supply in an intermittent mode, making it possible to change the number of the times electric power is supplied (electric power supply frequency) per unit time (one second), a duty ratio relevant to intermittent electric power supply and an electric power value of intermittent electric power supply, respectively.

In response to a change of an electric power supply frequency, the control section 6b can adjust an electric power supply frequency in the range of about 30 Hz to about 30000 Hz. When the electric power supply frequency is changed, a time between electric power supplies (difference between T2a and T1a) changes in the graph shown in FIG. 5B. In addition, with respect to a change of a duty ratio, a rate (T1a/T2a) of one-shot electric power supply time interval T1a to a unit time T2a during intermittent electric power supply can be properly regulated.

In addition, as drilling of the sample S advances, a distance between a drilled site surface of the sample S and the end 12e of the electrode 12 increases, and an impedance value relevant to the sample S in applying a voltage changes any time. Thus, the control section 6b also carries out an adjusting processing relevant to a change of an impedance value in an intermittent mode.

Specifically, the control section 6b computes a difference between an output value Pf and a reflection value Pr transmitted from the electric power measuring section 6c described later, and makes control for changing an electric power value (output value Pf) of a traveling wave produced when the high frequency electric power generated by the high frequency electric power generating section 6a based on the computed difference is supplied to the sample S. The control section 6b adjusts the output value Pf so that the computed difference (Pf - Pr) is constant. In the present embodiment, the control section 6b adjusts by its built-in IC software-based processing operation, the output value Pf generated by the high frequency electric power generating section 6a so that the computed difference (Pf - Pr) is equal to a reference electric power value transmitted from the computer 7 described later.

In this way, the control section 6b makes software-based adjustment, thereby enabling proper electric power supply in response to a change of an impedance value of the sample S in an intermittent mode. The control section 6b makes adjustment in response to the change of the impedance value of the sample S in the case of the intermittent mode, whereas the matching box 5 makes adjustment in a continuous mode, as described later.

Turning to FIG. 3, the electric power measuring section 6c of the generator 6 is connected to the control section 6b and the high frequency electric power generating section 6a via second and third internal connection lines 6e and 6f. The electric power measuring section 6c detects an output value Pf that is an electric power value of a traveling wave of high frequency electric power generated by the high frequency electric power generating section 6a, the wave traveling toward the oscillator 3 shown in FIG. 1. In addition, the electric power measuring section 6c detects a reflection value Pr that is an electric power value of the wave which is reflected and returned from the sample S, and transmits the detected value to the control section 6b.

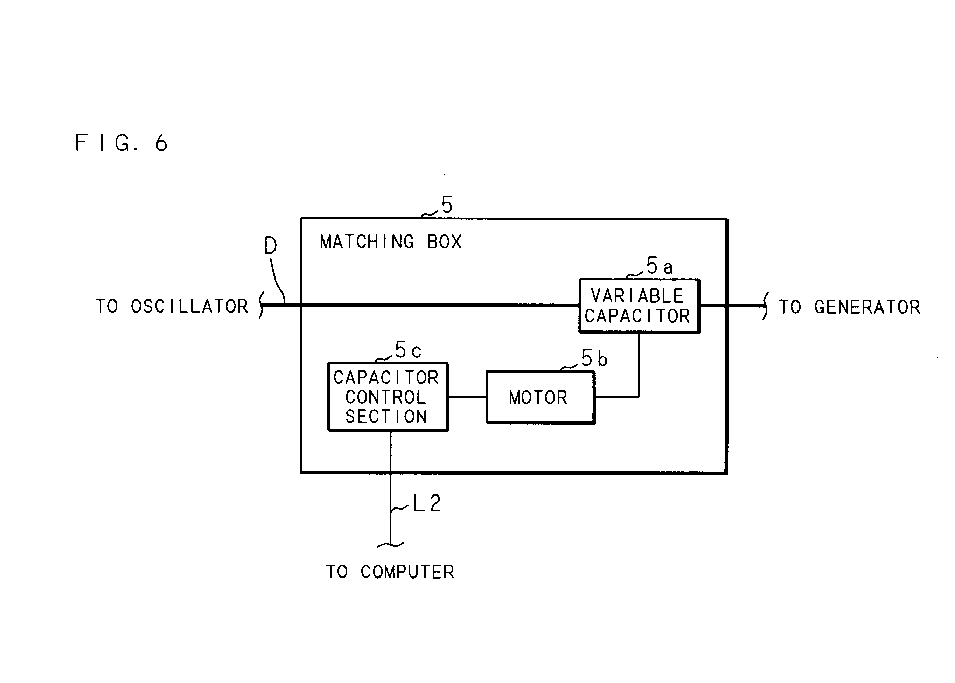

On the other hand, the matching box 5 of the electric power supply section 4, as shown in FIG. 6, comprises: a variable capacitor 5a for adjusting an output aspect of high frequency electric power generated by the generator 6 in a continuous mode; a motor 5b for adjusting an electric capacitance of the variable capacitor 5a; and a capacitor control section 5c for making control such as driving the motor 5b.

The variable capacitor 5a can change its own electric capacitance in response to driving of the motor 5b, and a module and a phase are regulated due to a change of the electric capacitance. In addition, a capacitor control section 5c is connected to the computer 7 via a second connection cable L2. The driving of the motor 5b is controlled based on a notifying signal set in an intermittent mode transmitted from the computer 7 to the matching box 5.

Specifically, in the case where the notifying signal in the intermittent mode has been accepted, the capacitor control section 5c makes control to maintain the motor 5b in a constant state so that the electric capacitance of the variable capacitor 5a is fixed to be constant. Therefore, in the intermittent mode, a module and a phase of high frequency electric power are not adjusted by means of the matching box 5. In addition, in the case where the notifying signal in the intermittent mode is not accepted, i.e., when a continuous mode has been set, the capacitor control section 5c makes control to change the electric capacitance of the variable capacitor 5a by controlling the driving of the motor 5b so that the reflection value Pr from the sample S becomes minimal. If the reflection value Pr is minimal, the capacitor control section 5c does not make control to change the electric capacitance of the variable capacitor 5a.

In addition, the computer 7 shown in FIG. 1 provides an interface substrate 7b having connected thereto a first connection cable L1 that extends from the generator 6 and a second connection cable L2 that extends from the matching box 5. This interface substrate 7b is connected to an internal bus 7f having connected thereto a CPU 7a (a main controller), a RAM 7c, a ROM 7d, and a hard disk unit 7e. An operating section 7g (accepting means, accepting section) is connected to the internal bus 7f via a connection line L3. In addition, the RAM 7c temporarily stores data or the like obtained when the CPU 7a carries out a variety of control processing operations. The ROM 7d stores in advance a program or the like having defined the contents of basic processing operations that the CPU 7a carries out. The hard disk unit 7e stores a drilling program 21a having defined the controls of control operations that the CPU 7a carries out in response to a drilling processing operation.

The interface substrate 7b has a continuous mode circuit and an intermittent mode circuit. When a mode set by a user is notified to the interface substrate 7b under the control of the CPU 7a, a circuit corresponding to the notified mode is actuated. Then, a control signal for mode switching is outputted to the generator 6 in accordance with the processing operation of the actuated circuit.

In addition, parameters such as an electric power supply frequency, a duty ratio, and an electric power value set at the computer 7 by a user in response to an intermittent mode are transmitted to the intermittent mode circuit of the interface substrate 7b. In addition, the intermittent mode circuit generates a signal having summarized the transmitted contents in one item, and outputs the generated signal to the generator 6. In addition, this circuit carries out a processing operation for outputting to the matching box 5 a notifying signal called manual adaptation for notifying the intermittent mode. The parameters to be transmitted include a peak electric power value of high frequency electric power and a reference electric power value (reference value) or the like for use in an adjusting process in response to a changing impedance value.

The CPU 7a carries out a variety of processing operations based on the drilling program 21a stored in the hard disk unit 7e, and makes predetermined settings and controls based on an instruction inputted by a user through keyboard or mouse operation, although not shown in FIG. 1.

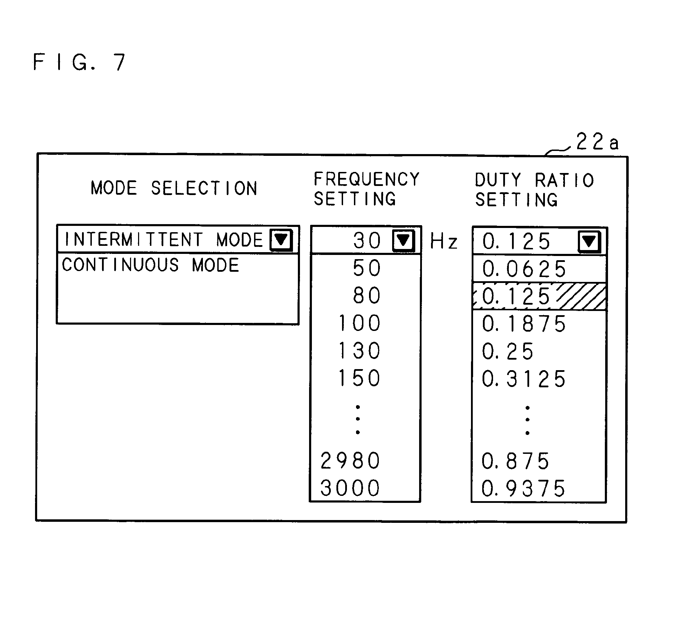

For example, when the drilling program 21a starts up, the CPU 7a causes an operator section 7g to displays a setting menu 22a shown in FIG. 7. In addition, in the case where an operation for an intermittent mode or a continuous mode has been accepted in accordance with the setting menu 22a, the CPU 7a carries out a processing operation for actuating a circuit in the interface substrate 7b that corresponds to the accepted contents of settings.

In the case where the intermittent mode has been set on the setting menu 22a, the CPU 7a carries out a processing operation for accepting numeric value settings of a frequency (electric power supply frequency) and a duty ratio from a user; notifies the accepted contents to the interface substrate 7b; and causes the interface substrate 7b to transmit a predetermined signal to the generator 6. It is preferable to set the duty ratio to a numeric value lower than 0.5 in the case where the sample S targeted for drilling is easily melted and is easily broken in particular.

In addition, the CPU 7a can set other parameters such as a time required for a drilling processing operation and a peak of high frequency electric power on another menu except the above described setting menu 22a. When an intermittent mode has been set, the CPU 7a makes control to output a notifying signal for notifying the setting of the intermittent mode from the interface substrate 7b to the matching box 5.

On the other hand, in the case where a continuous mode has been set on the setting menu 22a, the CPU 7a makes control to output a command signal from the interface substrate 7b to the generator 6 so as to supply electric power during a time set with respect to the drilling processing operation.

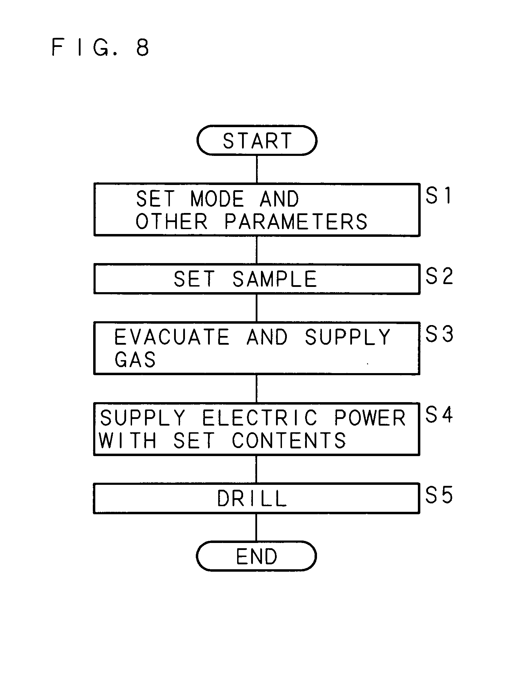

Now, with respect to a flow chart shown in FIG. 8, a description will be given with respect to whole operating procedures relevant to a glow discharge drilling method using the glow discharge drilling apparatus 1 configured as described above.

First, a variety of parameters such as a mode and a frequency, a duty ratio, and a drilling time or the like are set on a setting menu 22a or the like shown in FIG. 7 (S1), and a sample S is set at a glow discharge tube 2, as shown in FIG. 2 (S2).

Now, the inside of the glow discharge tube 2 is evacuated by means of the evacuating device 8, and then, inert gas (argon gas) is supplied to the inside of the glow discharge tube 2 from the gas supply source 10 (S3). Then, electric power is supplied in accordance with the set contents in an atmosphere in which the inert gas has been supplied to the space K (S4), and the surface Sa exposed in the space K of the sample S is drilled (S5).

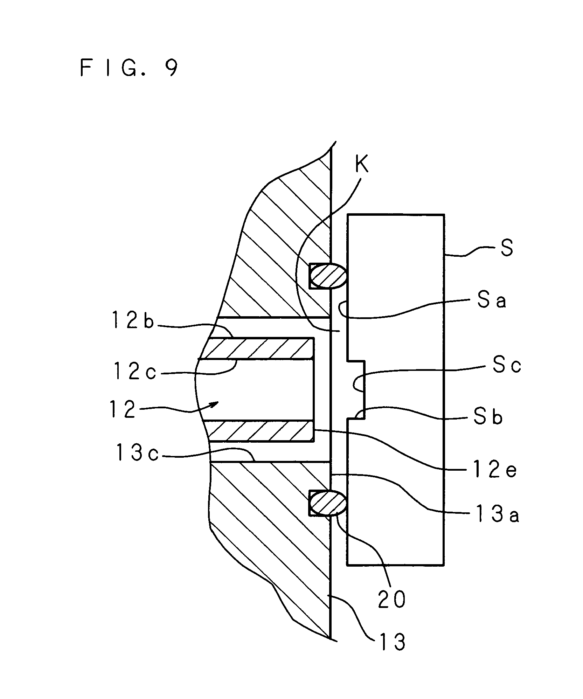

FIG. 9 shows a state of the drilled sample S. In the present embodiment, the argon gas is smoothly guided to the space K sealed by the third O-ring 20 through the through hole 12c of the electrode 12 so that a sufficient amount of the argon gas is supplied to the space K any time. In addition, electric power is supplied in this argon gas supply atmosphere, whereby a glow discharge occurs in the space K. Then, argon ions contained in the argon gas burst out toward the sample surface Sa and collide with the sample surface, and sputtering occurs. The sample surface Sa is drilled due to the collision of the argon ions during this sputtering, and a recessed portion Sb occurs. In the present embodiment, a sufficient amount of the argon gas is supplied, and thus, a degree of argon ion collision with the sample surface Sa also increases as compared with that in a conventional apparatus, and efficient drilling can be carried out. In addition, the drilled site is also obtained as a smooth and clean face as compared with that in a conventional case.

That is, a bottom face Sc of the drilled recessed portion Sb has a predetermined area according to a size of the end 12e of the electrode 12, and a clean site having met a predetermined degree of smoothness occurs in the bottom face Sc. Thus, an observation face (bottom face Sc) relevant to a scanning electron microscope can be easily formed as compared with a conventional polishing processing operation. Further, an observation face (bottom face Sc) having an excellent degree of smoothness can be obtained as compared with drilling due to a conventional glow discharge.

In addition, in the glow discharge drilling apparatus 1 according to the first embodiment, a constant mode and an intermittent mode can be set by switching it. Thus, electric power is supplied to an easily melted sample or an easily broken sample or the like in an intermittent mode, whereby drilling of a sample of such type that has been difficult in a conventional apparatus can be carried out smoothly without any problem. In particular, in the intermittent mode, an electric power supply frequency, a duty ratio, and an electric power value or the like can be set in detail, and thus, a delicate sample can also be reliably drilled. In addition, with respect to a sample other than those having the above described characters, argon ions are caused to continuously collide with the sample surface Sa by carrying out continuous mode operation so that efficient drilling can be carried out with good precision.

In the case where electric power has been supplied in the intermittent mode, when a difference between an output value Pf and a reflection value Pr is made constant with respect to a fluctuation of an impedance value of the sample S due to an occurrence of sputtering, a whole processing operation is made in accordance with the following flow of operation.

First, in a variety of parameter settings before electric power is supplied, when the computer 7 sets a reference electric power value to A watt, for example, a difference between the output value Pf and the reflection value Pr is concurrently set to be constant by means of a required IC included in the intermittent mode circuit of the interface substrate 7b. Then, the output value Pf of high frequency electric power supplied from the generator 6 to a sample S is adjusted to "a" watt. At this time, Pf - Pr = c = A watt is established.

Next, after sputtering has occurred due to drilling of the sample S caused by electric power supply, if an impedance value of the sample S changes, the reflection value Pr from the sample S also changes to "b" watt. Thus, Pf - Pr = a - b is established, and a difference between the output value Pf and the reflection value Pr is different from A watt.

If the difference between the output value Pf and the reflection value Pr is different to A watt, the generator 6 makes adjustment so that Pf - Pr = c and so that the output value Pf is set to a' watt. In this manner, Pf- Pr = a' - b = c = A watt is established, and the difference between the output value Pf and the reflection value Pr is maintained to be constant. In the intermittent mode as well, a stable electric power supply state is allocated.

The glow discharge drilling apparatus 1 according to the present invention is not limited to the above described embodiment, and various modifications can be applied thereto. For example, while the above described embodiment has explained a case of generating high frequency electric power and supplying the electric power, the above described processing operation and configuration according to the present invention can be applied to an apparatus for generating direct current electric power and supplying the electric power instead of high frequency electric power, and generating a glow discharge. Electric power supply of such direct current electric power is preferred when the sample S is an sample made of an electric conducting material such as a metal.

In addition, for example, in the case where no delicate sample is targeted for drilling, there may be provided a configuration of reducing an operating burden of the computer 7 (CPU 7a) by eliminating a setting processing operation relevant to an electric power supply frequency, a duty ratio, and an electric power value or the like. Further, in the case where a sample targeted for drilling is easily melted or easily broken, it is possible to provide apparatus exclusively available for use in an intermittent mode by eliminating a function for switching the intermittent mode and continuous mode. In the case where a sample targeted for drilling is easily drilled as that having characteristics other than the above described characteristics, an apparatus exclusively available for use in a continuous mode may be provided. By doing this, a variety of processing operations or the like relevant to the glow drilling apparatus 1 can be remarkably simplified.

On the other hand, in the case where a sample targeted for drilling is composed of a plurality of materials having different characteristics, a total drilling time may be divided into a plurality of time periods. Namely, electric power is supplied in a continuous mode at one time period and electric power is supplied in an intermittent mode at another time period, whereby one of these modes may be switched to another one even during a drilling processing operation. Mode switching is enabled during the drilling processing operation in this manner, whereby a good drilling processing operation can be carried out with respect to a sample or the like featured in that a hard material and a soft material hierarchically exist.

In addition, in the case of intermittent mode operation as well, intermittent electric power supply may be carried out by changing a state relevant to electric power supply on a plurality of time periods basis in a total drilling time.

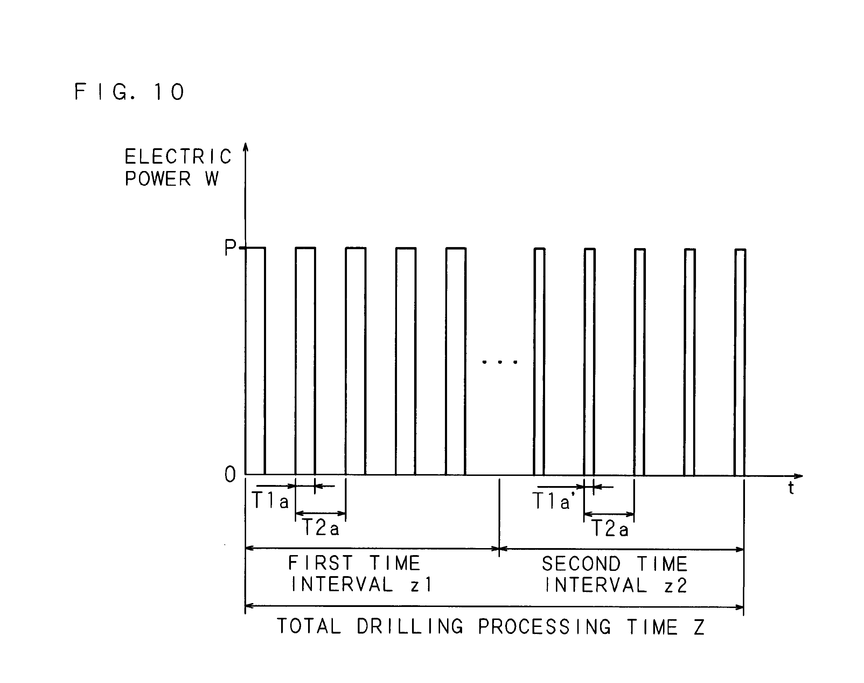

FIG. 10 shows an electric power supply state in which a total drilling processing time Z is divided into a first time interval z1 serving as a time period at which drilling starts and a second time interval z 2 serving as a time period at which drilling terminates, and a duty ratio is differentiated from another one depending on the first time interval z1 and the second time interval z2. In this case, at the first time interval z1, a duty ratio (T1a / T2a) similar to that shown in FIG. 5B is established. On the other hand, at the second time interval z2, a one-shot electric power supply time interval is set to T1a' (T1a' < T1a), and a duty ratio (T1a' / T2a) is smaller than that of the first time interval z1.

As a result, at the second time interval z2, a load due to electric power supply and a sputtering force are reduced as compared with those at the first time interval z1. Thus, a preferred electric power supply aspect can be allocated with respect to a sample or the like having a plurality of materials laminated thereon, featured in that a material for a layer serving as a deep layer is easily broken as compared with a top surface. In order to achieve such an electric power supply aspect, it is necessary for the computer 7 to enable settings such as the number of time periods obtained by dividing the total drilling time, a time occupied by each time period, and a duty ratio of each time period, on a menu as shown in FIG. 7, and then, transmit the contents of these settings to the generator 6, and to enable electric power supply control that corresponds to a time set by the control section 6b.

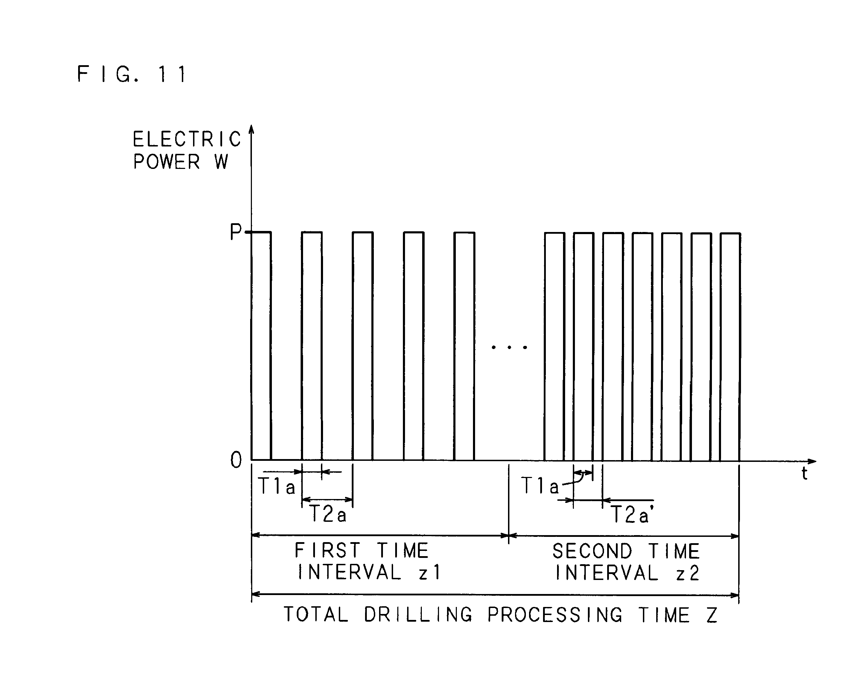

In addition, FIG. 11 shows an electric power supply state in which an electric power supply frequency of a second time interval z2 in a total drilling processing time Z is increased as compared with that of a first time interval z1. In this case, a unit time T2a' of the second time interval z2 is shorter than a unit time T2a of the first time interval z1. In thus way, one of the electric power supply frequencies is different from another one depending on each time period, whereby a load due to electric power supply and a degree of a sputtering force are also different from each other depending on each time period, making it possible to provide detail settings in accordance with sample characteristics targeted for drilling. In addition, in order to achieve an electric power supply aspect in which an electric power supply frequency are differentiated from another one depending on each time period, it is necessary for the computer 7 to enable dividing of a drilling time and setting of an electric power supply frequency with respect to each of the divided time periods.

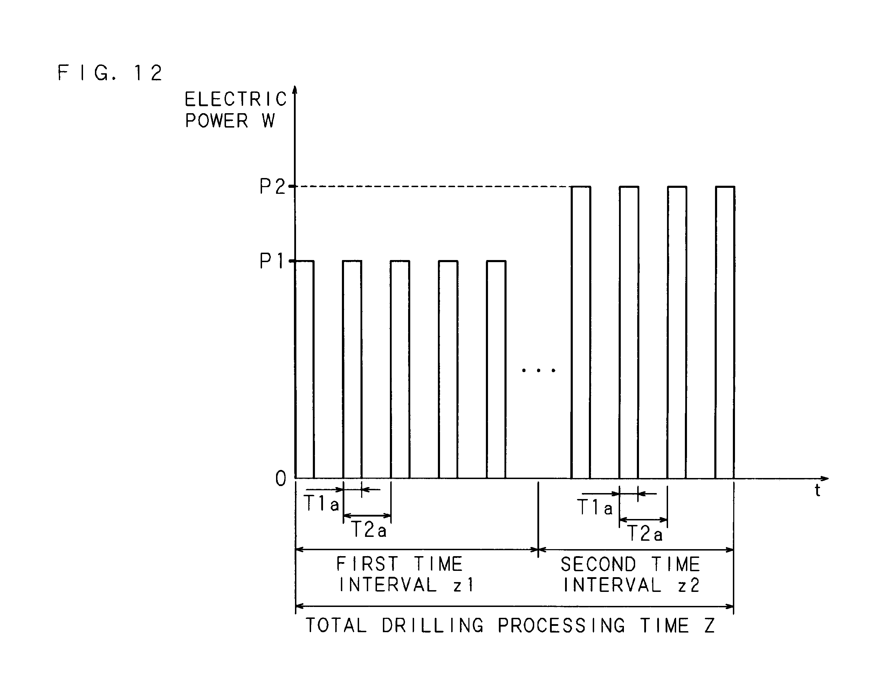

Further, FIG. 12 shows an electric power supply state in which an electric power value P2 of a second time interval z2 in a total drilling processing time Z is increased as compared with an electric power value P1 of a first time interval z1. The electric power values are different depending on time periods in this way, whereby a load due to electric power supply at each time period and a degree of a sputtering force are also different from each other, making it possible to allocate an electric power supply condition according to a sample targeted for drilling. Any one of these electric power value settings different depending on each of the time periods is suitable to a sample having a plurality of materials laminated thereon. In addition, in order to supply electric power at an electric power value different depending on each of the time period, it is necessary for the computer 7 to enable acceptance of settings of the number of time periods obtained by dividing a drilling time and electric power value of each time period or the like.

It is also possible to properly set a duty ratio, an electric power supply frequency, and an electric power value depending on each time period by combing some or all of them. By doing this, an electric power supply aspect according to sample characteristics can be allocated more significantly, and stable drilling can be carried out while sample melting and breakage or the like are reliably prevented.

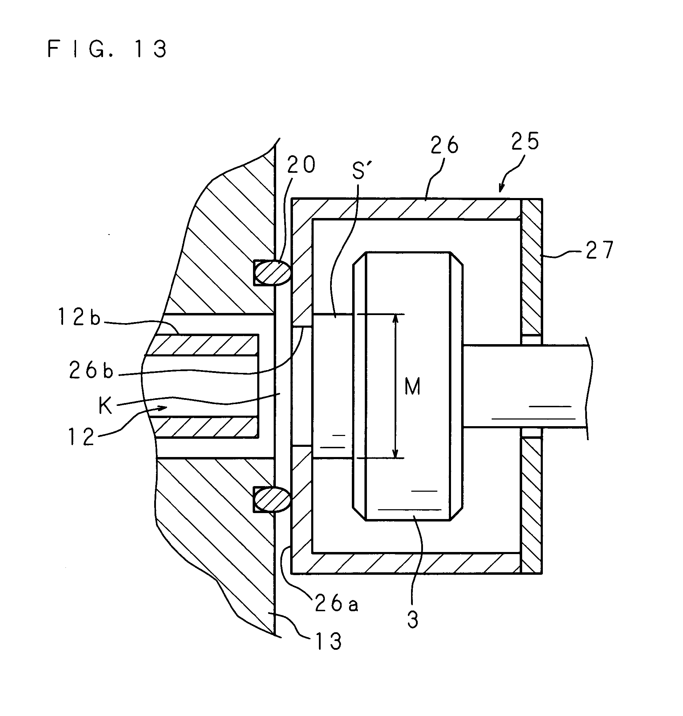

In addition, when sample dimensions targeted for drilling are small, it is suitable to apply a sample holding device 25, as shown in FIG. 13. A sample S' shown in FIG. 13 is smaller than diameter dimensions of the third O-ring 20 in dimensions M shown in FIG. 13, and cannot be directly abutted against the third O-ring 20. Thus, a space K is formed by using a box shaped sample holding device 25. The sample holding device 25 is composed of an opened box portion 26 and a capping portion 27 for covering an opening of the box portion 26. A hole portion 26b whose diameter is slightly greater than an outer diameter of a cylinder portion 12b of an electrode 12 is formed at a center site of a bottom plate portion 26a of the box portion 26.

The small sample S' is disposed so as to seal the hole portion 26b inside of the box portion 26 and pressurized against the electrode 12 together with the bottom plate portion 26a by means of the oscillator 3. As a result, an outer face of the bottom plate portion 26a abuts against the third O-ring 20, and the space K is formed so as to be sealed by the sample S' that seals the third O-ring 20, the bottom plate section 26a, and the hole portion 26b, making it possible to drill the sample S' in the same manner as that described above.

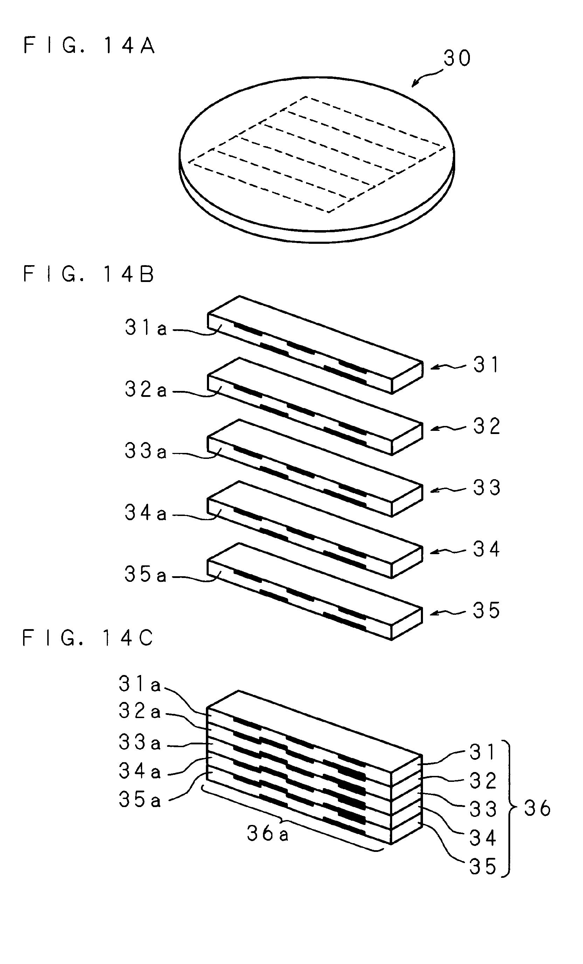

Further, in the case where the thickness of a sample is small, it becomes possible to set a plurality of samples at a glow discharge tube 2 by bonding them with each other. For example, in the case where a cross section of a disk shaped silicon wafer 30 having small thickness as shown in FIG. 14A is observed by means of a scanning electron microscope, first, the silicon wafer 30 is cut into a plurality of short strips (indicated by the dashed line in FIG. 14A). Next, as shown in FIGS. 14B and 14C, short strips 31 to 35 are laminated on each other, and are bonded with each other by adhesive, thereby forming a sample 36 having settable dimensions.

A surface 36a targeted for drilling, of a sample 36, is featured in that side faces 31a to 35a targeted for observation, of short strips 31 to 35, are combined with each other. A plurality of the side faces 31a to 35a are drilled at the same time by drilling the surface 36a, making it possible to form a plurality of observation sites. Thus, a probability of enabling good observation is improved. In order to drill a sample having small thickness, apart from the above bonding, it is thought to provide a thin sample molded of a resin or the like and to increase a size settable to the glow discharge tube 2.

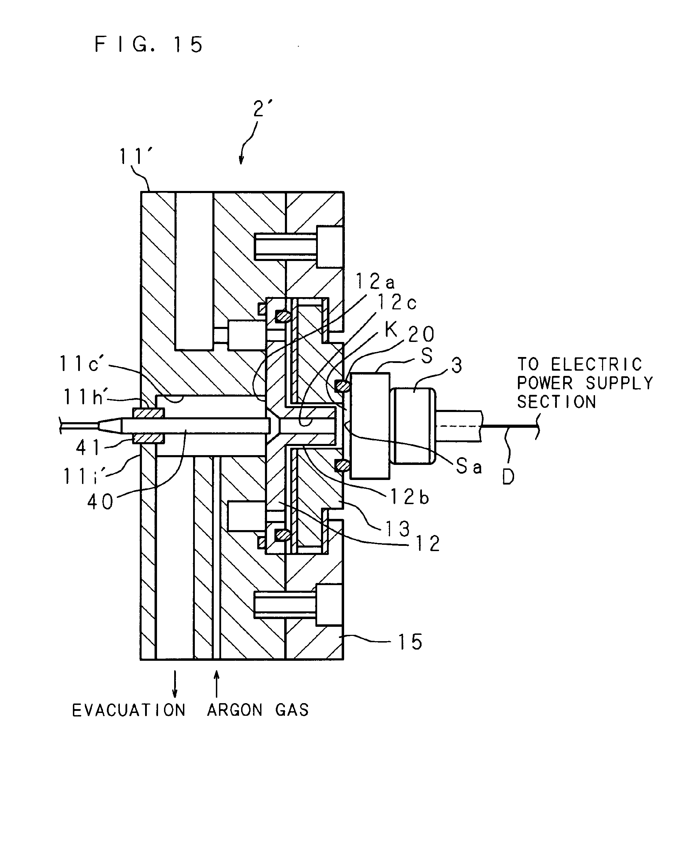

FIG. 15 shows a glow discharge tube 2' according to a modified example, This glow discharge tube 2' is featured in that a scope 40 is disposed for observing a drilling situation inside of a cavity 11c' of a lamp body 11'. In order to dispose the scope 40, the lamp body 11' provides a hole portion 11h' that communicates with the cavity 11c' at an outer end face 11i', and the rod shaped scope 40 is inserted via a sealing member 41 and disposed in the cavity 11c'. The scope 40 is configured so that it can observe a target on a distal extension line. Thus, a situation in which the sample surface Sa is drilled can be observed from the outside through the through hole 12c of the electrode 12, and a drilling processing operation can be carried out while checking the situation.

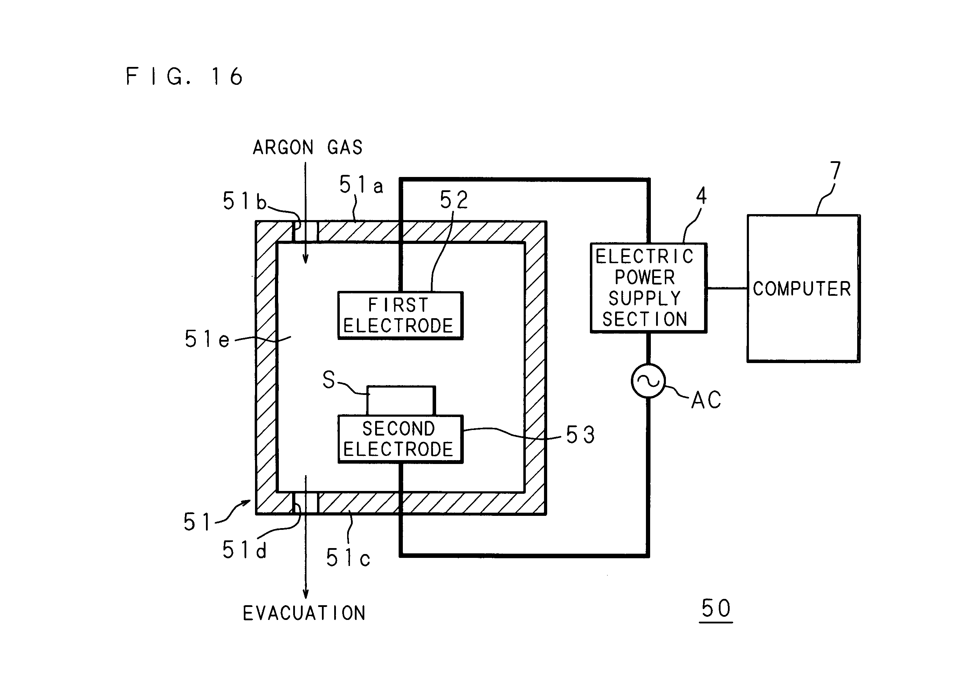

FIG. 16 shows a glow discharge drilling apparatus 50 according to a modified example. Unlike the glow discharge drilling apparatus 1 shown in FIG. 1, this drilling apparatus 50 provides a first electrode 52 and a second electrode 53 on which a sample S is disposed inside of a sealed drilling processing chamber 51 instead of setting the sample S by using the glow discharge tube 2 and the oscillator 3. The first electrode 52 is connected to an electric power supply section 4 having a configuration similar to that shown in FIG. 1 and the second electrode 53 is connected to a grounding side of an alternating current electric power supply AC. The electric power supply section 4 is controlled by means of a computer 7 in the same manner as that shown in FIG. 1.

The drilling processing chamber 51 opens a gas supply hole 51b for supplying an argon gas at a top plate portion 51a, and opens an evacuating hole 51d at a bottom plate portion 51c. In a state in which an internal space 51e of the drilling processing chamber 51 is evacuated from the evacuating hole 51d, and then, argon gas (inert gas) is supplied from the gas supply hole 51b, high frequency electric power is generated by the electric power supply section 4; a voltage is applied between the first electrode 52 and the second electrode 53 (sample S); and the sample S is drilled by means of sputtering due to a glow discharge. Application of a variety of electric power supply aspects described above can be made for electric power supply. In the glow discharge drilling apparatus 50 according to this modified example, it is sufficient if a sample S targeted for drilling is disposed on the second electrode 53 of the drilling processing chamber 51. Thus, inconvenience required for setting the sample S is reduced. In addition, any type of sample S can be drilled as long as it can be placed on the second electrode 53. Therefore, there is an advantage that the degree of freedom in types of samples that can be drilled is great.

Now, a description will be given with respect to Examples (test results) of actually drilling a variety of samples by using a glow discharge drilling apparatus having a configuration similar to that of the above described glow discharge drilling apparatus 1 (apparatus utilizing only a portion associated with a drilling processing operation of JY-5000RF available from HORIBA,Ltd.).

In Example 1, drilling was carried out using a silicon substrate for a sample.

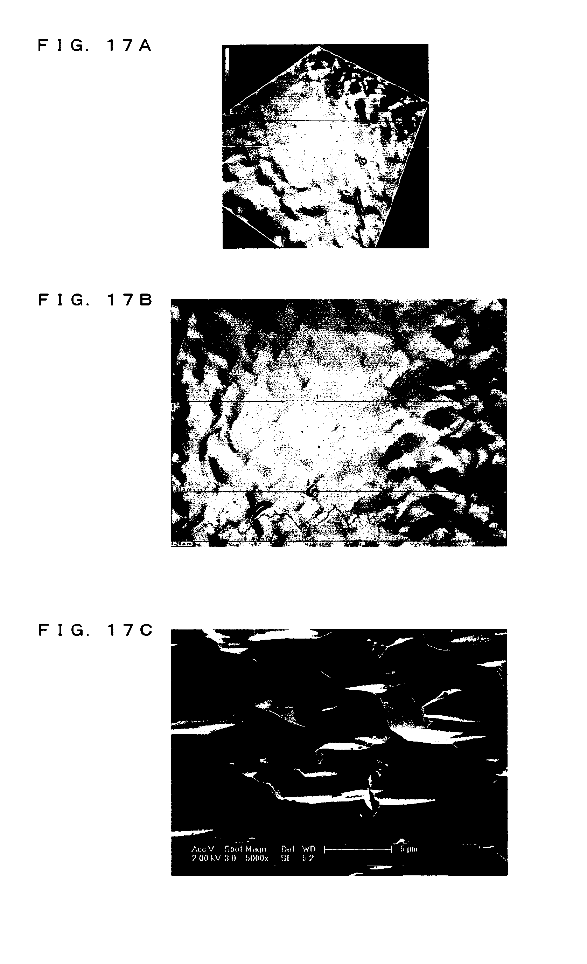

Micrograms of FIGS. 17A to 17C each show a silicon substrate before drilled. FIG. 17A is an image showing a whole silicon substrate, the image being taken by using a confocal laser microscope; FIG. 17B is an image showing an enlarged view of a substrate surface by the confocal laser microscope; and FIG. 17C is a further enlarged image by a scanning electron microscope. When irregularities of the silicon substrate surface before drilled were measured by means of a roughness gauge, a level difference of 0.84 µm was measured with respect to a horizontal distance of 281.43 µm at one site on the substrate surface, and a level difference of 0.70 µm was measured with respect to a horizontal distance 25.31 µm at another site.

After a mechanical mirror face polishing processing operation was carried out with respect to the above described silicon substrate, drilling was carried out by using the above described glow discharge drilling apparatus. A drilling condition was such that a mode relevant to an occurrence of a glow discharge is set to a continuous mode, and an electric power voltage supplied to a silicon substrate is set to 40W.

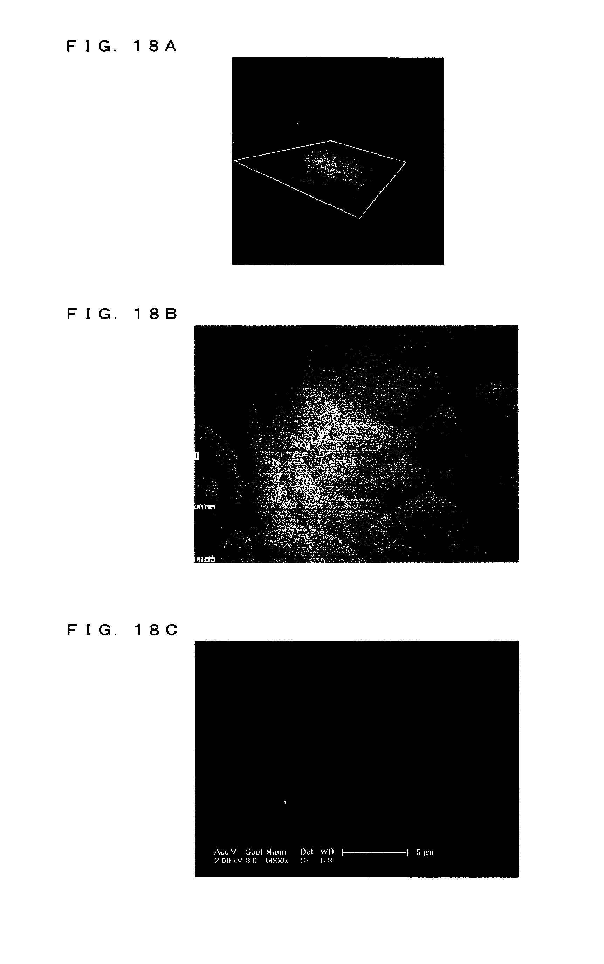

Micrograms of FIGS. 18A to 18C each show a silicon substrate after drilled. These images corresponding to those shown in FIGS. 17A to 17C, respectively, and are taken by using microscopes similar to those described above. In comparison with the micrograms shown in FIGS. 17A to 17C and 18A to 18C, it was successfully verified that the silicon substrate after drilled has uniform irregularities as compared with the surface before drilled.

In addition, with respect to a substrate surface after drilled, when measurements were carried out by a roughness gauge with respect to sites similar to those at which surface roughness before drilled was measured, a level difference of 0.46 µm was measured with respect to a horizontal distance of 281.43 µm at one site, and a level difference of 0.37 µm was measured with respect to a horizontal distance 62.17 µm at another site. Therefore, it was found that the level difference was substantially smoothened to be halved by means of drilling. A substantially operating time at which the glow discharge drilling apparatus carried out drilling was about 5 seconds. In this manner, a sample surface is drilled by using a glow discharge drilling apparatus according to the present invention, whereby a uniform and smooth surface can be formed in a nano-level scale within a very short time, and a good surface image and analysis information can be obtained by using an optical microscope, a scanning electron microscope, an electron-ray microscope analyzer, and a surface analyzing device or the like.

In Example 2, a thermally weak, easily melted plastic material was drilled.

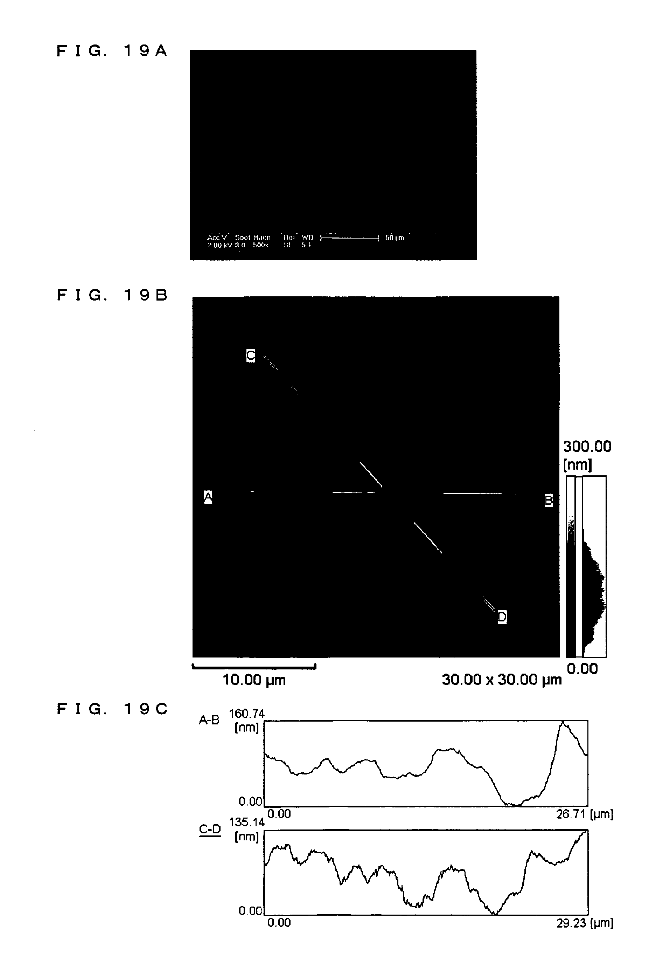

FIGS. 19A and 19B each show a surface of a plastic material before drilled. FIG. 19A is an image showing an enlarged view of a material surface by using a scanning electron microscope; and FIG. 19B is an image showing a further enlarged view of a material surface by using an atom force microscope. In addition, a graph of FIG. 19C shows a level difference measured by a roughness gauge with respect to a site connected by the line A-B and a site connected by the line C-D shown in FIG. 19B. A level difference of 160.74 nm was measured with respect to a horizontal distance of 26.71 µm at the site connected by the line A-B, and a level difference of 135.14 nm was measured with respect to a horizontal distance of 29.23 µm at the site connected by the line C-D.

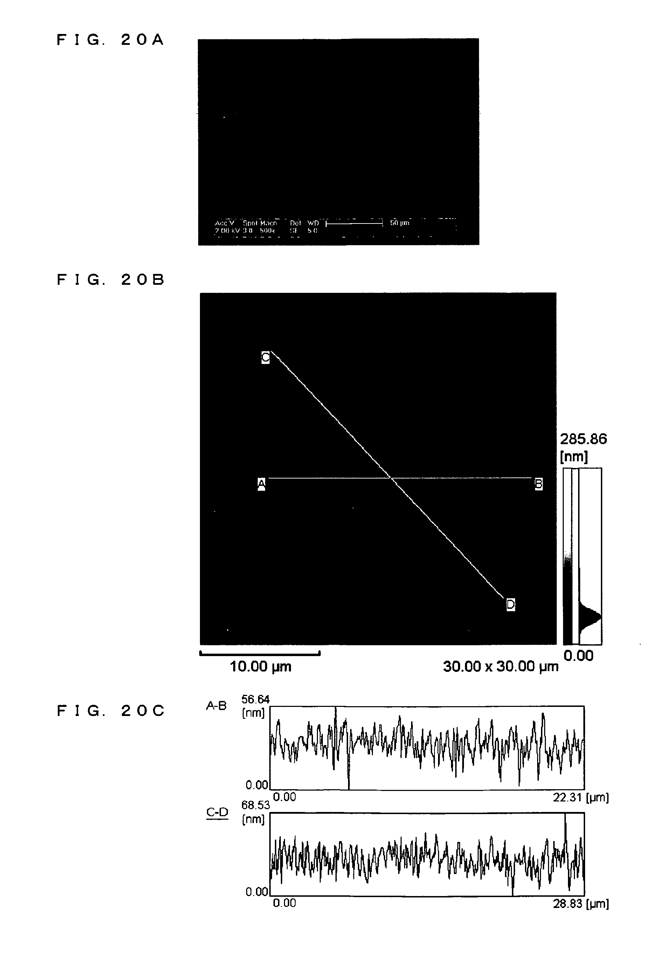

Micrograms of FIGS. 20A and 20B each show a material surface in the case where the above described plastic material was drilled in an intermittent mode. These images correspond to those shown in FIGS. 19A and 19B before drilled, and is taken by using microscopes similar to those described above. At the time of drilling in an intermittent mode, electric power supplied to the plastic material was set to 40W, a duty ratio was set to 0.0625, a frequency of intermittent electric power supply was set to 20000 Hz, and a total drilling time was set to 300 seconds.

A graph of FIG. 20C shows level differences measured by a roughness gauge with respect to site connected by the line A-B and site connected by the line C-D shown in FIG. 20B. A level difference of 56.64 nm was measured with respect to a horizontal distance of 22.31 µm at the site connected by the line A-B, and a level difference of 68.53 nm was measured with respect to a horizontal difference of 28.83 µm at the site connected by the line C-D. Therefore, after drilling, the level difference was reduced to be equal to or smaller than 1/2 as compared with that before drilled. In addition, from the graphs of FIGS. 19C and 20C, it was found that the surface drilled by the glow discharge is entirely smoothened.

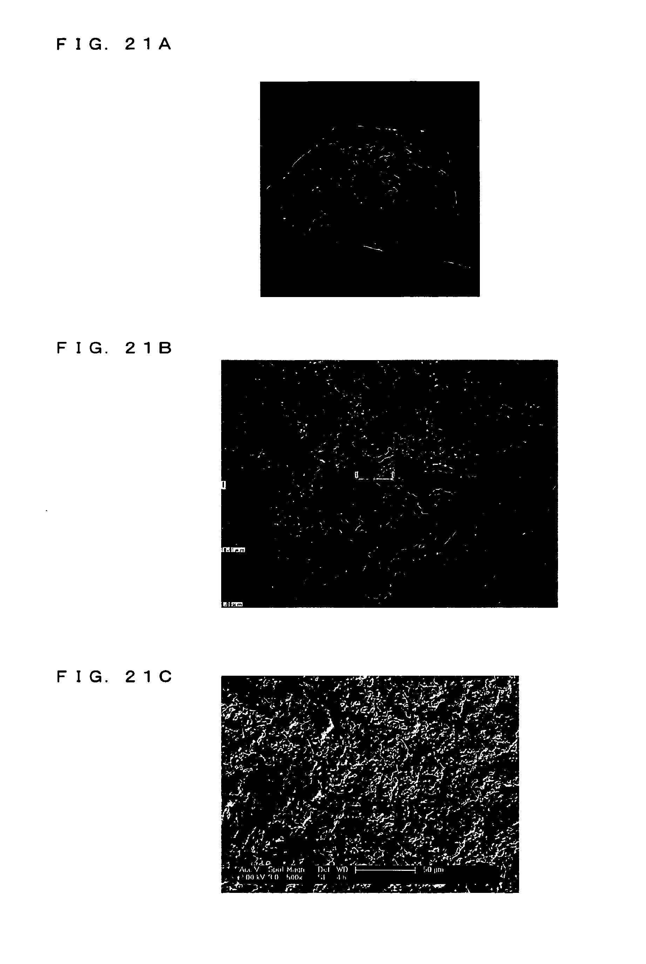

Micrograms of FIGS. 21A to 21C each show a material surface in the case where the above described plastic material is drilled in a continuous mode. FIG. 21A is an image showing a whole plastic material, the image being taken by using the confocal laser microscope; FIG. 21B is an image showing an enlarged view of a material surface by using the confocal laser microscope; and FIG. 21C is an image showing a further enlarged view by using a scanning electron microscope. In addition, when a surface of the plastic material drilled in a continuous mode was measured by a roughness gauge, a level difference of 3.86 µm was entirely measured with respect to a horizontal distance of 281.43 µm; a level difference of 4.24 µm was measured with respect to a horizontal distance of 30.81 µm at a partial site; and a level difference was increased as compared with that in an intermittent mode. Therefore, it was found that surfaces of a thermally weak sample and a sample easily broken by a sputtering force (such as a composite material including an organic substance or the like, for example) can be smoothly drilled by switching the continuous mode to the intermittent mode in the glow discharge drilling apparatus according to the present invention.

For the purpose of comparative verification, drilling tests in a continuous mode were carried out with respect to a variety of samples by using the above described glow discharge drilling apparatus. Now, the test results in the continuous mode are shown below.

It was verified whether or not layers can be released from a top layer on a one by one layer basis, due to changes of an electric power supply condition and a drilling time when structural analysis is carried out from a surface of a sample that forms a layered structure in a depth direction. By using a semiconductor having a layered structure as a sample, a degree of pattern recognition relevant to a depth direction of layers exposed on a cross section of the semiconductor was comparatively verified.

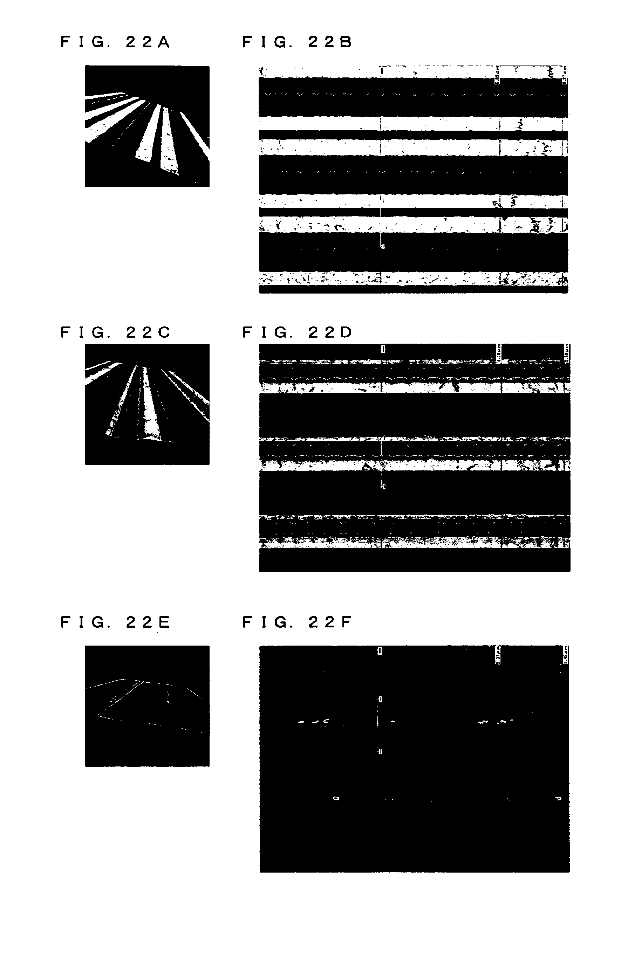

Microscopes of FIGS. 22A and 22B each show a semiconductor cross section before drilled. FIG. 22A is an image when a layered structure is seen in a sectional direction by using the confocal laser microscope, and FIG. 22B is an image when a layered structure is seen from a surface by using the confocal laser microscope. When surface irregularities of FIG. 22B were measured by a roughness gauge, a level difference of 1.01 µm was entirely measured with respect to a horizontal distance of 70.74 µm on a surface, and a level difference of 1.00 µm was measured with respect to a horizontal distance of 14.92 µm at a partial site.

Micrograms of FIGS. 22C and 22D each show a semiconductor cross section drilled in accordance with a continuous mode. These images correspond to those shown in FIGS. 22A and 22B, respectively, and is taken by using microscopes similar to those described above. In the images of FIGS. 22C and 22D, layers are drilled in a preferential manner from a top layer of a semiconductor surface, as compared with those of FIGS. 22A and 22B, and an underlying structure can be seen. An electric power supply condition for obtaining the microscopes of FIGS. 22C and 22D was such that electric power supplied to a semiconductor sample is set to 40W, and a total drilling time is set to 30 seconds. In addition, when surface irregularities of FIG. 22D was measured by a roughness gauge, a level difference of 0.88 µm was entirely measured with respect to a horizontal distance of 70.74 µm on a surface, and a level difference of 0.76 µm was measured with respect to a horizontal distance of 15.12 µm at a partial site.

Further, microscopes of FIGS. 22E and 22F each show a semiconductor cross section drilled in a continuous mode while an electric power supply condition and a drilling time are changed from the cases of FIGS. 22C and 22D. These images correspond to those shown in FIGS. 22A and 22B, respectively, and are taken by using microscopes similar to those described above. In the images of FIGS. 22E and 22F, a structure of a semiconductor surface is remarkably drilled as compared with those shown in FIGS. 22C and 22D, and a structure proximal to the substrate can be seen. In the glow discharge drilling apparatus according to the present invention, capable of changing an electric power supply condition and a drilling time, the electric power supply condition and the drilling time is changed, whereby a surface aspect to be drilled is different from another one, and structural analysis can be carried out by setting proper electric power supply condition and drilling time. An electric power supply condition for obtaining the images of FIGS. 22E and 22F was such that electric power supply to a semiconductor sample is set to 40W, and a total drilling time is set to 60 seconds. In addition, when surface irregularities of FIG. 22F was measured by a roughness gauge, a level difference of 0.44 µm was entirely measured with respect to a horizontal distance of 70.74 µm on a surface, and a level difference of 0.35 µm was measured with respect to a horizontal distance of 16.42 µm at a partial site.

In addition, in another test using a continuous mode, drilling was carried out in a continuous mode by means of a glow discharge drilling apparatus with respect to a sample (silicon wafer) produced in accordance with the contents of the testing shown in FIGS. 14A to 14C.

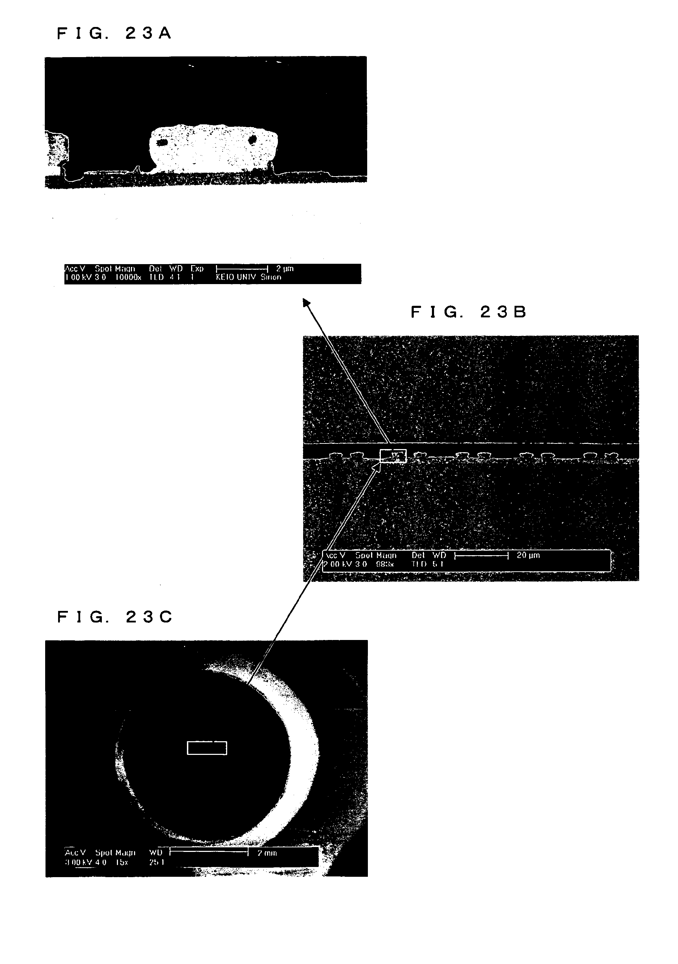

As shown in FIGS.14A to 14C, three micrograms of FIGS. 23A to 23C each are an image of a microgram of a drilled surface when parts of one silicon wafer were cut out in plurality, and were laminated. The microgram of FIG. 23C shows a state in which a silicon wafer having a pattern provided thereon is laminated in plurality. In the microgram of FIG. 23C, a central black circular range indicates a drilled portion.

A photogram of FIG. 23B is an enlarged image when a portion enclosed by a white frame of FIG. 23C is photographed by means of an electron microscope. It was successfully verified that a number of gates exist in a pattern provided on a silicon wafer. Further, a photogram of FIG.23A is an enlarged image when a portion enclosed by a white frame of FIG.23B is photographed by means of the electron microscope. It was verified that clear gate exist. In this manner, condition evaluation of a gate structure was carried out by cutting out, laminating, and drilling parts of a sample (silicon wafer). A drilling electric power supply condition for obtaining three micrograms of FIGS. 23A to 23C was such that electric power supplied to a silicon wafer is set to 40W, and a total drilling time is set to 5 seconds.

Further, in another test using a continuous mode, texture observation generally carried out by a wet system with respect to a metal material was carried out under a dry process by means of continuous mode drilling.

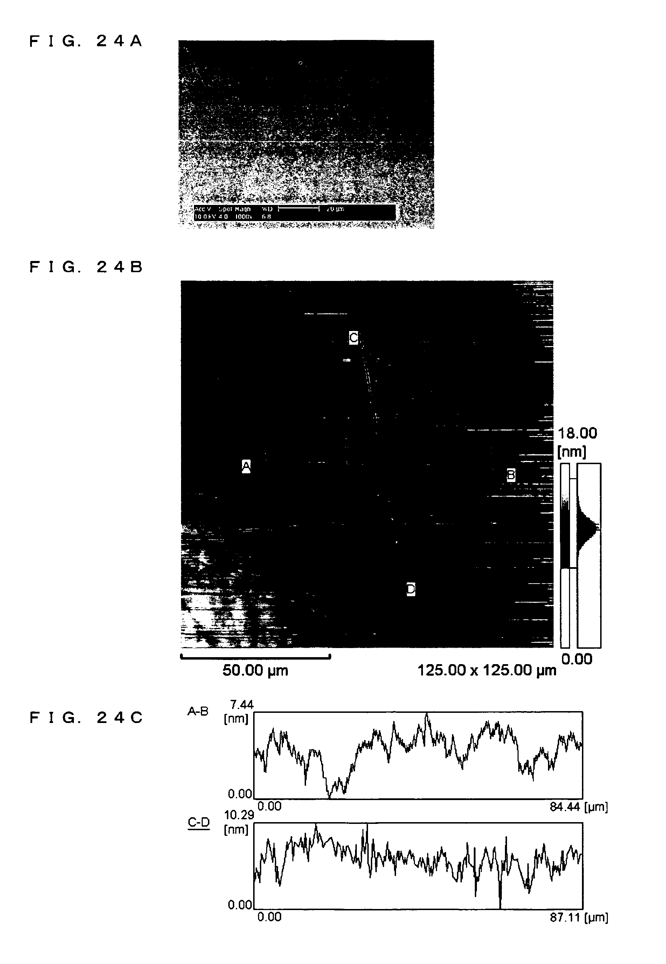

Micrograms of FIGS. 24A and 24B each show a surface of a metal material (stainless steel) before drilled. FIG. 24A is an image showing an enlarged view of a material surface by means of a scanning electron microscope and FIG. 24B is an image showing a further enlarged image by means of an atom force microscope. In addition, a graph of FIG. 24C shows a level difference measured by a roughness gauge with respect to site connected by the line A-B and site connected by the line C-D shown in FIG. 24B. A level difference of 7.44 nm was measured with respect to a horizontal distance of 84.44 µm at the site connected by the line A-B, and a level difference of 10.29 nm was measured with respect to a horizontal distance of 87.11 µm at the site connected by the line C-D.

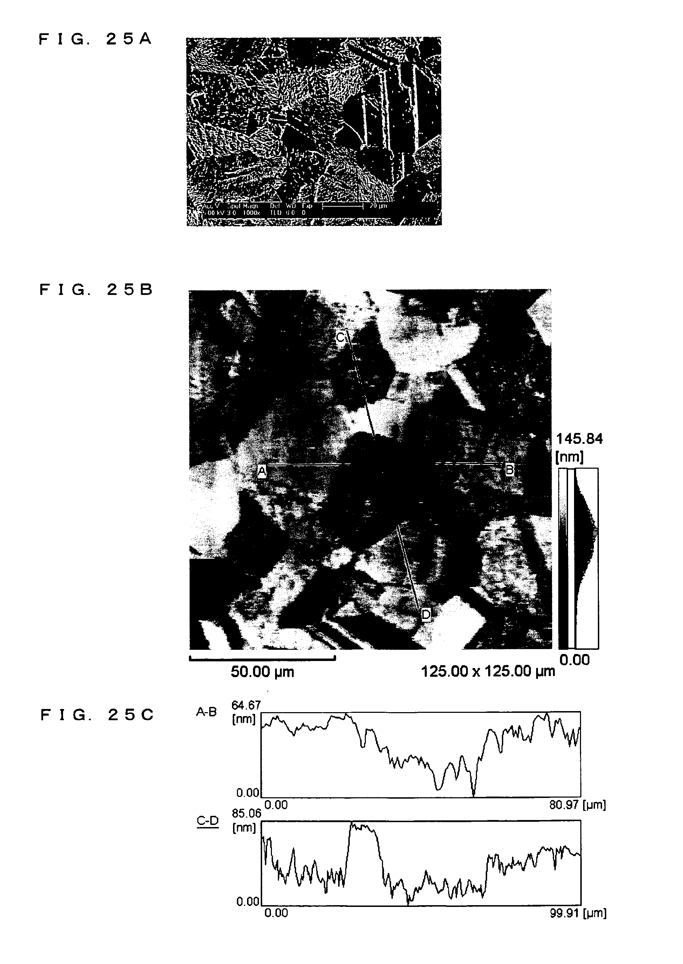

Micrograms of FIGS. 25A and 25B each show a surface when the above described metal material (stainless steel) was drilled in a continuous mode. These images correspond to those shown in FIGS. 24A and 24B before drilled, and are taken by using microscopes similar to those described above. At the time of drilling in a continuous mode, electric power supplied to the metal material was set to 40W, and a total drilling time was set to 10 seconds.

In addition, a graph of FIG. 25C shows a level difference measured by a roughness gauge with respect to site connected by the line A-B and site connected by the line C-D shown in FIG. 25B. A level difference of 64.67 nm was measured with respect to a horizontal distance of 80.97 µm at the site connected by the line A-B, and a level difference of 85.06 nm was measured with respect to a horizontal distance of 99.91 µm at site connected by the line C-D. From this fact, even in the case drilling was carried out in a continuous mode with respect to texture observation of a metal material having a crystalline structure, there was attained an etching effect depending on a crystalline orientation on a sample surface, and a level difference depending on a crystal was successfully verified. Therefore, in the case where a sample is a single crystal, a smooth plane can be obtained by carrying out drilling using the glow discharge drilling apparatus according to the present invention. In the case where a sample is a poly-crystal, there can be attained an anisotropic etching effect depending on a sample crystal orientation, etching is carried out in an orientation depending on a planer direction for each crystal, and a texture observation face can be formed.

### Second embodiment

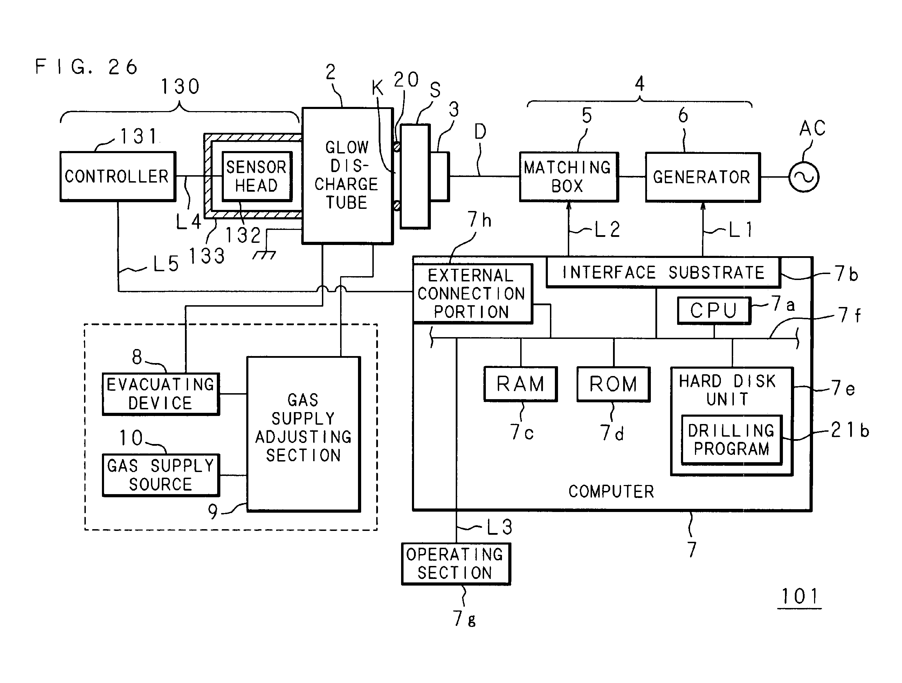

FIG. 26 shows a whole configuration of a glow discharge drilling apparatus 101 according to a second embodiment of the present invention. The glow discharge drilling apparatus 101 comprises: a glow discharge tube 2 for generating a glow discharge in order to drill a sample S; an electric power supply section 4 for generating electric power according to voltage application; a length measuring device 130 (measuring means, measuring section) having a controller 131, and a sensor head 132, the length measuring device measuring a drilled depth; and a computer 7 for making whole control of the apparatus, wherein, a dripping process is automatically stopped by drilling the sample S up to a predetermined depth. In the following description, like constituent elements according to the first embodiment are designated by like reference numerals according to the first embodiment. A duplicate description is omitted here.

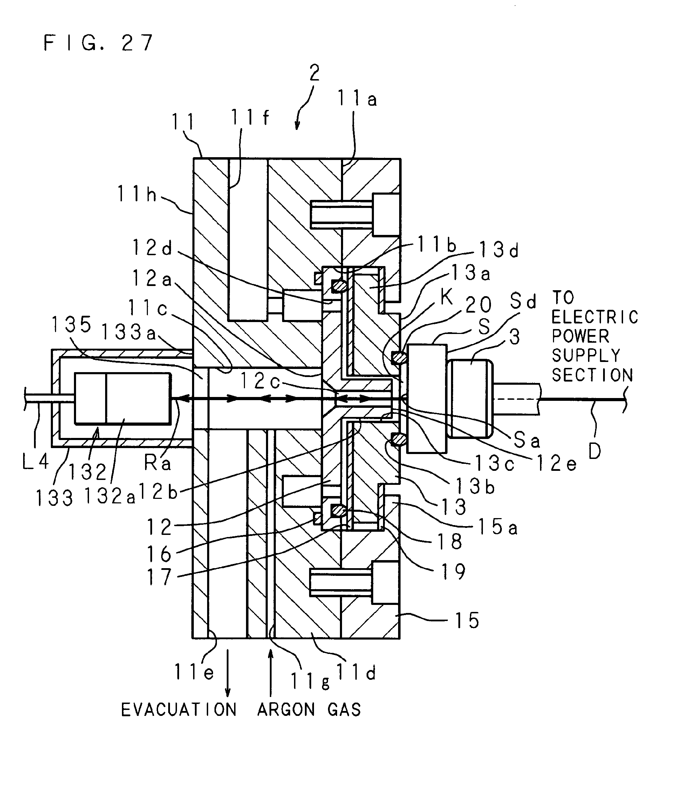

FIG. 27 shows a configuration relevant to a glow discharge tube 2 and the sensor head 132 of the length measuring device 130, wherein the glow discharge tube 2 is configured by combining a short cylinder shaped lamp body 11, an electrode 12, a ceramics member 13, and a pressurizing block 15 with each other.

The lamp body 11 corresponds to a holding member for holding the electrode 12. In addition, the lamp body 11 seals a cavity 11c by mounting a glass member 135 (corresponding light transmitting member) at a site that corresponds to a cavity 11c of an end face 11h opposite to a sample S to be held.

The electrode 12 held on the lamp body 11 is formed in a shape such that a cylinder potion 12b protrudes from a center of a disk portion 12a, and punches a through hole 12c (corresponding to penetrating portion) that penetrates the cylinder section 12b and the disk portion 12a. A hole 12d caused to communicate with an evacuating suction hole 11f is formed at the disk portion 12a. In addition, the electrode 12 serves as an earth electric potential when it is mounted on a cavity portion 11b of the lamp body 11, and the through hole 12c communicates with a cavity 11c of the lamp body 11, and is opposed to a glass member 135.

In addition, the sensor head 132 of the length measuring device 130 is disposed in parallel to one end face 11h of the lamp body 11 of the glow discharge tube 2. The sensor head 132 has an irradiation and light receiving section 132 for carrying out irradiation of a laser light beam Ra and light receiving of a reflected laser light beam Ra (reflection light beam) at its end, and the irradiation and light emitting section 132a is opposed to the glass member 135 of the lamp body 11. As a result, the laser light beam Ra irradiated from the irradiation and light receiving section 132a of the sensor head 132 passes through the glass member 135, cavity 11c, and through hole 12c, and reaches a sample surface Sa of the sample S. In addition, the resulting laser light beam Ra is reflected on the sample surface Sa, passes through the through hole 12c, cavity 11c, and glass member 135, and returns to the irradiation and light receiving section 132a.

Further, a cup-shaped light shielding member 133 is mounted on an end face 11h of the lamp body 11 of the glow discharge tube. Specifically, the light shielding member 133 abuts a peripheral rim end 133a against the end face 11h of the lamp body 11 so as to cover the sensor head 132 and the glass member 135 therein. As a result, stabilized measurement is promoted while ambient blight light is prevented from entering the irradiation and light receiving section 132a of the sensor head 132. In addition, the light shielding member 133 comprises a through hole for passing a connection line L4 that extend from the sensor head 132, leads out the connection line L4 outwardly. Then, the connection line L4 is connected to a controller 131 (refer to FIG. 26) of the length measuring device 130. The light shielding member 133 can be formed in a shape such that it fully covers the glow discharge tube 2. In addition, when a drilling processing itself is carried out in location in which ambient bright light can be eliminated such as a dark room, the light shielding member 133 may be eliminated.

The controller 131 of the length measuring device 130 carries out a processing operation for measuring a distance and a processing operation for outputting the measured distance through a measuring connection line L5 or the like based on irradiation control of the laser light beam Ra relevant to the sensor head 132 and light receiving of the laser light beam having returned after reflected on the sample S.

With respect to the irradiation control of the laser light beam Ra, the controller 131 determines a timing period for irradiation based on an irradiation instruction inputted through the measuring connection line L5, and carries out a control processing operation for irradiating the laser light beam from the irradiation and light receiving section 132a of the sensor head 132. In addition, with respect to distance measurement, the controller 131 carries out an irradiation and light receiving processing operation relevant to the laser light beam Ra at a preparatory stage of distance measurement and stores the relevant state (such as time from irradiation to light receiving). Next, this controller compares a state of irradiation and light receiving relevant to the laser light beam Ra to be carried out at the time of measurement with the stored state, calculates a distance, and specifies the calculated distance as a measurement value.

The length measuring device 130 carries out measurement by irradiation and light receiving of the laser light beam in the case where the controller 131 has accepted an instruction from the computer 7 through the measuring connection line L5. In more detail, when the controller 131 has accepted a preparation instruction from the computer 7, the length measuring device 130 carries out an irradiation and light receiving processing operation at the preparatory stage. When the controller 131 has accepted a measurement instruction from the computer 7, the length measuring device 130 carries out irradiation and light receiving; obtains a measurement value of a drilled depth through a distance calculating processing operation, and carries out a processing for outputting the thus obtained measurement value to the computer 7 through the measuring connection line L5. In addition, when the controller 131 accepts an instruction for terminating measurement from the computer 7, the length measuring device 130 terminates measurement. When the controller 131 accepts a temporary stop instruction from the computer 7, the length measuring device 130 temporarily stops measurement. The length measuring device 130 according to the second embodiment is used as a device whose type of laser light beam Ra to be irradiated is He-Ne, whish is 632.8 nm (nanometers) in wavelength of the laser light beam Ra, and which is about 0.08 µm in resolution.

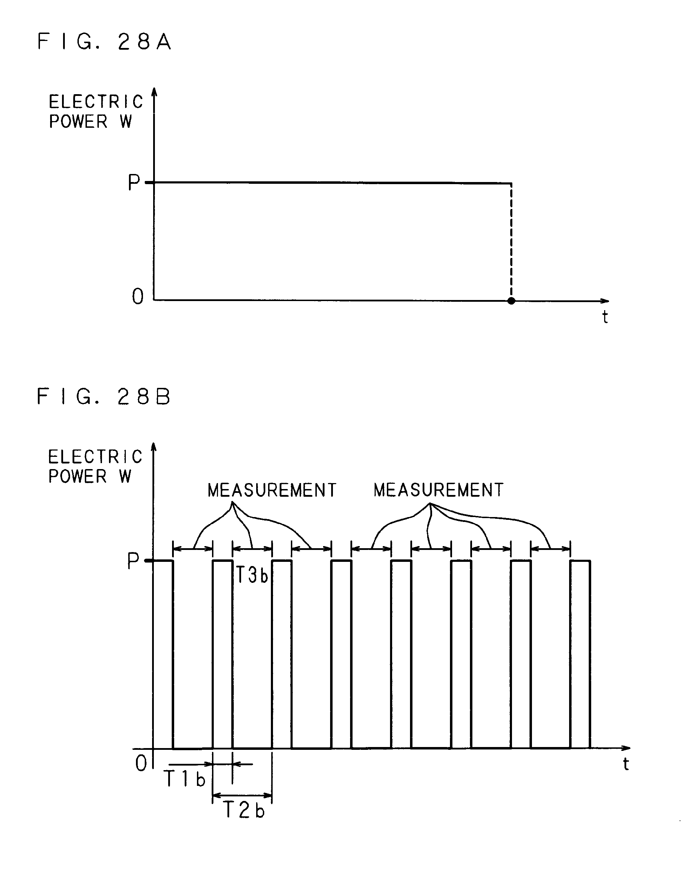

FIG. 28A is a graph depicting a first output mode using a control section 6b. In this mode, within a predetermined period of time, high frequency electric power (electric power value P) is continuously outputted, and a high frequency voltage is continuously applied to the sample S and the electrode 12 (hereinafter, referred to as a continuous mode). In addition, FIG. 28B is a graph depicting a second output mode using a control section 6b. In this mode, within a predetermined period of time, high frequency electric power (electric power value P) is outputted in a pulse-based manner (ON/OFF switching manner), and a high frequency voltage is intermittently applied to the sample S and the electrode 12 (hereinafter, referred to as an intermittent mode).

The control section 6b alternately carries out electric power supply and electric power supply intermission by carrying out a pulse-based processing operation by an internal IC serving as intermittent electric power supply means (means for intermittently applying a voltage) in an intermittent mode. By such a processing operation, high frequency electric power is outputted at an electric power supply time interval T1b that corresponds to a portion protruded in a rod shape shown in FIG. 28B. Then, output of high frequency electric power is intermitted at a time interval T3b at which the electric power supply time interval T1b is subtracted from a unit time T2b including one cycle of electric power supply and electric power supply intermission, respectively.

In response to a change of an electric power supply frequency, the control section 6b can adjust an electric power supply frequency in the range of about 30 Hz to about 3000 Hz. When the electric power supply frequency is changed, the time interval T3b changes in the graph shown in FIG. 28B. In addition, with respect to a change of a duty ratio, a rate (T1b/T2b) of one-shot electric power supply time interval T1b to a unit time T2b during intermittent electric power supply can be properly regulated.

In addition, the computer 7 shown in FIG. 26 provides an interface substrate 7b having connected thereto a first connection cable L1 that extends from a generator 6 and a second connection cable L2 that extends from a matching box 5. This interface substrate 7b is connected to an internal bus 7f having connected thereto a CPU 7a, a RAM 7c, a ROM 7d, a hard disk unit 7e, and an external connection portion 7h. An operating section 7g is also connected to the internal bus 7f via a connection line L3.

The external connection portion 7h is used for connection to an external device. In the second embodiment, the controller 131 of the length measuring device 130 is connected to the measuring connection line L5. In addition, the RAM 7c temporarily stores data or the like caused by a variety of control processing operations carried out by the CPU 7a. The ROM 7d stores in advance a program or the like defining basic contents of processing operations carried out by the CPU 7a. The hard disk unit 7e stores a drilling program 21b or the like defining the contents of controls associated with a drilling processing operation carried out by the CPU 7a.

The CPU 7a carries out a variety of processing operations based on the drilling program 21b stored in the hard disk unit 7e. This CPU carries out predetermined settings and controls based on an instruction for a user to have inputted to the operating section 7g by keyboard or mouse operation or the like, although not shown in FIG. 26.

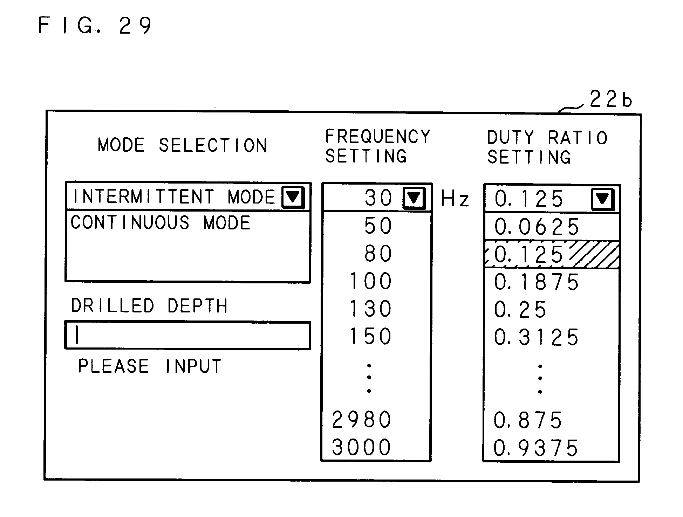

For example, when the drilling program 21b starts up, the CPU 7a causes an operator section 7g to displays a setting menu 22b shown in FIG. 29. In addition, in the case where an operation for an intermittent mode or a continuous mode has been accepted in accordance with the setting menu 22b from a user, the CPU 7a carries out a processing operation for actuating a circuit in the interface substrate 7b that corresponds to the accepted contents of settings.

In the case where the intermittent mode has been set on the setting menu 22b, the CPU 7a carries out a processing operation for accepting numeric value settings of a frequency (electric power supply frequency) and a duty ratio from a user; notifies the accepted contents to the interface substrate 7b; and causes the interface substrate 7b to transmit a predetermined signal to the generator 6. It is preferable to set the duty ratio to a numeric value lower than 0.5 in the case where the sample S targeted for drilling is easily melted and is easily broken in particular. In addition, the CPU 7a can set other parameters such as a peak of high frequency electric power on another menu except the above described setting menu 22b. Further, when an intermittent mode has been set, the CPU 7a makes control to output a notifying signal for notifying the setting of the intermittent mode from the interface substrate 7b to the matching box 5.

On the other hand, in the case where a continuous mode has been set on the setting menu 22b, the CPU 7a makes control to output a command signal from the interface substrate 7b to the generator 6 so as to supply electric power continuously

Further, in the case where either of the above described modes has been set, the setting menu 22b enables setting of a drilled depth with respect to the sample S. In the case where the operating section 7g has accepted input of a drilled depth from a user by keyboard or mouse operation, the CPU 7a stores the accepted numeric value in the RAM 7c. In addition, this CPU carries out a processing for sending a preparation instruction relevant to the sample surface Sa from the external connection portion 7h to the controller 131 of the length measuring device 130 before a drilling processing operation using a glow discharge.

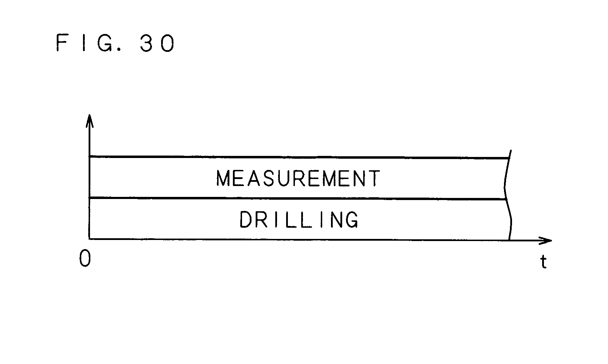

In addition, in the second embodiment, when a continuous mode has been set, the CPU 7a controls the length measuring device 130 so as to carry out drilling due to a glow discharge and measurement of a drilled depth by the length measuring device 130, as shown in FIG. 30. In this case, the CPU 7a makes control to output a measurement instruction to the controller 131 of the length measuring device 130 in accordance with a time period for instructing electric power supply start to the generator 6. In this case, the length measuring device 130 carries out measurement by irradiation and light receiving of laser light beams while light emission due to a glow discharge occurs. However, it is often that a wavelength of a light beam generated by a glow discharge and a wavelength of a laser light beam are greatly different from each other, and thus, there is a low possibility that measurement precision is affected.

On the other hand, when an intermittent mode has been set, as shown in FIG. 28B, the CPU 7a controls the length measuring device 130 so as to carry out measurement at a time interval T3b during electric power supply intermission when electric power is intermittently supplied (when high frequency voltage is stopped from being intermittently applied). In more detail, the CPU 7a outputs a measurement instruction from the external connection portion 7h to the controller 131 of the length measuring device 130 at the end time of the electric power supply time interval T1b so as to enable measurement of a drilled depth in synchronism with the time interval T3b during each electric power supply time interval T1b. In addition, the CPU 7a outputs a temporary stop instruction to the controller 131 at the time of ending the time interval T3b. In this manner, the CPU 7a outputs an instruction, whereby, when the length measuring device 130 carries out measurement (when the sensor head 132 receives the reflected laser light beam Ra), light emission due to a glow discharge does not occur. Thus, more stable high precision measurement can be carried out without being affected by light emission due to a glow discharge.

Further, when the sample S is drilled up to a drilled depth set on the setting menu 22b, a drilling process is automatically terminated. Thus, the computer 7 accepts a measurement value sent from the length measuring device 130 at the external connection portion 7h. The CPU 7a makes control to display the accepted measurement value at the operating section 7g any time. In addition, the CPU 7a compares the accepted measurement value with a drilled depth (stored value) stored in the RAM 7c and make determination. As a result of the comparison, when the measurement value does not reach the stored value, the CPU 7a carries out a control processing operation for continuing a drilling process. On the other hand, when it is determined that the measurement value has reached the stored value, the CPU 7a outputs an electric power supply stopping instruction to the generator 6, and terminates drilling. At this time, the CPU 7a outputs a measurement terminating instruction to the length measuring device 130.

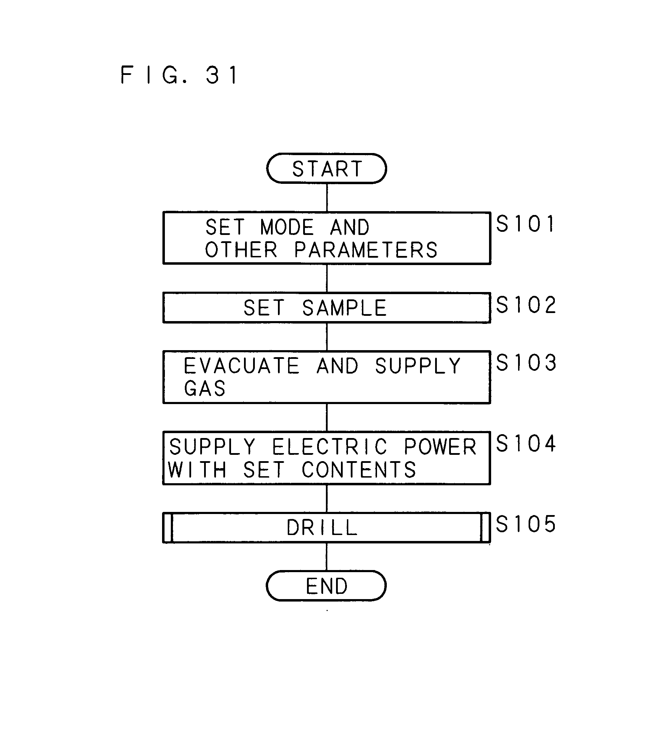

Now, with reference to a first flow chart shown in FIG. 31, a description will be given wit respect to whole operating procedures relevant to a glow discharge drilling method using the glow discharge drilling apparatus 101 configured as described above.

First, a variety of parameters such as a mode and a frequency, a duty ratio, and a drilled depth are set on a setting menu 22b or the like shown in FIG. 29 (S101), and then, a sample S is set at a glow discharge tube 2, as shown in FIG. 27 (S102).

Next, an inside of the glow discharge tube 2 is evacuated by means of an evacuation device 8, and inert gas (argon gas) is supplied into the glow discharge tube 2 from a gas supply source 10 (S103). Then, at a preparatory stage of a length measuring device 130, a process for carrying out irradiation of a laser light beam Ra to a sample surface Sa before drilled and light receiving of the reflected laser light beam Ra is carried out for the purpose of measurement of a reference state, and then, a voltage is applied by supplying electric power in accordance with the set contents (S104). The sample surface Sa exposed in a space K of the sample S is drilled (S105).

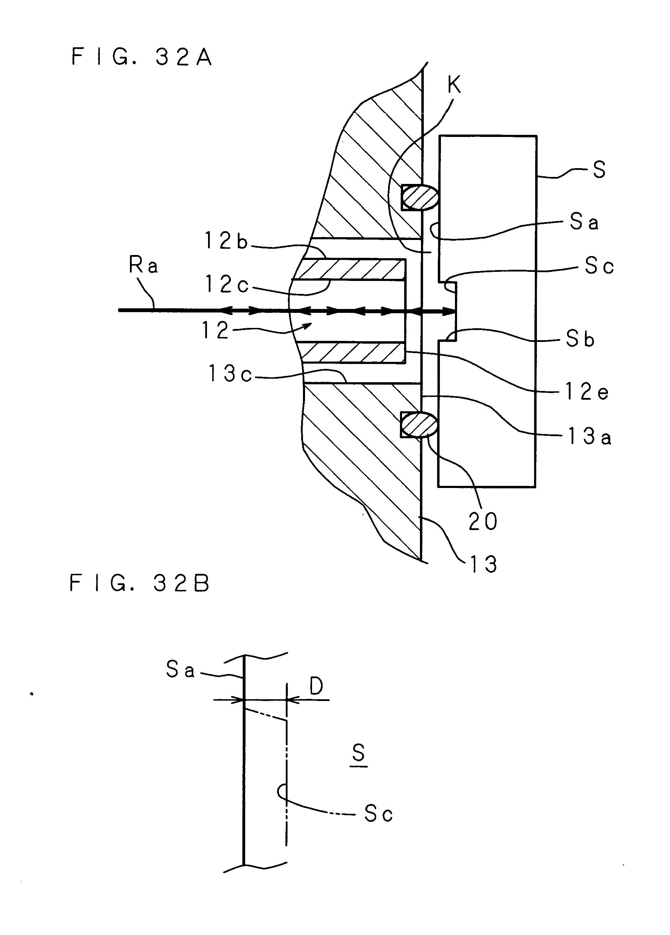

FIG. 32A shows a drilled state of a sample S. In a space K sealed by a third O-ring 20, in a state in which an argon gas is smoothly guided through a through hole 12c of an electrode 12, a voltage is applied between the electrode 12 and the sample S, and a glow discharge occurs. Then, argon ions contained in the argon gas burst toward a sample surface Sa, and collide with the surface, and sputtering occurs. The sample surface Sa is drilled due to collision of the argon ions due to this sputtering, and a recessed portion Sb occurs. In addition, the laser light beam Ra is irradiated on a bottom face Sc of the recessed portion Sb from the length measuring device 130, and the irradiated laser light beam Ra is reflected so that a distance D from the sample surface Sa to the bottom face Sc is measured as a drilled depth by means of the length measuring device 130 (refer to FIG. 32B).

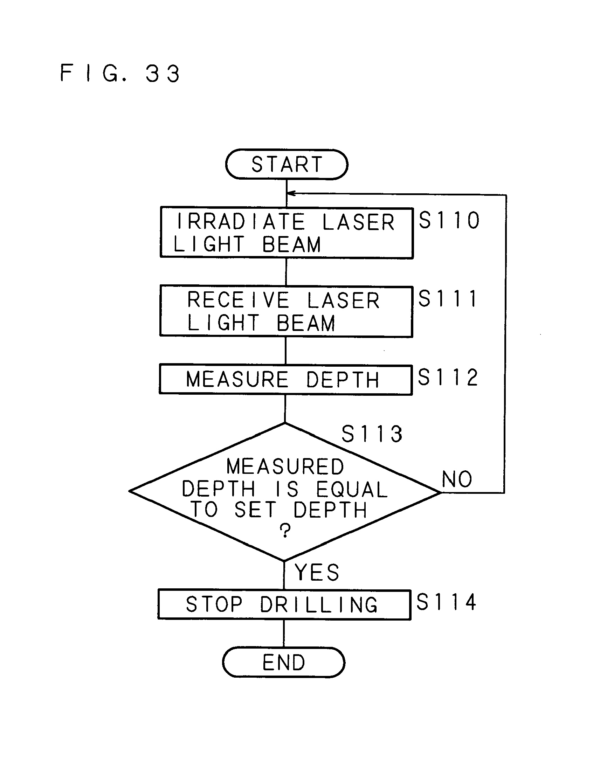

FIG. 33 is a second flow chart showing a control processing operation relevant to measurement of a drilled depth carried out together with drilling at a processing stage (S105) of drilling in the first flow chart of FIG. 31. This second flow chart shows basic contents relevant to a measuring processing operation. This flow chart also shows common processing operations in the case where measurement is intermittently carried out as shown in FIG. 28B and in the case where measurement is continuously carried out as shown in FIG. 30.

First, in the case of carrying out measurement, the glow discharge drilling apparatus 101 irradiates a laser light beam Ra from the sensor head 132 of the length measuring device 130 (S110) and receives the laser light beam Ra reflected on a bottom face Sc of a recessed portion Sb serving as a drilled portion of a sample S (S111); and then, the length measuring device 130 measures a drilled depth (S112). Next, the computer 7 compares whether or not the drilled depth measured by the length measuring device 130 is equal to the drilled depth set at the first stage (S101) of the first flow chart (S113) .

In the case where it has been determined that the drilled depth measured by the computer 7 is not equal to the set dripped depth (S113: NO), current processing reverts to the first irradiation stage (S110) in which the length measuring device 130 continues measurement. Alternatively, in the case where it has been determined that the drilled depth measured is equal to the set dripped depth (S113: YES), the glow discharge drilling apparatus 101 determines that the sample S has been drilled up to a desired depth, stops voltage application, stops drilling (S114), and terminates a whole processing operation.

In this way, the glow discharge drilling apparatus 101 according to the second embodiment directly measures a drilled site of the sample S by using the length measuring device 130 together with drilling, thus making it possible to obtain a drilled depth (length) during a drilling process precisely as compared with a conventional case. In addition, by setting a desired drilling depth, when a measurement value reaches the set drilled depth, a drilling process automatically terminates. Thus, the glow discharge drilling apparatus 101 according to the second embodiment remarkably reduced a user's operation burden as compared with a conventional apparatus and achieves a drilling processing with high precision without dependency on a processing person's skillfulness.

The glow discharge drilling apparatus according to the present invention is not limited to the above described second embodiment, and various modifications can be applied thereto. For example, a direct current voltage may be applied between an electrode 12 and a sample S by a glow discharge drilling apparatus 101. In this case, an electric power supply section 4 is changed to a configuration of generating and supplying direct current electric power. In addition, in the case of summarizing the specification relevant to the glow discharge drilling apparatus 101, a control of stopping voltage application and terminating drilling processing may be eliminated by comparing the set drilled depth and the measurement value. In this case, a user terminates a drilling process by means of manual operation while the user checking the measurement value displayed on the operating section 7g.

Further, the glow discharge drilling apparatus 101 does not always need to comprise both of the continuous mode and the intermittent mode in response to voltage application. Apparatus cost may be reduced by applying a voltage in either one of these modes.

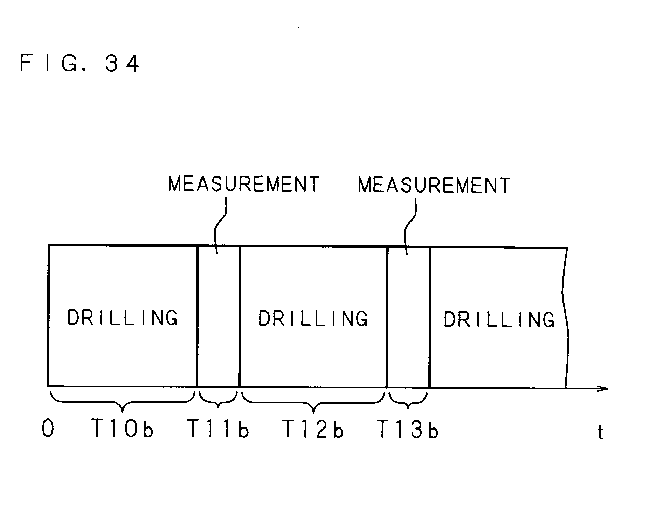

Furthermore, with respect to a time period of measurement in the continuous mode, apart from a case in which measurement is carried out any time together with drilling as shown in FIG. 30, drilling and measurement may be overlapped in time by carrying out measurement at a time interval (T11b, T13b) after drilling has been carried out at a predetermined time interval (T10b, T12b) as shown in FIG. 34. In this case, when the length measuring device 130 receives a laser light beam Ra for the purpose of measurement, voltage application is stopped, and sputtering light emission due to a glow discharge does not occur, and thus, the stability of measurement can be improved.

It is preferable to enable a time interval T10b, T12 or the like relevant to drilling to be set on a menu. In the case where detailed settings are provided, numeric values may be individually set every drilling time T10b or T12b. In this case, the computer 7 carried out control processing operation as follows. That is, the computer 7 clocks the set time interval T10b, T12b. When the clocking of the time interval T10b has terminated, an instruction for temporarily stopping voltage application is outputted to the generator 6. In addition, after a measurement instruction has been outputted to the length measuring device 130, when the measurement value is sent, an instruction for restarting voltage application to the generator 6 is outputted. In addition, a temporary stop instruction is outputted to the length measuring device 130, and then, the clocking of a next time interval T12b is started.

In addition, in the case of intermittent mode operation as well, a measuring processing operation may be carried out any time together with a drilling process, as shown in FIG. 30. By doing this, a drilled depth can be measured in real time together with the drilling process, and a timing of terminating the drilling process can be specified more precisely.

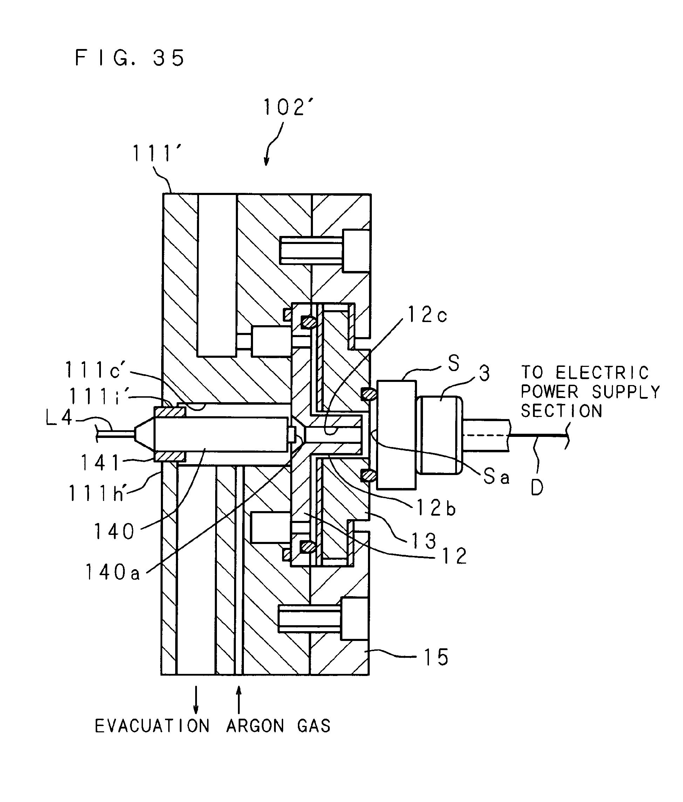

FIG. 35 shows a glow discharge tube 102' according to a modified example. This glow discharge tube 102' is featured in that a rod-shaped sensor head 140 is disposed in a cavity 111c' provided in a lamp body 111'. The sensor head 140 is downsized as compared with the sensor head 132 shown in FIG. 27, and has a sheath having anti-sputtering performance. In addition, the lamp body 111' for mounting the sensor head 140 comprises a communication hole 111i' that communicates with a cavity 111c' on an end face 111h' at the opposite side to a side at which a sample S is disposed. The sensor head 140 is inserted through this communication hole 111i' and a ring-shaped sealing member 141 is mounted between an inner rim of the communication hole 111i' and an outer face of the sensor head 140, thereby sealing the cavity 111c'.

A configuration of a glow discharge tube 102' according to the modified example is similar to that shown in FIG. 27 with respect to that other than the above described configuration. This glow discharge tube 102' has an electrode 12, a ceramics member 13, and a pressurizing block 15, and a sample is mounted while an oscillator 3 is pressed against the sample S. As described above, by mounting the sensor head 140, an end face 140a of the sensor head 140 is opposed to a sample surface Sa through a through hole 12c formed at a cylinder portion 12b of the electrode 12. Then, a laser light beam is irradiated from the end face 140a, whereby the laser light beam reflected on the sample surface Sa can be received on the end face 140a.

Such a glow discharge tube 102' according to the modified example mounts the sensor head 140 in the cavity 111c', thus making it possible to eliminate a light shielding member 133 mounted on the end face 11h of the glow discharge tube 2 shown in FIG. 27. In addition, a distance from a laser light beam irradiating section (laser light beam receiving section) of the sensor head 140 to the sample surface Sa is also reduced, thus making it possible to improve measurement precision.

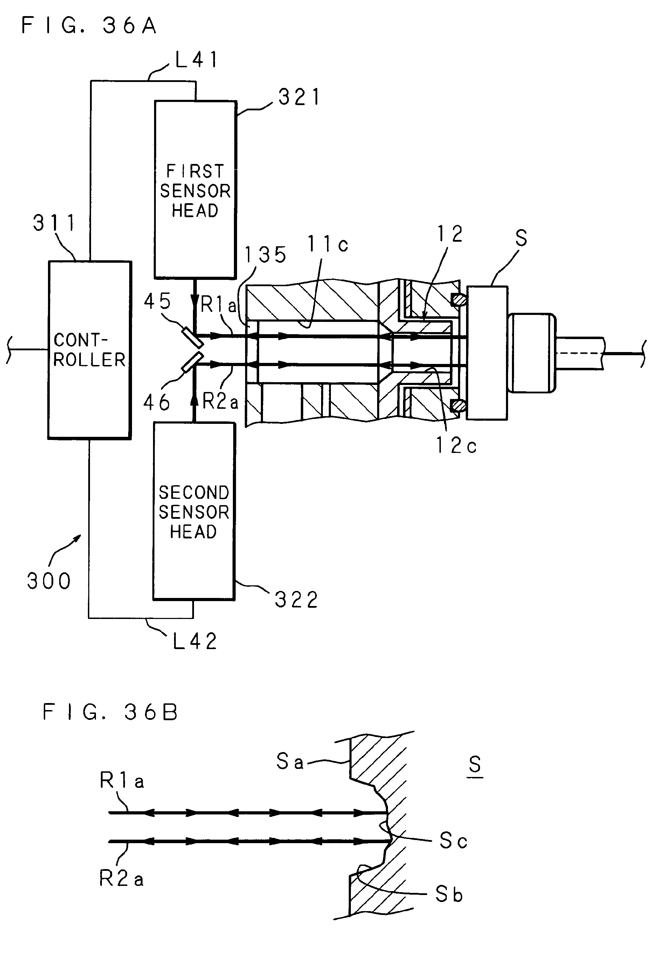

FIG. 36A shows a configuration of a length measuring device (measuring means) 300 relevant to a glow discharge tube 2 according to another modified example. This length measuring device 300 is featured by comprising a plurality of sensor heads (first sensor head 321 and second sensor head 322) (irradiation and light receiving section) and providing reflection members 45 and 46 so as to irradiate laser light beams R1a and R2a from the sensor heads 321 and 322 to the sample S. In more detail, the sensor heads 321 and 322 are disposed in orientation orthogonal to a center axis of a through hole 12c of an electrode 12 so as to enable laser light beam irradiation to the sample S and light receiving of the reflected laser light beam by changing the traveling directions of the laser light beams R1a and R2a by means of the reflection members 45 and 46. The reflection members 45 and 46 can be substituted by one prism. In addition, a configuration of the glow discharge tube 2 itself is similar to that shown in FIG. 27.

The sensor heads 321 and 322 are connected to a controller 311 (measurement control section) by means of connection lines L41 and L42. The controller 311 accepts laser light beam irradiations and light receiving results on the sensor heads 321 and 322, and specifies a drilled depth for each of the sensor heads 321 and 322. In addition, the controller 311 calculates an average value of the specified drilled depths, and carries out a process for outputting to the computer 7 the thus calculated average value as a drilled depth of the sample S. In this manner, the dripped depth is measured by using two laser light beams R1a and R2a, thereby making it possible to further improve measurement precision.

That is, as shown in FIG. 36B, when a recessed portion Sb serving as a drilled site of a sample S is microscopically seen, it is found that irregularities occur on a bottom face Sc of the recessed portion Sb in accordance with a situation in which sputtering occurs. As in the above described modified example, by obtaining an average value of the measurement values using the two laser light beams R1a and R2a, measurement with high precision can be achieved while an effect of the irregularities on the bottom face Sc is reduced to the minimum.

The number of sensor heads 321 and 322 is not limited to two, and a drilled depth may be measured by using two or more sensor heads. In addition, instead of commonly using one controller 311 by a plurality of sensor heads 321 and 322, one controller is associated with another one on a sensor head by sensor head basis, and controllers whose number is equal to that of sensor heads are provided, and each of the controllers measures only the drilled depth, and outputs the measured depth to a computer 7, whereby an average value of the drilled depths may be calculated by means of the computer 7. Further, a light shielding member is mounted so as to cover at least the sensor heads 321 and 322, reflection members 45 and 46, and a glass member 135 so that an effect of ambient blight light may be eliminated. Furthermore, if internal diameter dimensions of a cavity 11c of a lamp body 11 in the glow discharge tube 2 and a through hole 12c of an electrode 12 are sufficiently large, the sensor heads 321 and 322 may be disposed so as to directly irradiate laser light beams R1a and R2a to a sample S without using the reflection members 45 and 46.

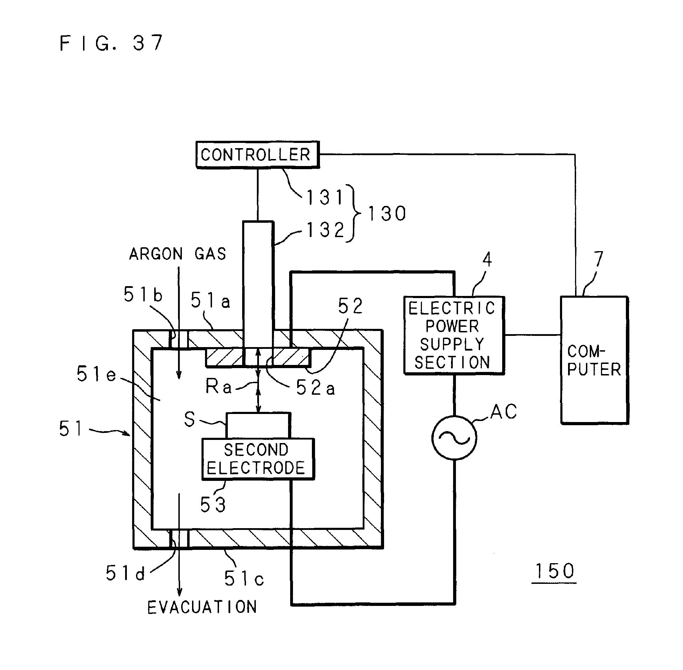

FIG. 37 shows a glow discharge drilling apparatus 150 according to a modified example in the case where a glow discharge tube is not used. A first electrode 52 and a second electrode 53 for disposing a sample S are provided in a sealed drilling processing chamber 51; the first electrode 52 is connected to an electric power supply section 4 having a configuration similar to that shown in FIG. 26; and the second electrode 53 is connected to a grounding side of an alternating current electric power supply AC. The electric power supply section 4 is controlled by means of a computer 7 in the same manner as that shown in FIG. 26.

The first electrode 52 is mounted on an interface side of a top plate portion 51a of the drilling processing chamber 51 in an insulated state, and a through hole 52a (corresponding to penetrating portion) is formed at a portion opposed to a sample S placed on the second electrode 53. In addition, a sensor head 132 of a length measuring device 130 is mounted on the top plate portion 51a of the drilling processing chamber 51 so that a laser light beam Ra can irradiated to the sample S through the through hole 52a of the first electrode 52 and so that the laser light beam Ra reflected on the sample S can be received. The sensor head 132 is connected to a controller 131 and the controller 131 is connected to the computer 7. A configuration of the glow discharge drilling apparatus 150 according to the modified example is similar to that of the glow discharge drilling apparatus according to the modified example according to the first embodiment shown in FIG. 16 with respect to the configuration other than the above described configuration.

In addition, in the glow discharge drilling apparatus 150 according to a modified example shown in FIG. 37, it is possible to apply a variety of electric power supply aspects (continuous mode and intermittent mode) described above and a variety of measurement aspects (refer to FIGS. 28B, 30, and 34) according to each of these aspects.

In the glow discharge drilling apparatus 150 according to this modified example, it is sufficient if a sample S is set merely by disposing the sample S on the second electrode 53 of the drilling processing chamber 51. Thus, inconvenience required for setting the sample S is reduced. In addition, any type of sample S can be drilled as long as it can be placed on the second electrode 53. Therefore, there is an advantage that the degree of freedom in types of samples that can be drilled is great. In addition, the sensor head 132 is mounted on the top table portion 51a of the drilling processing chamber 51 so that the sensor head 132 is hardly affected by ambient bright light and the light shielding member 133 shown in FIG. 27 can be easily eliminated. With respect to the glow discharge drilling apparatus 150 according to the modified example as well, measurement may be carried out by using a plurality of sensor heads in the same manner as that shown in FIG. 36B. In particular, the glow discharge drilling apparatus 150 uses the drilling processing chamber 51, and thus, has large space. Therefore, there is also attained an advantage that a plurality of sensor heads can be easily disposed without providing the reflection members 45 and 46.

### Third embodiment

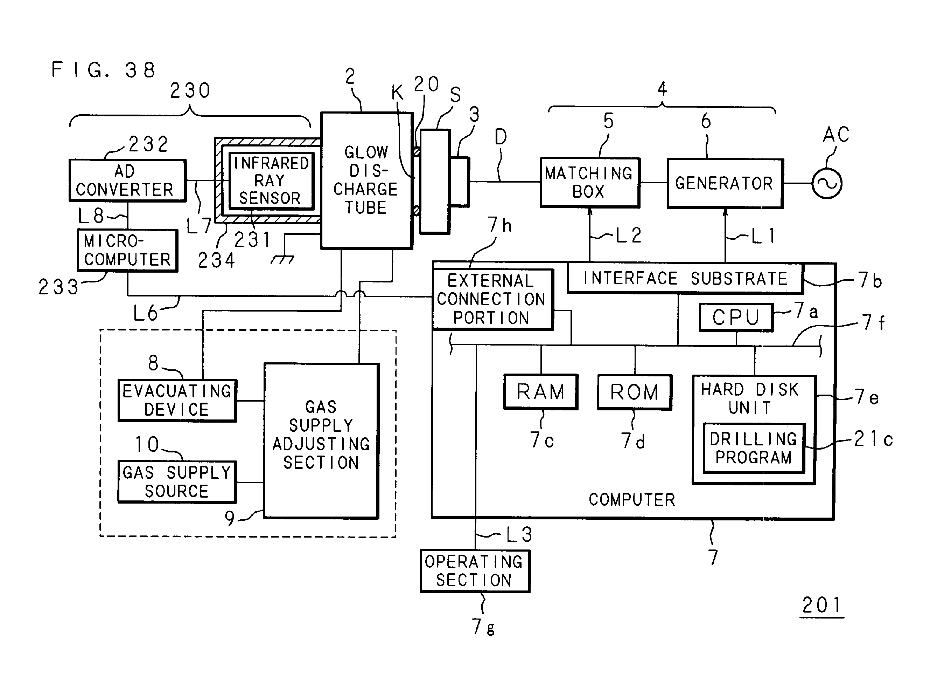

FIG. 38 shows a whole configuration of a glow discharge drilling apparatus 201 according to a third embodiment of the present invention. The glow discharge drilling apparatus 201 comprises: a glow discharge tube 2 for generating a glow discharge in order to drill a sample S; an electric power supply section 4 for generating electric power according to voltage application; a radiation temperature measuring device 230 for measuring a temperature of a drilled site based on an infrared ray radiated from the sample; and a computer 7 for making whole control of the apparatus. In addition, the radiation temperature measuring device 230 comprises an infrared ray sensor 231, an AD converter 232, and a microcomputer 233 (corresponding to temperature measuring means, temperature measuring section). The glow discharge drilling apparatus 201 according to the third embodiment is featured in that a temperature of a drilled site of a sample S drilled due to a glow discharge can be measured. In the following description, like constituent elements according to the first embodiment are designated by like reference numerals according to the first embodiment. A duplicate description is omitted here.

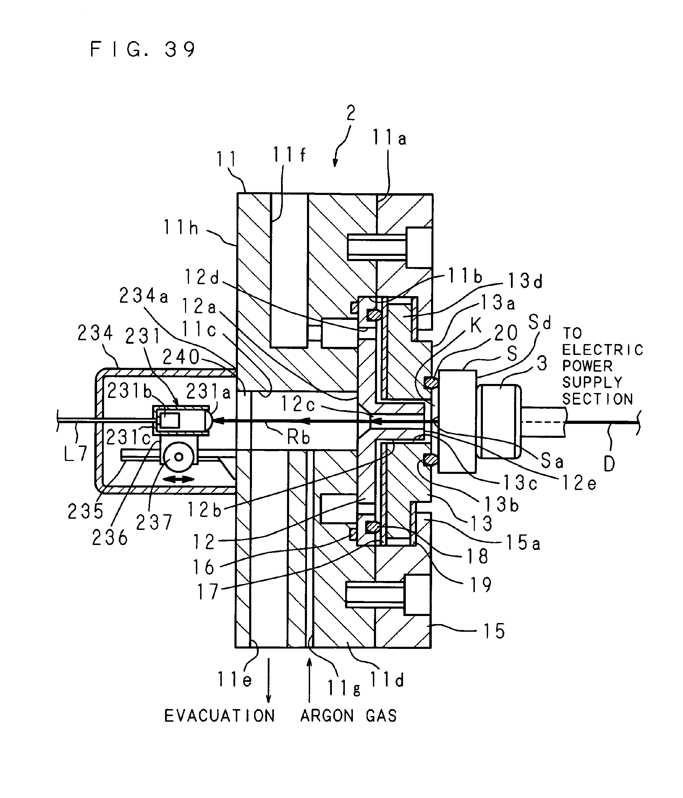

FIG. 39 shows a mount configuration of the glow discharge tube 2 and the infrared ray sensor 231 of the radiation temperature measuring device 230, wherein the glow discharge tube 2 is configured by combining a short cylinder shaped lamp body 11, an electrode 12 (corresponding to hollow electrode), a ceramics member 13, and a pressurizing block 15 with each other.

The lamp body 11 corresponds to a holding member for holding the electrode 12. In addition, the lamp body 11 seals a cavity 11c by mounting a glass member 240 (corresponding light transmitting member) at a site that corresponds to a cavity 11c of an end face 11h opposite to a sample S to be disposed.

The electrode 12 held on the lamp body 11 is formed in a shape such that a cylinder potion 12b protrudes from a center of a disk portion 12a, and punches a through hole 12c (corresponding to hollow portion) that penetrates the cylinder section 12b and the disk portion 12a. A hole 12d caused to communicate with an evacuating suction hole 11f of the lamp body 11 is formed at the disk portion 12a. In addition, the electrode 12 serves as an earth electric potential when it is mounted on a cavity portion 11b of the lamp body 11, and the through hole 12c communicates with a cavity 11c of the lamp body 11, and is opposed to a glass member 240.

In addition, an infrared ray sensor head 231 of the radiation temperature measuring device 230 is disposed on one end face 11h of the lamp body 11 of the glow discharge tube 2. The infrared ray sensor 231 has: an optical lens 231a serving as a light receiving section of an infrared ray Rb radiated from a sample S; a thermo-pile 231b for receiving the infrared ray Rb having passed through the optical lens 231a; and a housing 231c having housed therein the optical lens 231a and the thermo-pile 231b. As shown in FIG. 39, the optical lens 231a is opposed to the glass member 240, whereby the infrared ray sensor 231 receives the infrared ray Rb radiated from the sample S, the infrared ray Rb having passed through the through hole 12c of the electrode 12, cavity 11c, and glass member 240.

Further, on the end face 11h of the lamp body 11, a rail member 235 is protruded in parallel to the infrared ray Rb traveling from the sample S to the infrared ray sensor 231. This rail member 235 provides a slidable slide unit 236 (moving section). The housing 231c of the infrared ray sensor 231 is mounted on the slide unit 236. By sliding the slide unit 236 in a direction indicated by the arrow in FIG. 39, the infrared ray sensor 231 is movable so that the optical lens 231a of the infrared ray sensor 231 can be made close to or distant from a drilled site of the sample S. In addition, a fixing screw 237 is mounted on the slide unit 236. A position of the slide unit 236 can be fixed by tightening the fixing screw 237, and the slide unit 236 can be set at a slidable state by loosening the fixing screw 237.

The thermo-pile 231b of the infrared ray sensor 231 generates an analog signal according to energy of an incident infrared ray Rb and generates an analog signal according to a temperature of the thermo-pile 231b itself so as to output the generated signal to the AD converter 232 through a signal line L7.

Furthermore, a cup-shaped light shielding member 234 is mounted on the end face 11h of the lamp body 11. The light shielding member 234 mounts a peripheral rim end 234a on the end face 11h of the lamp body 11 in a state in which the light shielding member 234 covers the infrared ray sensor 231, the rail member 235, and the glass member 240. As a result, stabilized reception of the infrared ray Rb is promoted while ambient blight light is prevented from entering the optical lens 231a of the infrared ray sensor 231. The light shielding member 234 comprises a through hole for passing the signal line L7 that extends from the infrared ray sensor 231, and leads out the signal line L7 outwardly. Then, the signal line L7 is connected to the AD converter 232 of the radiation temperature measuring device 230 (refer to FIG. 38). The light shielding member 234 can be formed in a shape such that it fully covers the glow discharge tube 2. In addition, when a drilling processing itself is carried out in location in which ambient bright light can be eliminated such as a dark room, the light shielding member 234 may be eliminated.

The AD converter 232 of the radiation temperature measuring device 230 shown in FIG. 38 converts to a digital signal an analog signal outputted from the infrared ray sensor 231, and sends the converted digital signal to the microcomputer 233 through a signal line L8. The microcomputer 233 corresponds to the temperature measuring means, and carries out correction based on a reference temperature and a radiation rate with respect to the sent digital signal. Then, this microcomputer233 converts (computes) a temperature of a surface (site at which infrared ray Rb is radiated) of the sample S based on the infrared ray Rb received by the infrared ray sensor 231; and carries out a processing operation for outputting the converted temperature as a measured temperature to the computer 7 through the signal line L6.

The microcomputer 233 of the radiation temperature measuring device 230 carries out a computing processing operation of the measured temperature in the case where the microcomputer233 has accepted a start instruction for starting temperature measurement from the computer 7 through the signal line L6. When the instruction has been accepted, the microcomputer233 measures a temperature based on a digital signal sent from the AD converter 232. In addition, the microcomputer 233 stops a processing operation relevant to temperature measurement in the case where the microcomputer233 has accepted a stop instruction for stopping temperature measurement from the computer 7. In this way, the microcomputer 233 carries out temperature measurement under the control (instruction) of the computer 7, thereby making it possible to disable temperature measurement when sputtering occurs and to enable temperature measurement when no sputtering occurs. Therefore, reliability of a measured temperature value can be allocated while an influence of sputtering is avoided.

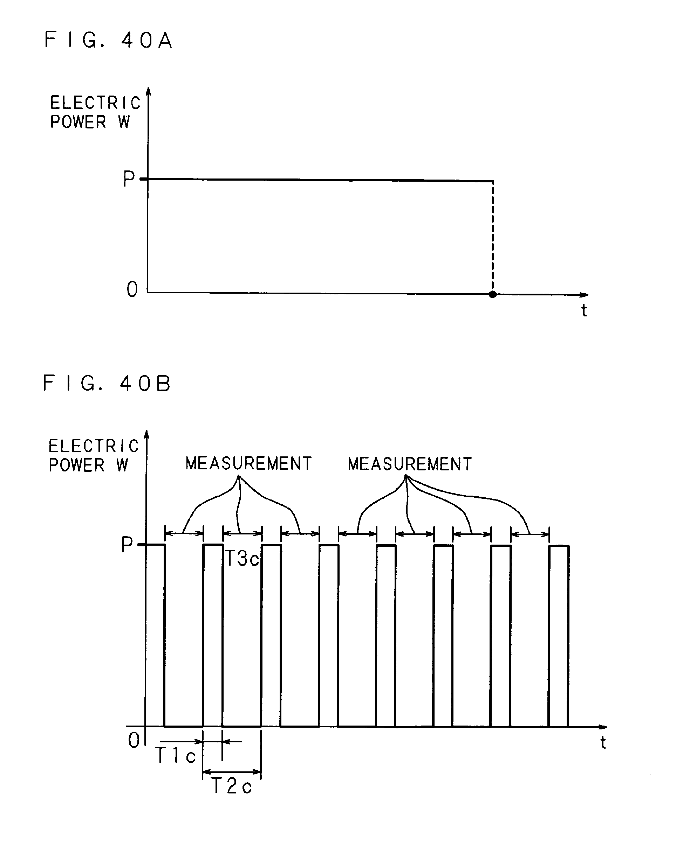

FIG. 40A is a graph depicting a first output mode using a control section 6b. In this mode, within a predetermined period of time, high frequency electric power (electric power value P) is continuously outputted and a high frequency voltage is continuously applied to the sample S and the electrode 12 (hereinafter, referred to as a continuous mode). In addition, FIG. 40B is a graph depicting a second output mode using the control section 6b. In this mode, within a predetermined period of time, high frequency electric power (electric power value P) is outputted in a pulse-based manner (ON/OFF switching manner), and a high frequency voltage is intermittently applied to the sample S and the electrode 12 (hereinafter, referred to as an intermittent mode).

The control section 6b alternately repeats electric power supply and electric power supply intermission by carrying out a pulse-based processing operation by means of an internal IC serving as means for intermittently applying a voltage in the intermittent mode. By such a processing operation, high frequency electric power is outputted at an electric power supply time interval T1c that corresponds to a portion protruded in a rod shape shown in FIG. 40B, and a voltage is applied to the sample S. High frequency electric power output (voltage application) is intermitted, and voltage application is stopped at a time interval T3c obtained by subtracting the electric power supply time interval T1c from a unit time T2c including one-shot electric power supply (voltage application) and one-shot electric power supply intermission (voltage application intermission).

In addition, the control section 6b serves as switching means for switching the above described continuous mode and intermittent mode based on a signal outputted from the computer 7. Further, the control section 6b can change an electric power value p relevant to electric power supply as a value associated with an applied voltage in the continuous mode. In the intermittent mode, this control section66 can change the number of the times electric power is supplied (electric power supply frequency) per unit time (one second), a duty ratio relevant to intermittent electric power supply, and an electric power value P, respectively, as the values associated with an applied voltage. The control section 6b changes (sets) a value associated with an applied voltage based on a signal outputted from the computer 7.

With respect to a change of an electric power supply frequency, the control section 6b can adjust an electric power supply frequency in the range of about 30 Hz to about 3000 Hz. When the electric power supply frequency is changed, the time interval T3c is changed as shown in the graph of FIG. 40B. In addition, with respect to a change of a duty ratio, a rate (T1c/T2c) of one-shot electric power supply time interval T1c to a unit time T2c during intermittent electric power supply can be properly regulated.

On the other hand, the computer 7 shown in FIG. 38 provides an interface substrate 7b having connected thereto a first connection cable L1 that extends from a generator 6 and a second connection cable L2 that extends from a matching box 5. This interface substrate 7b is connected to an internal bus 7f having connected thereto a CPU 7a, a RAM 7c, a ROM 7d, a hard disk unit 7e, and an external connection portion 7h. An operating section 7g is also connected to the internal bus 7f via a connection line L3.

The external connection portion 7h is used for connection to an external device. In the third embodiment, the microcomputer 233 of the radiation temperature measuring device 230 is connected through the signal line L6. A temperature measured by the radiation temperature measuring device 230 is displayed on the operating section 7g any time under the control of the CPU 7a. In addition, the RAM 7c temporarily stores data or the like caused by a variety of control processing operations carried out by the CPU 7a. The ROM 7d stores in advance data (reference time) required for processing operations and a program defining basic contents of processing operations carried out by the CPU 7a or the like. The hard disk unit 7e stores a drilling program 21c defining the contents of controls associated with a drilling processing operation carried out by the CPU 7a or the like.

The CPU 7a has a clock function and carries out a variety of processing operations based on the drilling program 21c stored in the hard disk unit 7e. In addition, this CPU7a carries out predetermined settings and controls based on an instruction inputted by a user through keyboard or mouse operation, although not shown in FIG. 38.

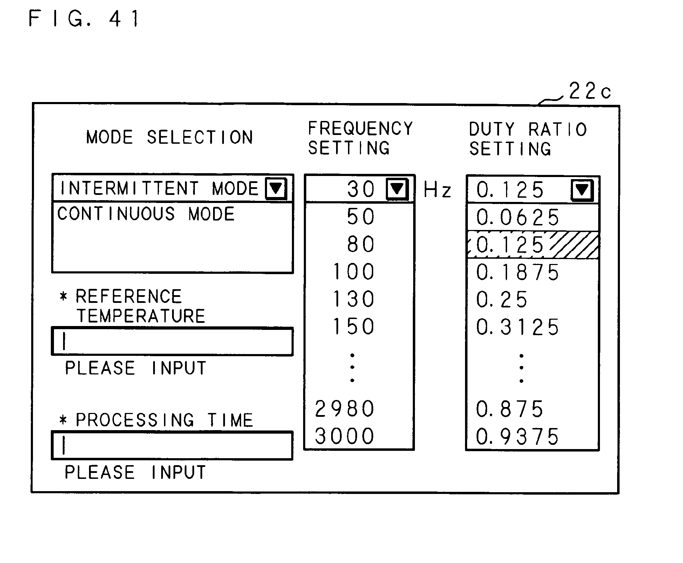

For example, when the drilling program 21c starts up, the CPU 7a causes the operating section 7g to display a setting menu 22c shown in FIG. 41. In addition, in the case where an operation for the intermittent mode or the continuous mode has been accepted in accordance with the setting menu 22c through the manipulation by the user, the CPU 7a carries out a processing operation for actuating a circuit in the interface substrate 7b that corresponds to the accepted contents of settings.

In the case where the intermittent mode has been set on the setting menu 22c, the CPU 7a carries out a processing operation for accepting from the user numeric value settings such as a processing time of a drilling process, a frequency (electric power supply frequency), and a duty ratio. Then, this CPU 7a stores the accepted contents in the RAM 7c. Then, the CPU 7a notifies the interface substrate 7b to transmit a predetermined signal to the generator 6. It is preferable to set the duty ratio to a numeric value lower than 0.5 in the case where the sample S targeted for drilling is easily melted and easily broken in particular. Further, the CPU 7a enables settings of other parameters such as a high frequency electric power peak value (electric power value) with the use of another menu other than the setting menu 22c shown in FIG. 41. In addition, when the intermittent mode has been set on the setting menu 22c, the CPU 7a makes control to output a notifying signal for notifying setting of the intermittent mode from the interface substrate 7b to the matching box 5.

On the other hand, in the case where the continuous mode has been set on the setting menu 22c, the CPU 7a makes control to output a command signal from the interface substrate 7b to the generator 6 so as to continuously generate electric power. When the continuous mode has been set, an electric power value relevant to electric power supply can also be set as a value associated with an applied voltage.

In addition, in the case where either of the above described modes has been set, the setting menu 22c enables settings of a reference time and a processing time with respect to the sample S (refer to FIG. 41). In the case where the operating section 7g has accepted input of the reference temperature and the processing time from the user by keyboard or mouse operation, the CPU 7a stores the accepted numeric value in the RAM 7c. It is necessary to determine a value of the reference temperature to be inputted, in accordance with a type of the sample S targeted for a drilling process. In the case where the sample S is easily affected by a heat, an allowable temperature of a level at which no thermal influence occurs (temperature lower than a temperature at which a thermal influence occurs) is inputted.

In addition, in the third embodiment, when the continuous mode has been set, electric power supply (voltage application) is temporarily intermitted if electric power supply (voltage application) is carried out for a predetermined period of time by a user's manual operation. Concurrent with that intermission, the radiation temperature measuring device 230 measures a temperature of a drilled site of a sample under the control of the computer 7, and the computer 7 carries out a process for displaying the measurement result on the operating section 7g. Therefore, in the continuous mode, when the user intermits electric power supply, a temperature displayed on the operating section 7g is verified, and it is determined whether electric power supply is continued, a value (voltage value P) associated with electric power supply (output voltage) is lowered, or a drilling process is terminated.

On the other hand, when the intermittent mode has been set, the CPU 7a starts measurement of a time interval at the same time as starting processing, and compares the measured time interval with a processing time stored in the RAM 7c. When the measured time reaches the processing time, this CPU7a makes control to stop voltage application, and then, terminates a drilling process.

In addition, during a drilling process, the CPU 7a controls the radiation temperature measuring device 230 so as to carry out temperature measurement at the time interval T3c at the time of electric power supply intermission during intermittent electric power supply (at the time of voltage application intermission during intermittent application of a high frequency voltage), as shown in FIG. 40B. In more detail, the CPU 7a outputs an instruction for starting temperature measurement from the external connection portion 7h to the microcomputer 233 of the radiation temperature measuring device 230 at the end time of the electric power supply time interval T1c so as to enable temperature measurement in synchronism with the time interval T3c and outputs an instruction for stopping temperature measurement to the microcomputer 233 at the end time of the time interval T3c. In this manner, the CPU 7a outputs an instruction, whereby light emission due to a glow discharge does not occur when the radiation temperature measuring device 230 carries out measurement (when the infrared sensor 231 receives the infrared ray Rb), thus enabling temperature measurement without being affected by light emission due to a glow discharge sputtering.

Further, in the intermittent mode, the CPU 7a compares a temperature measured by the radiation temperature measuring device 230 with a reference temperature set on the setting menu 22c, and makes determination. In the case where it has been determined that the measured temperature is equal to or greater than the reference temperature, this CPU7a makes control to lower an electric power value P relevant to an applied voltage for intermittent voltage application to the generator 6. In the third embodiment, a set value is halved as a quantity to be lowered. For example, in the case where the set electric power value is 1 W, if the measured temperature is equal to or greater than the reference temperature, a signal defining that the electric power value is set to 0.5 W is outputted from the computer 7 to the generator 6.

Furthermore, when the signal for lowering the electric power value has been outputted, the CPU 7a carries out time measurement from the signal output, and determines whether or not the measured time has elapsed the reference time stored in the ROM 7d. At this time, even if the measurement time after outputting the signal for lowering the electric power value has elapsed the reference time, when the measured temperature is maintained to be equal to or greater than the reference temperature, the CPU 7a makes control to stop voltage application, and then, terminate a drilling process in order to prevent deterioration of the sample S. The drilling program 21c stored in the hard disk unit 7e defines a variety of processing operations carried out by the above described CPU 7a.

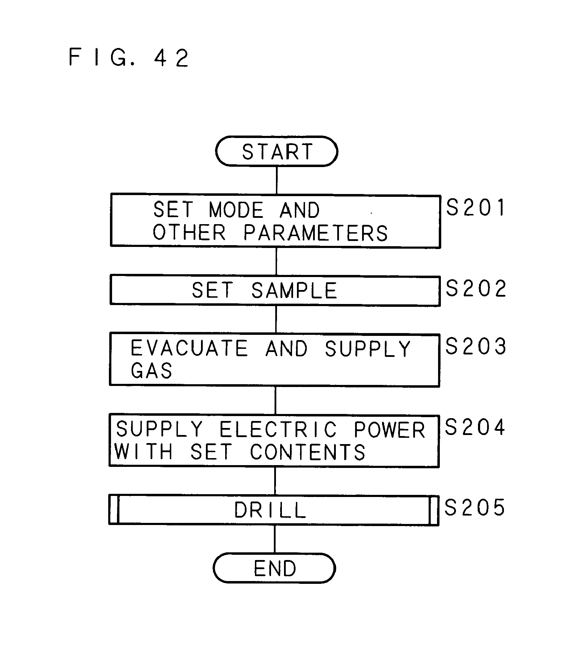

Now, with reference to a first flow chart shown in FIG. 42, a description will be given with respect to whole operating procedures relevant to a glow discharge drilling method using the glow discharge drilling apparatus 201 configured as described above.

First, the glow discharge drilling apparatus 201 sets a variety of parameters such as a frequency and a duty ratio in the case where a mode, a reference temperature, and an intermittent mode have been set upon the receipt of an input on the setting menu 22c or the like by a user shown in FIG. 41 (S201), and the user sets the sample S on the glow discharge tube 2, as shown in FIG. 39 (S202).

Next, the user evacuates an inside of the glow discharge tube 2 by means of the evacuating device 8, and then, supplies inert gas (argon gas) into the glow discharge tube 2 from the gas supply source 10 (S203). Then, the user carries out light receiving of an infrared ray Rb radiated from a sample surface Sa before drilled as a preparatory stage of the radiation temperature measuring device 230; checks whether or not a temperature can be properly measured; makes position adjustment of the infrared ray sensor 231; and measures a sample surface temperature before drilled. Then, the glow discharge drilling apparatus 201 applies a voltage by supplying electric power according to the set contents (S204), and drills the sample surface Sa exposed in a space K of the sample S (S205).

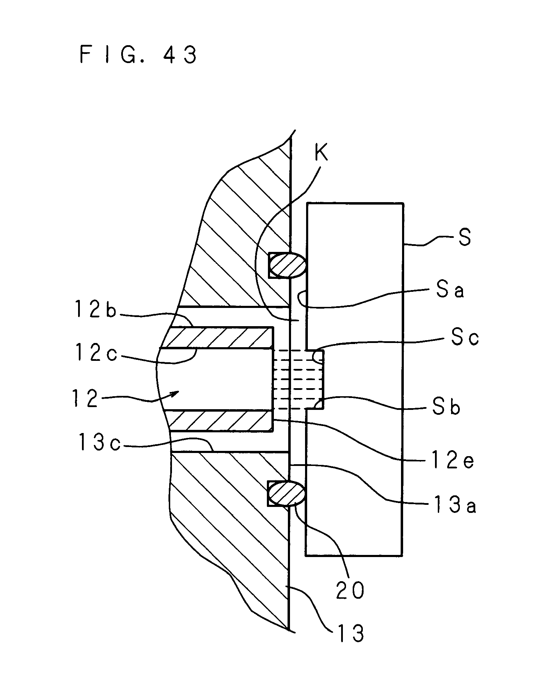

FIG. 43 shows a drilled state of the sample S. In the space K sealed by the third O-ring 20, in a state in which an argon gas is smoothly guided through the through hole 12c of the electrode 12, a voltage is applied between the electrode 12 and the sample S, and a glow discharge occurs. Then, argon ions contained in the argon gas burst toward the sample surface Sa, and collide with the surface Sa, and sputtering occurs. The sample surface Sa is drilled due to collision of the argon ions due to this sputtering, and a recessed portion Sb occurs. In addition, the infrared ray Rb is radiated from a bottom face Sc of the recessed portion Sb, and thus, the radiation temperature measuring device 230 measures a temperature of the bottom face Sc of the recessed portion Sb that is a drilled site of the sample S.

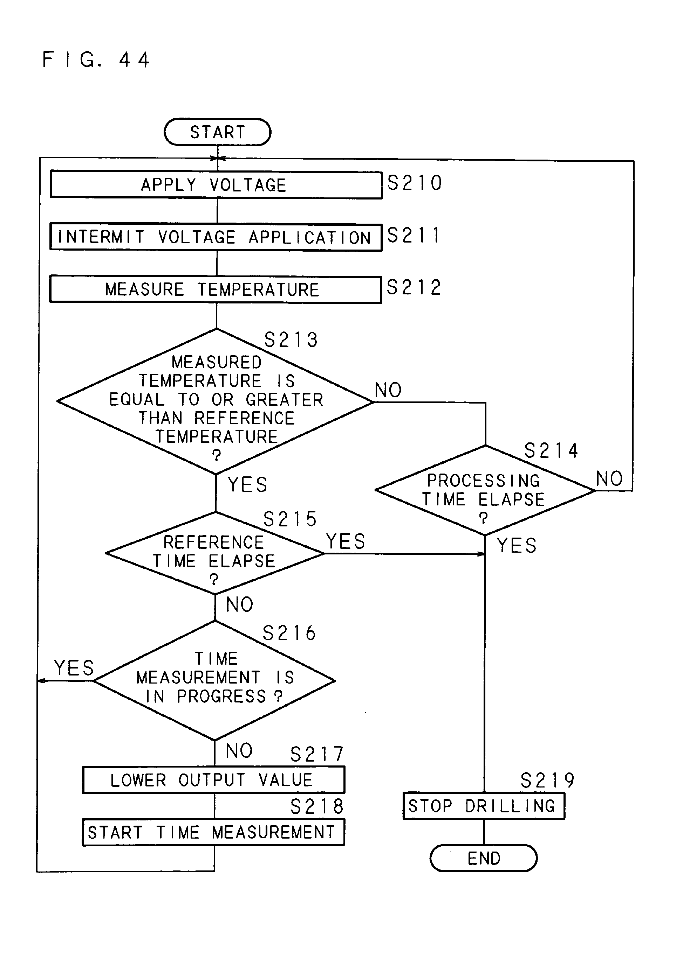

A second flow chart of FIG. 44 relates to a glow discharge drilling method showing detailed operating procedures for carrying out drilling in the intermittent mode in the drilling process (S205) shown in the first flow chart of FIG. 42. Now, a drilling processing operation in the intermittent mode will be described with reference to the second flow chart. The glow discharge drilling apparatus 201 carries out voltage application at the electric power supply time interval T1c, as shown in FIG. 40B (S210), and intermits voltage application in a voltage application intermission state at the subsequent time interval T3c (S211). The microcomputer 233 carries out temperature measurement based on an infrared ray Rb received by the infrared ray sensor 231 at the time interval T3c at which this voltage application is intermitted (S212). The computer 7 (CPU 7a) of the glow discharge drilling apparatus 201 starts measurement of a time for carrying out processing concurrently with starting a drilling processing operation.

Next, the computer 7 of the glow discharge drilling apparatus 201 determines whether or not a temperature measured by the microcomputer 233 is equal to or greater than a reference temperature stored in the RAM 7c (S213). In the case where the measured temperature is not equal to or greater than the reference temperature (S213: NO), the computer 7 determines whether or not the measured time has elapsed a processing time stored in the RAM 7c (S214). In the case where the processing time has not been elapsed (S214: NO), current processing reverts to a voltage application stage (S210), and the drilling process is continued. In the case where the processing time has been elapsed (S214: YES), drilling is stopped (S219), and processing is terminated.

In addition, in the case where the computer 7 (CPU 7a) has determined that the measured temperature is equal to or greater than the reference temperature at the stage of temperature comparison (S213: YES), the computer 7 determines whether or not the measured time after starting a processing operation for lowering an electric power value at the stage (S218) described later has elapsed the reference time stored in the RAM 7c (S215). In the case where the reference time has been elapsed (S215: YES), drilling is stopped (S219), and the sample S is protected.

On the other hand, in the case where the measured time has not elapsed the reference time (S215: NO), the CPU 7a determines whether or not time measurement following a processing operation for lowering the electric power value is in progress (S216). In the case where the time measurement is in progress (S216: YES), current processing reverts to the voltage application stage (S210), and the drilling process is continued. In addition, in the case where time measurement is not in progress (S216: NO), the CPU 7a carries out a process for lowering (halving) an electric power value P (output value) relevant to intermittent voltage application (S217); and starts time measurement following starting of the processing operation for lowering the electric power value (S218). Then, current processing reverts to the voltage application stage (S210), and the drilling process is continued.

As described above, the glow discharge drilling apparatus 201 according to the third embodiment carries out temperature measurement when voltage application is intermitted in the intermittent mode, thus making it possible to precisely measure a temperature of the drilled site of the sample S without being affected by sputtering light emission. In addition, temperature measurement is carried out by using the time interval T3c for voltage application intermission, whereby a time required for temperature measurement can be included in the drilling processing time, and efficient processing can be achieved.

In addition, when the glow discharge drilling apparatus 201 lowers an electric power value of electric power applied to the sample S when the measured temperature is equal to or greater than a reference value (allowable temperature set with respect to sample S), an electric power value of electric power applied to the sample S is lowered. Thus, a heat rate applied to the sample S at the time of drilling processing is also lowered, a situation in which a temperature hardly rises is produced, and thermal damage to the sample S is avoided. Further, even if a predetermined time (reference time) has elapsed after lowering the electric power value, when a measured temperature is not lowered (when the measured temperature is not less than the reference temperature), the drilling process is stopped. Thus, the sample S is reliably prevented from being deteriorated due to a thermal influence, and then, entering a state in which the sample cannot be used for observation (sample S is wasted).

Even if the reference time has elapsed after lowering the electric power value, when the measured temperature is equal to or greater than the reference temperature, the drilling process is stopped. This is because a certain degree of time is required for temperature lowering, and determination for a temperature of the sample S is made at a time point at which the reference time has elapsed after lowering the electric power value of the sample S. In addition, the reference temperature is set at an allowable value lower than a temperature at which a thermal influence occurs with the sample S. Thus, even if the drilling process is carried out until the reference time has elapsed after the measured temperature has been set to be equal to or greater than the reference temperature, there is a margin for a temperature at which a thermal influence actually occurs to be produced, and thus, no thermal influence occurs with the sample S.

Therefore, in the glow discharge drilling apparatus 201 according to the third embodiment, a drilling process can be automatically carried out so that no thermal influence occurs with the sample S in the intermittent mode. Thus, an observation face suitable for observation can be stably formed even if a sample targeted for drilling is made of synthetic resin such as polycarbonate and a rubber material or the like such as synthetic rubber.

On the other hand, a drilling processing operation in the continuous mode of the glow discharge drilling apparatus 201 is in accordance with a user operation. In this operation, a voltage is applied by a set electric power value P for a predetermined time; the voltage application is temporarily intermitted; the user checks a measured temperature displayed on the operating section 7g, and restarts voltage application if the checked temperature does not reach an allowable temperature. Subsequently, such a processing operation is carried out, and drilling of a desired quantity is carried out. Alternatively, when the measured temperature is equal to or greater than the allowable temperature, the electric power voltage P of a voltage applied to a sample is lowered (halved, for example) by the user operation so as to carry out voltage application. By carrying out such a processing operation, a drilling process can be carried out while thermal influence on the sample S is reliably avoided even in the continuous mode.

The glow discharge drilling apparatus according to the present invention is not limited to the above described third embodiment, and various modifications can be applied thereto. For example, a direct current voltage may be applied between the electrode 12 and the sample S by means of the glow discharge drilling apparatus 201. In this case, the electric power supply section 4 is changed to have a configuration in which direct current electric power is generated and supplied. In addition, the glow discharge drilling apparatus 201 does not always need to have both of the continuous mode and the intermittent mode with respect to voltage application, and apparatus cost reduction may be promoted by applying a voltage in only either one of these modes. Further, in order to certainly notify the user that the measured temperature is equal to or greater than the reference temperature, a sound output portion for outputting a warning sound is provided with the computer 7 so that a configuration of generating a warning sound from the sound output section may be provided when the CPU 7a has determined that the measured temperature is equal to or greater than the reference temperature.

Furthermore, in the case where the measured temperature is equal to or greater than the reference temperature in the intermittent mode, a value of a duty ratio associated with an applied voltage may be lowered in addition to lowering an electric power value P applied to a sample S. For example, in the case where an electric power value is set to 1 W as a value associated with an applied voltage, and a duty ratio is set to 0.5, when a measured temperature is equal to or greater than the reference temperature, the electric power value is lowered to 0.5 W, and the duty ratio is lowered to 0.25, whereby a thermal load on the sample S may be reduced more remarkably. In addition, only a numeric value of the duty ratio can be lowered as a value associated with an applied voltage.

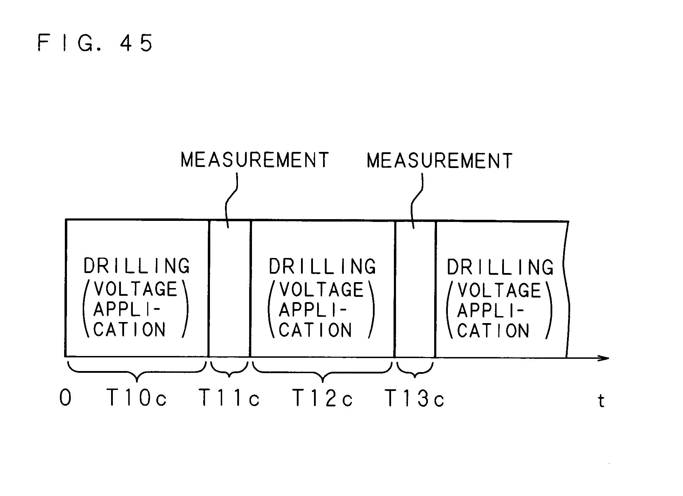

In order to reduce a user's operating burden in the continuous mode, as shown in FIG. 45, if a drilling is carried out for a predetermined time interval (such as T10c or T12c, for example, 1 minute), programming is carried out so as to measure a temperature at a next time interval (such as T11c or T13c, for example 2 seconds), whereby drilling can be automatically carried out even in the continuous mode. In this case, a time interval (such as T10c or T12c) required for drilling (voltage application) is set at a preparatory stage, and the CPU 7a clocks each of the time intervals (such as T10c to T13c). When a time interval for carrying out voltage application (such as T10c or T12c) has elapsed, voltage application is stopped, and then, temperature measurement is carried out under the control of the computer 7 (CPU 7a). When temperature measurement completes (when the time interval T11c or T13c and the like required for temperature measurement has elapsed), voltage application is restarted. In addition, in the case where a measured temperature is equal to or greater than a reference temperature, when next drilling (voltage application) is carried out, an electric power value of an applied voltage is lowered under the control of the computer 7 (CPU 7a) so that a thermal influence does not occur with the sample S.

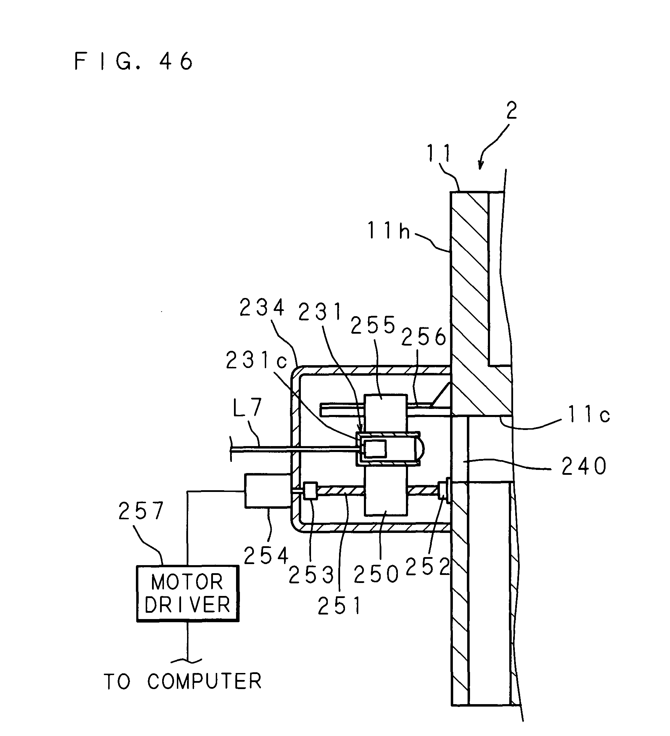

FIG. 46 is a modified example relevant to disposition of the infrared ray sensor 231 so that a position of the infrared ray sensor 231 can be adjusted by driving a motor. Specifically, a ball screw 251 is rotatably mounted via a bearing portion 252 on one end face 11h of the lamp body 11 of the glow discharge tube 2 in parallel to a rail member 256, and an end of the ball screw 251 is coupled with a motor shaft of a motor 254 disposed outwardly of the light shielding member 234 via a coupling portion 253. In addition, a housing 231c of the infrared ray sensor 231 is mounted on a first slide unit 250 provided at the ball screw 251 and a second slide unit 255 mounted on the rail member 256. The driving of the motor 254 is controlled by means of a motor driver 257. The motor driver 257 is connected to the computer 7 so as to control the driving of the motor 254 based on an instruction from the computer 7.

By applying a structure as shown in FIG. 46, the infrared ray sensor 231 can be made close to or distant from a glass member 240 for sealing a cavity 11 without removing the light shielding member 234, and a preparatory burden on temperature measurement can be reduced by adjusting the position of the infrared ray sensor 231 through driving of the motor 254.

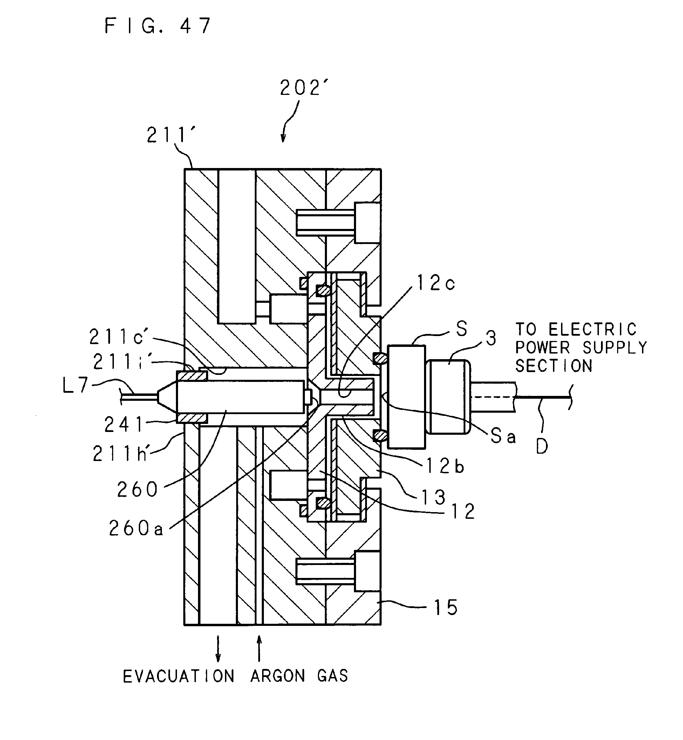

In addition, FIG. 47 shows another modified example. In the case where a fiber shaped fine infrared ray sensor 260 is used, the infrared ray sensor 260 may be disposed inside of a lamp body 211' of a glow discharge tube 202'. In this case, the lamp body 211' comprises a communication hole 211i' that communicate with a cavity 211c' at an end face 211h' at the opposite side to a side at which the sample S is disposed; inserts the infrared ray sensor 260 into the communication hole 211i', and mounts a ring-shaped sealing member 241 between an inner rim of the communication hole 211i' and an outer face of the infrared ray sensor 260 to seal the cavity 211c'.

A configuration of the glow discharge tube 202' shown in FIG. 47 is similar to that shown in FIG. 39 except the above described configuration. This glow discharge tube 202' has an electrode 12, a ceramics member 13, and a pressurizing block 15, and mounts a sample S by pressing an oscillator 3. The infrared ray sensor 260 is thus mounted, whereby a light receiving section 260a of the infrared ray sensor 260 is opposed to a sample surface Sa through a through hole 12c formed at a cylinder portion 12b of the electrode 12. A distance between the light receiving section 260a and the sample S can be remarkably reduced as compared with the cases shown in FIGS. 39 and 46. In addition, measurement precision can be improved while light receiving of an infrared ray radiated from a drilled site of the sample S is reliably carried out.

## Claims

1. A glow discharge drilling apparatus for, in an atmosphere in which inert gas is supplied, drilling a sample (S) disposed to be opposed to an electrode (12) by means of a glow discharge generated by supplying electric power to the electrode (12) and sample (S), said apparatus **characterized by** comprising:
a sealing member (20) for surrounding and sealing a space (K) at which the electrode (12) and sample (S) are opposed to each other;
a gas supply section (9. 10) for supplying inert gas to the space (K) sealed by the sealing member (20); and
intermittent electric power supply means (6b) for intermittently supplying electric power.

2. The glow discharge drilling apparatus according to claim 1, further comprising:
continuous electric power supply means (6b) for continuously supplying electric power; and
switching means (6b) for switching the continuous electric power supply carried out by the continuous electric power supply means (6b) and the intermittent electric power supply carried out by the intermittent electric power supply means (6b).

3. A glow discharge drilling apparatus having a first electrode (52) and a second electrode (53) on which a sample (S) is disposed in a drilling processing chamber (51) to which inert gas is supplied, said apparatus drilling the sample (S) by means of a glow discharge generated by supplying electric power to the first electrode (52) and the second electrode (53), **characterized by** comprising:
intermittent electric power supply means (6b) for intermittently supplying electric power;
continuous electric power supply means (6b) for continuously supplying electric power; and
switching means (6b) for switching the continuous electric power supply carried out by the continuous electric power supply means (6b) and the intermittent electric power supply carried out by the intermittent electric power supply means (6b).

4. The glow discharge drilling apparatus according to any one of claims 1 to 3, further comprising electric power supply state change means (6b) for changing a state relevant to the intermittent electric power supply carried out by the intermittent electric power supply means (6b).

5. A glow discharge drilling apparatus having a first electrode (52) and a second electrode (53) on which a sample (S) is disposed in a drilling processing chamber (51) to which inert gas is supplied, said apparatus drilling the sample (S) by means of a glow discharge generated by supplying electric power to the first electrode (52) and the second electrode (53), **characterized by** comprising:
intermittent electric power supply means (6b) for intermittently supplying electric power; and
electric power supply state change means (6b) for changing a state relevant to the intermittent electric power supply carried out by the intermittent electric power supply means (6b)

6. The glow discharge drilling apparatus according to claim 4 or 5, wherein the electric power supply state change means (6b) is designed to change the number of the times per unit time electric power is supplied.

7. The glow discharge drilling apparatus according to any one of claims 4 to 6, wherein the electric power supply state change means (6b) is designed to change a duty ratio relevant to intermittent electric power supply.

8. The glow discharge drilling apparatus according to any one of claims 4 to 7, wherein the electric power supply state change means (6b) is designed to change an electric power value relevant to intermittent electric power supply.

9. A glow discharge drilling method for disposing a sample (S) to be opposed to an electrode (12), supplying inert gas, supplying electric power to the electrode (12) and sample (S) to generate a glow discharge, and drilling the sample (S) by the generated glow discharge, said method **characterized by** comprising the steps of
surrounding and sealing a space at which the electrode (12) and sample (S) are opposed to each other; and
intermittently supplying electric power in an atmosphere in which inert gas is supplied to the space (K) formed by sealing.

10. A glow discharge drilling method for supplying inert gas into a drilling processing chamber (51) having a first electrode (52) and a second electrode (53) on which a sample (S) is disposed, supplying electric power to the first electrode (52) and the second electrode (53) to generate a glow discharge, and drilling the sample (S) by the generated glow discharge, said method **characterized by** comprising the step of:
the intermittent electric power supply step of intermittently supplying electric power, wherein a state relevant to intermittent electric power supply can be changed in the intermittent electric power supply step.

11. A glow discharge drilling apparatus for drilling a sample (S) by a glow discharge generated by applying a voltage between an electrode (12, 52) and the sample (S) disposed to be opposed to the electrode (12, 52), said apparatus **characterized by** comprising:
measuring means (130, 300) for measuring a drilled depth by carrying out light irradiation to a drilled site and light receiving of reflection light reflected on the drilled site.

12. The glow discharge drilling apparatus according to claim 11, wherein a penetrating portion (12c, 52a) is provided on the electrode (12, 52) at a portion opposed to the sample (S), and wherein the measuring means (130, 300) is designed to carry out light irradiation to a drilled site and light receiving of reflection light reflected on the drilled site through the penetrating portion (12c, 52a).

13. The glow discharge drilling apparatus according to claim 12, further comprising a holding member (11) for holding the electrode (12), and having a cavity (lie) that communicates with the penetrating portion (12c) of the electrode (12); and
a light transmitting member (135) opposed to the penetrating portion (12c) via the cavity (11c), and wherein the measuring means (130, 300) is designed to carry out light irradiation to a drilled site and light receiving of reflection light reflected on the drilled site through the light transmitting member (135), the cavity (11c) and the penetrating portion (12c).

14. The glow discharge drilling apparatus according to claim 13, wherein the measuring means (130) comprises an irradiation and light receiving section (132a) for carrying out light irradiation and light receiving of reflection light, and wherein the irradiation and light receiving section (132a) is disposed in parallel to the holding member (11) so as to be opposed to the light transmitting member (135), and the measuring means (130) comprises a light shielding member (133) for shielding light by covering the irradiation and light receiving section (132a) and the light transmitting member (135).

15. The glow discharge drilling apparatus according to any one of claims 11 to 14, further comprising stopping means (7a) for stopping voltage application when the measuring means (130, 300) carries out light receiving of reflection light.

16. The glow discharge drilling apparatus according to any one of claims 11 to 14, further comprising
means (6b) for intermittently applying a voltage, wherein the measuring means (130, 300) is designed to carry out light receiving of reflection light when voltage application is intermitted while a voltage is intermittently applied.

17. The glow discharge drilling apparatus according to any one of claims 11 to 16, further comprising
accepting means (7g) for accepting a drilled depth;
means (7a) for making comparative determination of the drilled depth accepted by the accepting means (7g) and the drilled depth measured by the measuring means (130, 300); and
means (7a) for, in the case where it is determined that the drilled depth measured by the measuring means (130, 300) reaches the drilled depth accepted by the accepting means (7g), stopping voltage application and terminating drilling.

18. The glow discharge drilling apparatus according to any one of claims 11 to 17, wherein the measuring means (300) comprises:
means (321, 322) for irradiating a plurality of light beams and receiving a plurality of reflection light beams; and
average value calculating means (311) for calculating an average value of a plurality of drilled depths based on a plurality of the received reflection light beams.

19. A glow discharge drilling method for drilling a sample (S) by a glow discharge generated by applying a voltage between an electrode (12) and the sample (S) disposed to be opposed to the electrode (12), said method **characterized by** comprising the steps of:
measuring a drilled depth by carrying out light irradiation to a drilled site and light receiving of reflection light reflected on the drilled site; and
stopping voltage application and terminating drilling according to the measured drilled depth.

20. A glow discharge drilling apparatus for drilling a sample (S) by a glow discharge generated by applying a voltage between a hollow electrode (12) and the sample (S) disposed to be opposed to the hollow electrode (12), said apparatus **characterized by** comprising:
an infrared ray sensor (231, 260) for receiving an infrared ray radiated from a drilled site of the sample (S), the infrared ray having passed through a hollow portion (12c) of the hollow electrode (12); and
temperature measuring means (233) for measuring a temperature of a drilled site of the sample (S) based on the infrared ray received by the infrared ray sensor (231,260).

21. The glow discharge drilling apparatus according to claim 20, further comprising moving means (236) for moving the infrared ray sensor (231) so that a light receiving section (231a) of the infrared ray sensor (231) can be made close to or distant from a drilled site of the sample (S).

22. The glow discharge drilling apparatus according to claim 20 or 21, further comprising a holding member (11) for holding the hollow electrode (12), and having a cavity (11c) that communicates with the hollow portion (12c) of the hollow electrode (12) and a light transmitting member (240) opposed to the hollow portion (12c) via the cavity (11c), and wherein the infrared ray sensor (231) is designed to receive an infrared ray having passed through the hollow portion (12c), the cavity (11c), and the light transmitting member (240).

23. The glow discharge drilling apparatus according to claim 22, further comprising a light shielding member (234) for shielding light by covering the infrared ray sensor (231) and light transmitting member (240).

24. The glow discharge drilling apparatus according to any one of claims 20 to 23, further comprising stopping means (7a) for stopping voltage application when the temperature measuring means (233) measures a temperature.

25. The glow discharge drilling apparatus according to any one of claims 20 to 23, further comprising means (6b) for intermittently applying a voltage, wherein the temperature measuring means (233) is designed to measure a temperature based on the infrared ray received by the infrared ray sensor (231, 260) when voltage application is intermitted while a voltage is intermittently applied.

26. The glow discharge drilling apparatus according to any one of claims 20 to 25, further comprising:
accepting means (7a) for accepting a reference temperature;
means (7a) for making comparative determination of the reference temperature accepted by the accepting means (7g) and a temperature measured by the temperature measuring means (233); and
lowering means (7a) for, in the case where it is determined that the temperature measured by the temperature measuring means (233) is equal to or greater than the reference temperature accepted by the accepting means (7g), lowering a value associated with an applied voltage.

27. The glow discharge drilling apparatus according to any one of claims 20 to 23, further comprising:
means (6b) for intermittently applying a voltage;
accepting means (7g) for accepting a reference temperature;
means (7a) for making comparative determination of the reference temperature accepted by the accepting means (7g) and a temperature measured by the temperature measuring means (233); and
lowering means (7a) for, in the case where it is determined that the temperature measured by the temperature measuring means (233) is equal to or greater than the reference temperature accepted by the accepting means (7g), lowering a duty ratio relevant to voltage application while a voltage is intermittently applied and / or an electric power value relevant to an applied voltage, wherein the temperature measuring means (233) is designed to measure a temperature based on the infrared ray received by the infrared ray sensor (231, 260) when voltage application is intermitted while a voltage is intermittently applied.

28. A glow discharge drilling method for drilling a sample (S) by a glow discharge generated by applying a voltage between a hollow electrode (12) and the sample (S) disposed to be opposed to the hollow electrode (12), **characterized by** comprising the steps of:
receiving an infrared ray radiated from a drilled site of the sample (S), the infrared ray having passed through a hollow portion (12c) of the hollow electrode (12);
measuring a temperature of a drilled site of the sample (S) based on the received infrared ray;
comparing the measured temperature and a reference temperature accepted in advance; and
in the case where it is determined that the measured temperature is equal to or greater than the reference temperature as a result of the comparison, lowering a value associated with an applied voltage.
